# EUROPEAN PATENT APPLICATION

(11) **EP 4 679 429 A1**
(43) Date of publication of application: **14.01.2026**
(21) Application number: 24766897.3
(22) Date of filing: 22.02.2024
(51) Int. Cl.: G11C 11/16, G11C 14/00, H01L 29/82, H10B 61/00, H10N 52/00

(54) **MEMORY DEVICE AND MEMORY SYSTEM**

(30) Priority: 07.03.2023 JP 2023034753
(71) Applicant: Sony Semiconductor Solutions Corporation, Atsugi-shi, Kanagawa 243-0014 (JP)
(72) Inventor: SAKAI, Lui, Atsugi-shi, Kanagawa 243-0014 (JP); HOSOMI, Masanori, Atsugi-shi, Kanagawa 243-0014 (JP); HIGO, Yutaka, Atsugi-shi, Kanagawa 243-0014 (JP); HIRAGA, Keizo, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/006420
(87) International publication number: WO 2024/185526

(57) **Abstract**

Provided is a memory device including: a magnetoresistive element connected between a first control line and a second control line, a write circuit that controls writing to the magnetoresistive element, and a read circuit that controls reading from the magnetoresistive element. The magnetoresistive element is a voltage-controlled magnetic anisotropy (VCMA) effect magnetoresistive element, and the write circuit controls the magnetoresistive element such that a first voltage for writing in a high resistance state and a second voltage for writing in a low resistance state have opposite directions.

## Description

### Field

The present disclosure relates to a memory device and a memory system.

### Background

Since a magnetoresistive random access memory (MRAM) using a magnetoresistive element as a storage element maintains a state by a magnetization state of a ferromagnetic material, the MRAM has non-volatility in which recorded data is maintained even when a power supply is turned off. A basic structure of the magnetoresistive element is a sandwich structure in which a nonmagnetic layer (tunnel barrier layer) of an insulator is sandwiched between two magnetic layers made of a magnetic thin film. This structure is referred to as a magnetic tunnel junction (MTJ), and an element having this structure is referred to as an MTJ element. Specifically, since a film thickness of the nonmagnetic layer is as very thin as about several nm, when a voltage is applied across the magnetoresistive element, a tunnel current flows. A magnitude of the tunnel current depends on a relative angle of magnetization of the two magnetic layers. The above phenomenon is called a tunnel magneto resistance (TMR) effect.

In the MRAM, the magnetization of one magnetic layer (magnetization fixed layer) of the two magnetic layers is fixed, and the magnetization of the other magnetic layer (storage layer) is controlled by an external field. A state in which magnetization directions of the magnetization fixed layer and the storage layer are parallel to each other is referred to as a state 0 (low resistance state), and a state in which the magnetization directions are antiparallel to each other is referred to as a state 1 (high resistance state). As described above, in the MRAM, the state ("0" or "1") can be stored in a nonvolatile manner by rewriting the parallel/antiparallel states of magnetization. Since a resistance value is different between the state in which the magnetization directions of the magnetization fixed layer and the storage layer are parallel to each other and the state in which the magnetization directions are antiparallel to each other, the stored state can be read by reading the resistance value. Furthermore, examples of the external field used for controlling the magnetization direction include a current magnetic field generated by current energization to an external wiring, a method of directly energizing a current to the MTJ element and utilizing a spin transfer torque (STT) effect, and a method of utilizing voltage controlled magnetic anisotropy (VCMA).

The MRAM that is currently the mainstream is an STT-MRAM that can be miniaturized, as compared with a case of using the current magnetic field, and can also reduce power consumption. On the other hand, in recent years, a voltage controlled (VC) MRAM using VCMA, i.e., a VC-MRAM, has been attracting attention because the VC-MRAM can operate at high writing speed and low power consumption. For example, a voltage writing system using VCMA disclosed in Patent Literature 1 below realizes bidirectional writing by applying an ultra-high speed pulse voltage with a unipolarity (applying a voltage in only one direction). In the VC-MRAM, as disclosed in Patent Literature 1 below, bidirectional writing can be performed by applying a unipolar pulse voltage.

### Citation List

### Patent Literature

Patent Literature 1: JP 2018-92696 A

### Summary

### Technical Problem

In the system disclosed in above Patent Literature 1, it is required to apply a pulse voltage having a short pulse width at high accuracy in order to reverse the magnetization direction of the storage layer. However, it is difficult to apply a pulse voltage having a short pulse width at high accuracy, and for example, a complicated and large-scale control circuit is required for controlling a short pulse width at high accuracy. In addition, in the system disclosed in Patent Literature 1, since initial reading is required, time obtained by integrating initial read time and write pulse application time is required as actual write time. It is impossible to avoid extended write time.

Therefore, the present disclosure proposes a memory device and a memory system that do not need to control a voltage pulse width at high accuracy and do not need initial reading.

### Solution to Problem

According to the present disclosure, there is provided a memory device including: a magnetoresistive element connected between a first control line and a second control line; a write circuit configured to control writing to the magnetoresistive element; and a read circuit configured to control reading from the magnetoresistive element. In the memory device, the magnetoresistive element is a voltage-controlled magnetic anisotropy (VCMA) effect magnetoresistive element, and the write circuit controls the magnetoresistive element such that a first voltage for writing in a high resistance state and a second voltage for writing in a low resistance state have opposite directions.

Furthermore, according to the present disclosure, there is provided a memory system including: a plurality of memory cells including a magnetoresistive element and a selection element that selects the magnetoresistive element; a write circuit configured to select the plurality of memory cells and performs writing to the magnetoresistive element via the selection element; a read circuit configured to select the plurality of memory cells and performs reading from the magnetoresistive element via the selection element; and a memory control unit configured to control data writing and reading in the plurality of the memory cells via the write circuit and the read circuit. In the memory system, the magnetoresistive element is a voltage-controlled magnetic anisotropy (VCMA) effect magnetoresistive element, and the write circuit controls the magnetoresistive element such that a first voltage for writing in a high resistance state and a second voltage for writing in a low resistance state have opposite directions.

### Brief Description of Drawings

FIG. 1 is a schematic diagram illustrating a configuration example of a magnetoresistive element according to a first embodiment of the present disclosure.
FIG. 2 is a perspective view of an example of a specific configuration of a memory cell array according to the first embodiment of the present disclosure.
FIG. 3 is a cross-sectional view of the memory cell array in FIG. 2.
FIG. 4 is an explanatory diagram (Part 1) illustrating an operation principle of the magnetoresistive element according to the first embodiment of the present disclosure.
FIG. 5 is an explanatory diagram (Part 2) illustrating the operation principle of the magnetoresistive element according to the first embodiment of the present disclosure.
FIG. 6 is an explanatory diagram (Part 3) illustrating the operation principle of the magnetoresistive element according to the first embodiment of the present disclosure.
FIG. 7 is an explanatory diagram (Part 4) illustrating the operation principle of the magnetoresistive element according to the first embodiment of the present disclosure.
FIG. 8 is a block diagram of a memory device according to the first embodiment of the present disclosure.
FIG. 9 is a timing chart of writing in the memory device according to the first embodiment of the present disclosure.
FIG. 10 is a flowchart of writing in the memory device according to the first embodiment of the present disclosure.
FIG. 11 is a timing chart of write voltage control in the memory device according to the first embodiment of the present disclosure.
FIG. 12 is a flowchart of writing in a memory device according to a first modification of the first embodiment of the present disclosure.
FIG. 13 is a timing chart (Part 1) of write voltage control in the memory device according to the first modification of the first embodiment of the present disclosure.
FIG. 14 is a timing chart (Part 2) of the write voltage control in the memory device according to the first modification of the first embodiment of the present disclosure.
FIG. 15 is an explanatory diagram illustrating a configuration example and an operation principle of a magnetoresistive element according to a second modification of the first embodiment of the present disclosure.
FIG. 16 is a schematic diagram illustrating a configuration example of a magnetoresistive element according to a second embodiment of the present disclosure.
FIG. 17 is an explanatory diagram (Part 1) illustrating an operation principle of the magnetoresistive element according to the second embodiment of the present disclosure.
FIG. 18 is an explanatory diagram (Part 2) illustrating the operation principle of the magnetoresistive element according to the second embodiment of the present disclosure.
FIG. 19 is an explanatory diagram (Part 3) illustrating the operation principle of the magnetoresistive element according to the second embodiment of the present disclosure.
FIG. 20 is an explanatory diagram illustrating a configuration example and an operation principle of a magnetoresistive element according to a second modification of the second embodiment of the present disclosure.
FIG. 21 is a schematic diagram illustrating a configuration example of a magnetoresistive element according to a third embodiment of the present disclosure.
FIG. 22 is an explanatory diagram (Part 1) illustrating an operation principle of the magnetoresistive element according to the third embodiment of the present disclosure.
FIG. 23 is an explanatory diagram (Part 2) illustrating the operation principle of the magnetoresistive element according to the third embodiment of the present disclosure.
FIG. 24 is an explanatory diagram (Part 3) illustrating the operation principle of the magnetoresistive element according to the third embodiment of the present disclosure.
FIG. 25 is an explanatory diagram illustrating a configuration example and an operation principle of a magnetoresistive element according to a second modification of the third embodiment of the present disclosure.
FIG. 26 is a schematic diagram illustrating a configuration example of a magnetoresistive element according to a third modification of the third embodiment of the present disclosure.
FIG. 27 is an explanatory diagram illustrating a configuration example and an operation principle of the magnetoresistive element according to the third modification of the third embodiment of the present disclosure.
FIG. 28 is an explanatory diagram illustrating a configuration example and an operation principle of a magnetoresistive element according to a fourth modification of the third embodiment of the present disclosure.
FIG. 29 is a schematic diagram illustrating a configuration example of a magnetoresistive element according to a fourth embodiment of the present disclosure.
FIG. 30 is an explanatory diagram (Part 1) illustrating an operation principle of the magnetoresistive element according to the fourth embodiment of the present disclosure.
FIG. 31 is an explanatory diagram (Part 2) illustrating the operation principle of the magnetoresistive element according to the fourth embodiment of the present disclosure.
FIG. 32 is an explanatory diagram (Part 3) illustrating the operation principle of the magnetoresistive element according to the fourth embodiment of the present disclosure.
FIG. 33 is an explanatory diagram illustrating a configuration example and an operation principle of a magnetoresistive element according to a second modification of the fourth embodiment of the present disclosure.
FIG. 34 is a schematic diagram illustrating a configuration example of a magnetoresistive element according to a third modification of the fourth embodiment of the present disclosure.
FIG. 35 is an explanatory diagram illustrating a configuration example and an operation principle of the magnetoresistive element according to the third modification of the fourth embodiment of the present disclosure.
FIG. 36 is an explanatory diagram illustrating a configuration example and an operation principle of a magnetoresistive element according to a fourth modification of the fourth embodiment of the present disclosure.
FIG. 37 is a schematic diagram illustrating a configuration example of a magnetoresistive element according to a fifth embodiment of the present disclosure.
FIG. 38 is an explanatory diagram (Part 1) illustrating the operation principle of the magnetoresistive element according to the fifth embodiment of the present disclosure.
FIG. 39 is an explanatory diagram (Part 2) illustrating the operation principle of the magnetoresistive element according to the fifth embodiment of the present disclosure.
FIG. 40 is an explanatory diagram (Part 3) illustrating the operation principle of the magnetoresistive element according to the fifth embodiment of the present disclosure.
FIG. 41 is an explanatory diagram illustrating a configuration example and an operation principle of a magnetoresistive element according to a second modification of the fifth embodiment of the present disclosure.
FIG. 42 is a schematic diagram illustrating a configuration example of a magnetoresistive element according to a sixth embodiment of the present disclosure.
FIG. 43 is an explanatory diagram (Part 1) illustrating an operation principle of the magnetoresistive element according to the sixth embodiment of the present disclosure.
FIG. 44 is an explanatory diagram (Part 2) illustrating the operation principle of the magnetoresistive element according to the sixth embodiment of the present disclosure.
FIG. 45 is an explanatory diagram (Part 3) illustrating the operation principle of the magnetoresistive element according to the sixth embodiment of the present disclosure.
FIG. 46 is an explanatory diagram illustrating a configuration example and an operation principle of a magnetoresistive element according to a second modification of the embodiment 6 of the present disclosure.
FIG. 47 is a schematic diagram illustrating a configuration example of a magnetoresistive element according to a third modification of the sixth embodiment of the present disclosure.
FIG. 48 is an explanatory diagram illustrating a configuration example and an operation principle of a magnetoresistive element according to the third modification of the sixth embodiment of the present disclosure.
FIG. 49 is an explanatory diagram illustrating a configuration example and an operation principle of a magnetoresistive element according to a fourth modification of the sixth embodiment of the present disclosure.
FIG. 50 is a circuit diagram of a memory cell array according to a seventh embodiment of the present disclosure.
FIG. 51 is a block diagram illustrating a configuration example of a memory device according to the seventh embodiment of the present disclosure.
FIG. 52 is an explanatory diagram illustrating write pulse control in a low resistance state according to the seventh embodiment of the present disclosure.
FIG. 53 is an explanatory diagram illustrating the write pulse control in a high resistance state according to the seventh embodiment of the present disclosure.
FIG. 54 is a circuit diagram of a memory cell array according to a modification of the seventh embodiment of the present disclosure.
FIG. 55 is a circuit diagram of a memory device according to an eighth embodiment of the present disclosure.
FIG. 56 is an explanatory diagram illustrating an operation when a memory device according to the eighth embodiment of the present disclosure functions as a latch circuit.
FIG. 57 is an explanatory diagram (Part 1) illustrating a storage operation of the memory device according to the eighth embodiment of the present disclosure.
FIG. 58 is an explanatory diagram (Part 2) illustrating the storage operation of the memory device according to the eighth embodiment of the present disclosure.
FIG. 59 is a circuit diagram of a memory device according to a first modification of the eighth embodiment of the present disclosure.
FIG. 60 is an explanatory diagram illustrating an operation when the memory device according to the first modification of the eighth embodiment of the present disclosure functions as a latch circuit.
FIG. 61 is an explanatory diagram (Part 1) illustrating a storage operation of the memory device according to the first modification of the eighth embodiment of the present disclosure.
FIG. 62 is an explanatory diagram (Part 2) illustrating the storage operation of the memory device according to the first modification of the eighth embodiment of the present disclosure.
FIG. 63 is a circuit diagram of a memory device according to a second modification of the eighth embodiment of the present disclosure.
FIG. 64 is an explanatory diagram for illustrating an operation when the memory device according to the second modification of the eighth embodiment of the present disclosure functions as a latch circuit.
FIG. 65 is an explanatory diagram (Part 1) illustrating a storage operation of the memory device according to the second modification of the eighth embodiment of the present disclosure.
FIG. 66 is an explanatory diagram (Part 2) illustrating the storage operation of the memory device according to the second modification of the eighth embodiment of the present disclosure.
FIG. 67 is a circuit diagram of a memory device according to a ninth embodiment of the present disclosure.
FIG. 68 is a circuit diagram illustrating a memory device according to a third modification of the ninth embodiment of the present disclosure.
FIG. 69 is a circuit diagram illustrating a memory device according to a tenth embodiment of the present disclosure.
FIG. 70 is a circuit diagram illustrating a memory device according to a first modification of the tenth embodiment of the present disclosure.
FIG. 71 is a circuit diagram of a memory device according to a second modification of the tenth embodiment of the present disclosure.
FIG. 72 is a circuit diagram of a write unit according to an eleventh embodiment of the present disclosure.
FIG. 73 is a block diagram illustrating an imaging device according to a twelfth embodiment of the present disclosure.
FIG. 74 is a schematic diagram illustrating a laminated structure example of the imaging device according to the twelfth embodiment of the present disclosure.
FIG. 75 is a flowchart of writing according to the twelfth embodiment of the present disclosure.
FIG. 76 is a flowchart of reading according to the twelfth embodiment of the present disclosure.
FIG. 77 is a diagram illustrating an example of a schematic configuration of an imaging device.
FIG. 78 is a diagram illustrating an example of a schematic configuration of a distance measuring device.
FIG. 79 is a perspective view (external perspective view) illustrating an example of a schematic configuration of a game machine.
FIG. 80 is a block diagram illustrating an example of a schematic configuration of the game machine.

### Description of Embodiments

Hereinafter, embodiments of the present disclosure will be described with reference to the drawings. Note that a device, apparatus, method, and the like according to the present disclosure are not limited by the embodiments, and various numerical values, materials, and the like according to the embodiments are examples. In the following embodiments, same parts are basically given the same reference signs to omit redundant description.

In addition, in the present specification and the drawings, a plurality of components having substantially the same or similar functional configurations may be distinguished by attaching different numbers after the same reference signs. However, when it is not particularly necessary to distinguish each of the plurality of components having substantially the same or similar functional configurations, only the same reference sign is assigned. In addition, similar components in different embodiments may be distinguished by adding different alphabets after the same reference signs. However, when it is not necessary to particularly distinguish each of similar components, only the same reference sign is assigned.

In the description below, one or more embodiments (including examples and modifications) may be implemented independently. On the other hand, at least some of the plurality of embodiments described below may be appropriately combined with at least some of other embodiments. The plurality of embodiments may include novel features different from each other. Therefore, the plurality of embodiments can contribute to solving different objects or problems, and can exhibit different effects. Note that the effects in each embodiment are merely examples and are not limited, and other effects may be provided.

In addition, the drawings referred to in the following description are drawings for facilitating the description and understanding of an embodiment of the present disclosure, and shapes, dimensions, ratios, and the like illustrated in the drawings may be different from actual ones for the sake of clarity. Furthermore, elements and the like illustrated in the drawings can be appropriately modified in design in consideration of the following description and known techniques. In addition, in the following description, a vertical direction of a laminated structure of the element and the like corresponds to a relative direction when a surface of a substrate on which the element is provided is facing upward, and may be different from the vertical direction according to actual gravitational acceleration.

In the following description, the description of specific lengths or and shapes does not mean only the same values as mathematically defined values or geometrically defined shapes. Specifically, the description of the specific lengths and shapes in the following description includes a case where there is an allowable difference (error/distortion) in a memory device and a manufacturing process thereof and use/operation thereof, and shapes similar to a shape thereof.

In the following description, terms such as "perpendicular direction" (direction perpendicular to a film surface or laminating direction of laminated structure) and "in-plane direction" (direction parallel to the film surface or direction perpendicular to the laminating direction of the laminated structure) are used for convenience when describing a magnetization direction (magnetic moment) and magnetic anisotropy. However, these terms do not necessarily mean the exact direction of magnetization. For example, an expression such as "the magnetization direction is the perpendicular direction" or "having perpendicular magnetic anisotropy" means that magnetization in the perpendicular direction is superior to magnetization in the in-plane direction. Similarly, for example, an expression such as "the magnetization direction is the in-plane direction" or "having in-plane magnetic anisotropy" means that magnetization in the in-plane direction is superior to magnetization in the perpendicular direction.

In addition, in the following description of a circuit (electrical connection), unless otherwise specified, "connection" means that a plurality of elements is connected such that electricity (signal) is conducted therebetween. In addition, "connection" in the following description includes not only a case of directly and electrically connecting the plurality of elements but also a case of indirectly and electrically connecting the plurality of elements via other elements.

Note that the description will be given in the following order.
1. Background to creation of embodiments according to the present disclosure by inventors
2. First embodiment
   2.1 Configuration example of magnetoresistive element
   2.2 Configuration example of memory cell array
   2.3 Operation principle
   2.4 Configuration example of memory device
   2.5 Write flow
   2.6 First modification
   2.7 Second modification
3. Second embodiment
   3.1 Configuration example of magnetoresistive element
   3.2 Operation principle
   3.3 First modification
   3.4 Second modification
4. Third embodiment
   4.1 Configuration example of magnetoresistive element
   4.2 Operation principle
   4.3 First modification
   4.4 Second modification
   4.5 Third modification
   4.6 Fourth modification
5. Fourth embodiment
   5.1 Configuration example of magnetoresistive element
   5.2 Operation principle
   5.3 First modification
   5.4 Second modification
   5.5 Third modification
   5.6 Fourth modification
6. Fifth embodiment
   6.1 Configuration example of magnetoresistive element
   6.2 Operation principle
   6.3 First modification
   6.4 Second modification
7. Sixth embodiment
   7.1 Configuration example of magnetoresistive element
   7.2 Operation principle
   7.3 First modification
   7.4 Second modification
   7.5 Third modification
   7.6 Fourth modification
8. Seventh embodiment
   8.1 Embodiment
   8.2 Modification
9. Eighth embodiment
   9.1 Embodiment
   9.2 First modification
   9.3 Second modification
10. Ninth embodiment
   10.1 Embodiment
   10.2 First modification
   10.3 Second modification
   10.4 Third modification
11. Tenth embodiment
   11.1 Embodiment
   11.2 First modification
   11.3 Second modification
12. Eleventh embodiment
13. Twelfth embodiment
14. Summary
15. Configuration example of electronic apparatus
   15.1 Imaging device
   15.2 Distance measuring device
   15.3 Game machine
16. Supplement

### <<1. Background to creation of embodiments according to the present disclosure by inventors>>

First, before describing embodiments according to the present disclosure, the background to the creation of the embodiments according to the present disclosure by inventors will be described.

As described above, in recent years, a voltage control type MRAM (VC-MRAM) using VCMA has attracted attention because writing can be performed at a high speed and with low power consumption. A basic structure of the VC-MRAM is also an MTJ element having a sandwich structure in which a nonmagnetic layer (tunnel barrier layer) of an insulator is sandwiched between two magnetic layers formed of a magnetic thin film.

In a write system of the VC-MRAM, a bidirectional write operation is performed with a unipolar voltage. When no voltage is applied to the MTJ element, magnetization is oriented in a film plane perpendicular direction (z direction) due to perpendicular magnetic anisotropy (property that magnetization is easily oriented in the film plane perpendicular direction) of a storage layer. Similarly, magnetization of a magnetization fixed layer also faces the z direction due to the perpendicular magnetic anisotropy. Here, it is assumed that both the magnetization directions of the storage layer and the magnetization fixed layer are in the +z direction, i.e., in a parallel state, and thus a state 0 is written in the MTJ element. Furthermore, it is assumed that an external magnetic field (Hext) is applied to the MTJ element in the +x direction among in-plane directions (x direction and y direction). At this time, when a voltage is applied to the MTJ element, the perpendicular magnetic anisotropy of the storage layer disappears by an electric field generated in the vicinity of an interface between the nonmagnetic layer and the storage layer, and thus the property that the magnetization tends to be oriented in the film surface perpendicular direction is lost. As a result, the magnetization of the storage layer starts to move toward the x direction in which magnetic energy is minimized by the external magnetic field. At that time, the magnetization direction of the storage layer does not simply change linearly from the +z direction to the +x direction, but starts a so-called spin precession movement of gradually moving in the +x direction while circling around the direction of the external magnetic field (Hext), as an axis, in a yz plane.

Then, there is a moment when the magnetization of the storage layer that has been initially oriented in the +z direction is oriented in substantially -z direction during the precession movement in the yz plane. When a voltage applied to the MTJ element at this time is set to zero, the perpendicular magnetic anisotropy of the storage layer returns to the original state, and the magnetization tends to be directed in the film surface perpendicular direction, so that the magnetization of the storage layer is fixed in the -z direction. In other words, by applying a pulsed voltage to the MTJ element, from the state 0 in which the magnetization directions of the storage layer and the magnetization fixed layer are parallel to each other, a state 1 in which the magnetization directions of the storage layer and the magnetization fixed layer are antiparallel to each other is written. Similarly, since the above-described phenomenon occurs even in the state 1 in which the magnetization direction of the storage layer is first oriented in the -z direction, bidirectional writing can be realized by applying a unipolar pulse voltage to the MTJ element.

In the voltage writing system using VCMA disclosed in Patent Literature 1, the probability of reversal of the magnetization direction of the storage layer approaches 1 (success) by setting a pulse width of the pulse voltage to about 0.7 [nsec]. In the system disclosed in Patent Literature 1, when the pulse width is longer than 0.7 [nsec], a success rate oscillates and converges to 0.5 (success and failure are 50%). In other words, there is an optimum pulse width for reversing the magnetization direction of the storage layer, and an optimum value of the pulse width depends on the external magnetic field (Hext).

In the system disclosed in Patent Literature 1, since the success rate is deteriorated even when the pulse width is shortened or lengthened with respect to optimal time. Thus, it is required to appropriately control the pulse width at high accuracy. However, it is difficult to accurately control the pulse width of several nanoseconds. Patent Literature 1 discloses a control circuit capable of performing the above control. However, when a memory cell array including a plurality of storage elements becomes large, pulse blunting due to the presence of parasitic resistance and parasitic capacitance cannot be ignored, and it becomes more difficult to apply the pulse voltage having a short pulse width at high accuracy to the storage elements.

In addition, Patent Literature 1 described above provides a flowchart of writing, and data programming (application of a write pulse voltage) is executed after initial reading is performed. Specifically, in the system disclosed in Patent Literature 1, since the magnetization direction of the storage layer is reversed by applying the unipolar (same direction) pulse voltage (so-called "toggle writing"), initial reading is performed to confirm whether the pulse voltage matches expectation in order to apply the pulse voltage only when the storage layer is in a state opposite to the expected state. The pulse voltage is applied based on the result.

Therefore, in the system disclosed in Patent Literature 1, since the initial reading is performed, actual write time requires time obtained by integrating time of the initial reading and time of applying the write pulse. Therefore, it cannot be said that the system disclosed in Patent Literature 1 fully utilizes the characteristic of the VC-MRAM to write at high speed.

Therefore, in view of the above situation, the inventors have intensively studied, and created embodiments of the VC-MRAM that does not need to perform the pulse width control at high-accuracy and initial reading. In the embodiments of the present disclosure created by the inventors, the storage element includes a plurality of storage layers that can use the VCMA, and change directions of the magnetic anisotropy of each of the storage layers with respect to applied voltage are opposite to each other. Alternatively, in the embodiments of the present disclosure created by the inventors, the storage element has the storage layer sandwiched between the tunnel barrier layers that can use the VCMA, and change directions of the magnetic anisotropy with respect to the applied voltage on an interface between one tunnel barrier layer and the storage layer and an interface between the other tunnel barrier layer and the storage layer are opposite to each other.

According to the embodiments of the present disclosure created by the inventors, since the probability of reversal of the magnetization direction of the storage layer does not deteriorate even when the pulse width of the applied voltage becomes long, writing can be easily performed without performing high-accuracy control of the pulse width. Furthermore, according to the embodiments of the present disclosure, a complicated and large-scale control circuit for controlling a short pulse width at high accuracy is not required.

Furthermore, in the embodiments of the present disclosure, in the writing of the storage element, a voltage in opposite directions (reverse directions) is applied (so-called "non-toggle writing") between writing in a state in which the magnetization directions of the magnetization fixed layer and the storage layer are parallel to each other (low resistance state) and writing in an antiparallel state (high resistance state). More specifically, in the embodiment of the present disclosure, a voltage in the opposite directions is applied between the case of writing from the high resistance state to the low resistance state and maintaining the high resistance state and the case of writing from the low resistance state to the high resistance state and maintaining the low resistance state. In other words, in the embodiments of the present disclosure, it is not necessary to perform the initial reading because a voltage and a bipolar voltage according to the expected state are applied to the storage layer, and the magnetization direction of the storage layer is not reversed by applying the unipolar (same direction) pulse voltage. Therefore, according to the embodiments of the present disclosure, since it is not necessary to perform the initial reading, it is possible to avoid an increase in the write time. The characteristics of the VC-MRAM to write at high speed can be sufficiently utilized. Hereinafter, details of the embodiments of the present disclosure will be sequentially described.

### <<2. First embodiment>>

### <2.1 Configuration example of magnetoresistive element>

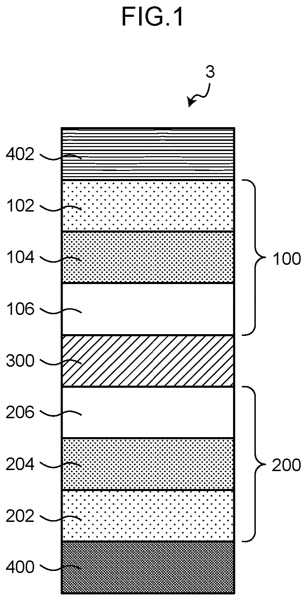

First, a configuration example of a magnetoresistive element 3 according to a first embodiment of the present disclosure will be described in detail with reference to FIG. 1. FIG. 1 is a schematic diagram illustrating the configuration example of the magnetoresistive element 3 according to the present embodiment.

In the present embodiment, the magnetoresistive element 3 is a voltage-controlled magnetic anisotropy (VCMA) effect magnetoresistive element, and has a laminated structure in which, for example, two MTJ elements 100 and 200 (first MTJ element and second MTJ element) are laminated as illustrated in FIG. 1. Each of the MTJ elements 100 and 200 includes magnetization fixed layers (reference layers) 102 and 202 whose magnetization direction is fixed, storage layers 106 and 206 whose magnetization direction changes according to an input magnetic field, and tunnel barrier layers 104 and 204 arranged between the magnetization fixed layers 102 and 202 and the storage layers 106 and 206. Furthermore, in the present embodiment, a magnetic coupling layer 300 is sandwiched between the two MTJ elements 100 and 200. Specifically, the magnetic coupling layer 300 is provided so as to be sandwiched between the storage layer 106 of the MTJ element (one MTJ element) 100 and the storage layer 206 of the MTJ element (the other MTJ element) 200. Furthermore, as illustrated in FIG. 1, a cap layer 402 and a base layer 400 are provided so as to sandwich the laminated structure of the two MTJ elements 100 and 200. Hereinafter, each layer of the magnetoresistive element 3 will be sequentially described.

The magnetization fixed layers 102 and 202 can be formed using cobalt iron boron (CoFeB), a cobalt iron boron alloy, a cobalt iron carbon (CoFeC) alloy, a nickel iron boron (NiFeB) alloy, a nickel iron carbon (NiFeC) alloy, or the like. Furthermore, the magnetization fixed layers 102 and 202 may have a configuration including a ferromagnetic layer or a laminated ferri-pin structure in which a plurality of ferromagnetic layers is laminated with a nonmagnetic layer interposed therebetween. As a material of the ferromagnetic layer configuring the magnetization fixed layer having the laminated ferri-pin structure, cobalt (Co), cobalt iron (CoFe), CoFeB, or the like can be used. As a material of the nonmagnetic layer, ruthenium (Ru), rhenium (Re), iridium (Ir), osmium (Os), or the like can be used. Furthermore, the magnetization fixed layers 102 and 202 can be layers in which the magnetization direction is fixed by using antiferromagnetic coupling between the antiferromagnetic layer and the ferromagnetic layer. In this case, examples of the material of the antiferromagnetic layer include magnetic materials such as an iron manganese (FeMn) alloy, a platinum manganese (PtMn) alloy, a platinum chromium manganese (PtCrMn) alloy, a nickel manganese (NiMn) alloy, an iridium manganese (IrMn) alloy, nickel oxide (NiO), and iron oxide (Fe₂O₃). Furthermore, nonmagnetic elements such as silver (Ag), copper (Cu), gold (Au), aluminum (Al), silicon (Si), bismuth (Bi), tantalum (Ta), boron (B), carbon (C), oxygen (O), nitrogen (N), palladium (Pd), platinum (Pt), zirconium (Zr), hafnium (Hf), Ir, tungsten (W), molybdenum (Mo), and niobium (Nb) may be added to these magnetic materials.

The storage layers 106 and 206 can be formed using CoFe, CoFeB, iron (Fe), iron boride (FeB), or the like. Furthermore, the storage layers 106 and 206 may contain transition metals (Hf, Ta, W, Re, Ir, Pt, Au, Zr, Nb, Mo, Ru, rhodium (Rh), Pd, Ag, titanium (Ti), vanadium (V), chromium (Cr), manganese (Mn), nickel (Ni), Cu, or nitrides and oxides thereof. Furthermore, the storage layers 106 and 206 may be formed using Ir and Os as materials that induce a proximity magnetic moment to the magnetic material. In the present embodiment, the storage layers 106 and 206 preferably have a film thickness of 3.0 nm or less.

The tunnel barrier layers 104 and 204 can be formed, for example, using an oxide of at least one element selected from a group consisting of magnesium (Mg), Al, Ti, Si, zinc (Zn), Zr, Hf, Ta, Bi, Cr, gallium (Ga), lanthanum (La), gadolinium (Gd), strontium (Sr), and barium (Ba),or a nitride of at least one element selected from a group consisting of Mg, Al, Ti, Si, Zn, Zr, Hf, Ta, Bi, Cr, Ga, La, Gd, Sr, and Ba. In addition, the tunnel barrier layers 104 and 204 may be formed using various insulators, dielectrics, and semiconductors such as magnesium fluoride (MgF₂), calcium fluoride (CaF), strontium titanate (SrTiO₂), lanthanum aluminate (LaAlO₃), and aluminum oxynitride (AlNO). In the present embodiment, the tunnel barrier layers 104 and 204 preferably have a film thickness of 0.6 nm or more.

In the present embodiment, it is preferable that the MTJ elements 100 and 200 have different tunnel magneto resistance (TMR) ratios, and thus, it is preferable that the tunnel barrier layers 104 and 204 of the MTJ elements 100 and 200 have different film thicknesses. Furthermore, in the present embodiment, it is preferable that a value sequentially decreases in the order of a resistance value of the MTJ element 200 in a high resistance state, a resistance value of the MTJ element 100 in the high resistance state, a resistance value of the MTJ element 100 in a low resistance state, and a resistance value of the MTJ element 200 in the low resistance state.

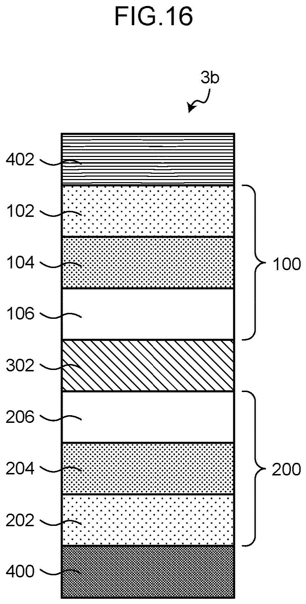

In the present embodiment, there is only a case where the magnetization of the two storage layers 106 and 206 sandwiching the magnetic coupling layer 300 faces the same direction due to the ferromagnetic coupling by the magnetic coupling layer 300. The magnetic coupling layer 300 can be formed using Mg, Al, Ti, Si, Zn, Zr, Hf, Ta, Bi, Cr, Ga, La, Gd, Sr, Ba, W, Re, Ir, Pt, Au, Nb, Mo, Ru, Rh, Pd, Ag, V, Mn, Ni, Cu, Os, or the like. In addition, an antiferromagnetic coupling layer 302 (see FIG. 16) of a second embodiment of the present disclosure described later can also be formed of the same material as the magnetic coupling layer 300, and the layer can be either the magnetic coupling layer 300 or the antiferromagnetic coupling layer 302 by changing a film thickness of the layer.

The base layer 400 can be formed using a noble metal such as Cr, Ta, Ru, Au, Ag, Cu, Al, Ti, V, Mo, Zr, Hf, Re, W, Pt, Pd, Ir, or Rh, an alloy containing the noble metal, a layer made of a transition metal element, and a laminated structure of the noble metal and the alloy. The base layer 400 can also be formed using a conductive nitride such as titanium nitride (TiN).

The cap layer 402 can be formed using a noble metal such as Cr, Ta, Ru, Au, Ag, Cu, Al, Ti, V, Mo, Zr, Hf, Re, W, Pt, Pd, Ir, or Rh, an alloy containing the noble metal, a layer made of a transition metal element, and a laminated structure of the noble metal and the alloy. The cap layer 402 can be formed using a conductive nitride such as TiN.

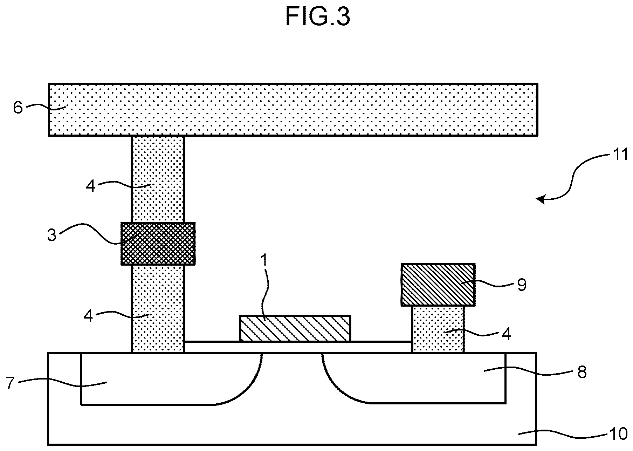

A diameter of the magnetoresistive element 3 is 15 nm or more, preferably 30 nm or more, more preferably 40 nm or more, and 280 nm or less, preferably 100 nm or less, more preferably 80 nm or less. In addition, a shape of the cross section (cross section when cut perpendicularly to the lamination direction) of the magnetoresistive element 3 may be circular or elliptical, but is not particularly limited in the present embodiment. In addition, in the present embodiment, the magnetoresistive element 3 has a plurality of storage layers 106 and 206 in which the VCMA can be used, and as will be described later, directions of change in the magnetic anisotropy of the storage layers 106 and 206 with respect to the applied voltage are not limited to the configuration illustrated in FIG. 3 as long as the directions are opposite to each other. Furthermore, in the present embodiment, the magnetization direction of the magnetization fixed layer 102 of the MTJ element 100 is downward, and the magnetization direction of the magnetization fixed layer 202 of the MTJ element 200 is upward.

### <2.2 Configuration example of memory cell array>

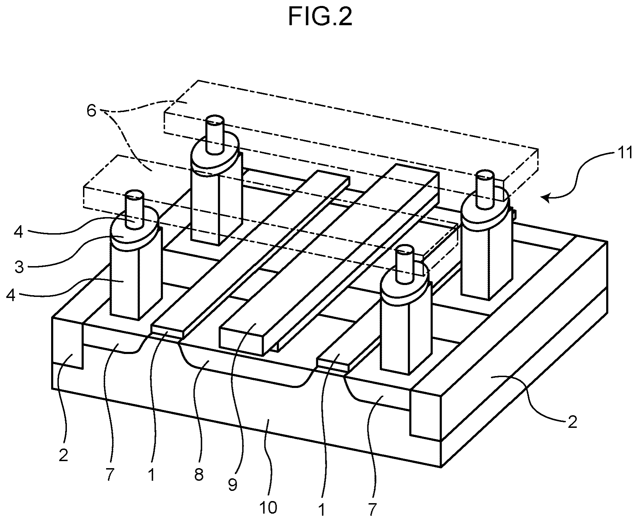

A memory cell array 11 including the magnetoresistive element 3 will be described with reference to FIGS. 2 and 3. FIG. 2 is a perspective view of an example of a specific configuration of the memory cell array 11 according to the present embodiment, and FIG. 3 is a cross-sectional view of the memory cell array 11 in FIG. 2.

As illustrated in FIG. 2, the magnetoresistive elements 3 are disposed at intersections of two types of address wirings (word line (second control line) and bit line (first control line) 6) orthogonal to each other. Specifically, a selection transistor (selection element) for selecting each magnetoresistive element 3 is formed in a region of a semiconductor substrate 10 separated by an element separation layer 2 provided on the semiconductor substrate 10 such as a silicon substrate. The selection transistor includes a drain region 8 and a source region 7 provided in the semiconductor substrate 10, and a gate electrode 1. The gate electrode 1 also serves as one address line (word line) extending in a depth direction in FIG. 2. The drain region 8 is formed in common for the two selection transistors arranged along the left-right direction in FIG. 2, and a wiring 9 is connected to the drain region 8. In other words, in the present embodiment, the magnetoresistive element 3 is disposed between the source region 7 and the bit line 6 disposed above and extending in the left-right direction in FIG. 2.

In addition, as illustrated in FIG. 3, the magnetoresistive element 3 is connected to the bit line 6 and the source region 7 via contact layers 4 located above and below. Thus, the magnetoresistive element 3 can be accessed by applying a voltage to the magnetoresistive element 3 through two types of address wirings. Note that the configuration of the memory cell array 11 according to the present embodiment is not limited to the configuration illustrated in FIGS. 2 and 3.

### <2.3 Operation principle>

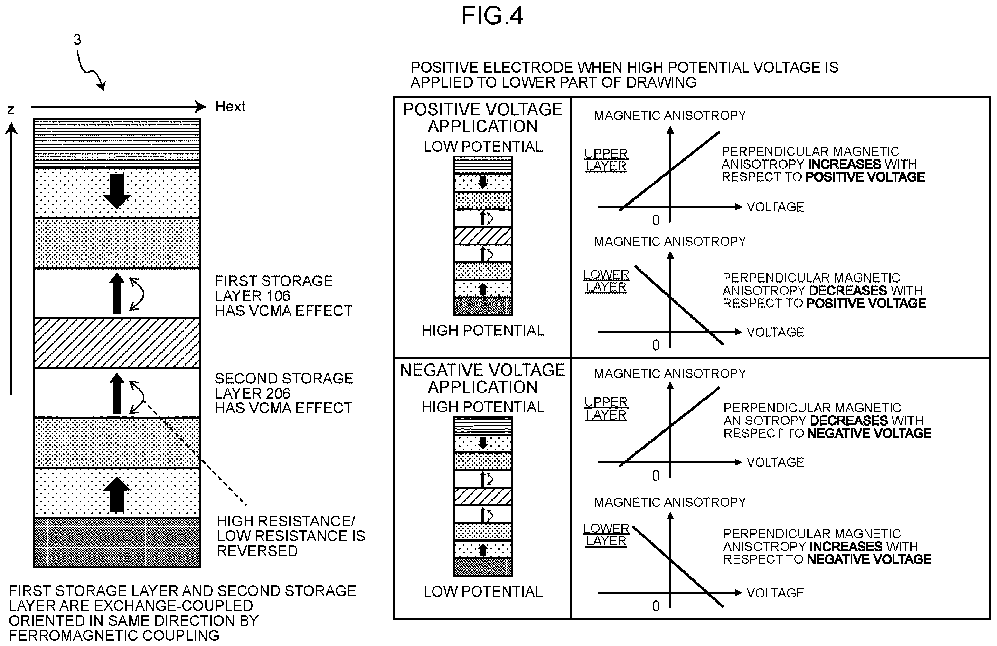

Next, an operation principle of the magnetoresistive element 3 according to the present embodiment will be described with reference to FIGS. 4 to 7. FIGS. 4 to 7 are explanatory diagrams illustrating the operation principle of the magnetoresistive element 3 according to the present embodiment.

FIG. 4 schematically illustrates changes in the magnetic anisotropy of the storage layer 106 of the MTJ element 100 and the storage layer 206 of the MTJ element 200 when a positive voltage (hereinafter, a case where a voltage having a high potential is applied in a lower part of the drawing is referred to as a "positive voltage") is applied and when a negative voltage (hereinafter, a case where a voltage having a high potential is applied in an upper part of the drawing is referred to as a "negative voltage") is applied to the magnetoresistive element 3 according to the present embodiment. In this case, the two storage layers 106 and 206 are exchange-coupled (ferromagnetically coupled) via the magnetic coupling layer 300, and magnetization is directed in the same direction. In FIG. 4, a vertical direction is defined as a z axis, and an external magnetic field Hext is applied to the magnetoresistive element 3 in an x-y plane direction orthogonal to the z axis.

As illustrated in FIG. 4, in the magnetoresistive element 3 according to the present embodiment, when the positive voltage is applied, due to the VCMA effect, perpendicular magnetic anisotropy of the storage layer 106 of the MTJ element 100 increases, and perpendicular magnetic anisotropy of the storage layer 206 of the MTJ element 200 decreases. Furthermore, in the magnetoresistive element 3 according to the present embodiment, when the negative voltage is applied, due to the VCMA effect, the perpendicular magnetic anisotropy of the storage layer 106 of the MTJ element 100 decreases and the perpendicular magnetic anisotropy of the storage layer 206 of the MTJ element 200 increases.

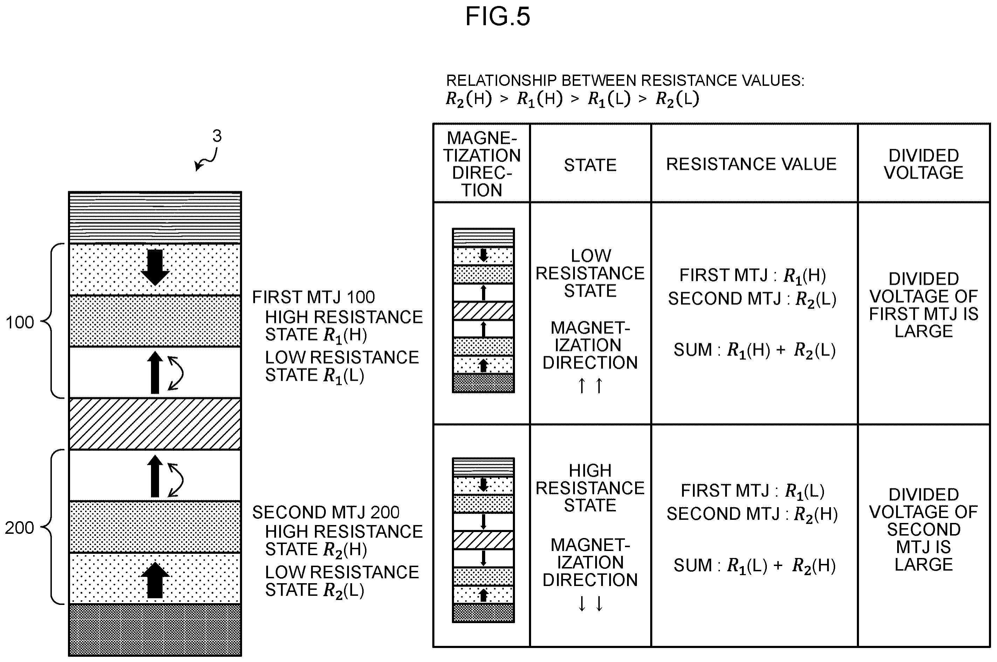

Next, FIG. 5 illustrates a relationship between a resistance state and the magnetization direction of the MTJ elements 100 and 200. In the present embodiment, the MTJ elements 100 and 200 have different resistance values. Specifically, in the present embodiment, a resistance value R₁(H) in the high resistance state and a resistance value R₁(L) in the low resistance state of the MTJ element 100, and a resistance value R₂(H) in the high resistance state and a resistance value R₂(L) in the low resistance state of the MTJ element 200 have, for example, a magnitude relationship of R₂(H)>R₁(H)>R₁(L)>R₂(L). Note that, in the present embodiment, the resistance values (R₁(L) and R₂(L)) of respective MTJ elements 100 and 200 in the low resistance state may be substantially equal, or may have a relationship of R₁(L)<R₂(L).

Hereinafter, the magnetization directions of the storage layers 106 and 206 are indicated by arrows (e.g., "↑↑"). A left arrow indicates the magnetization direction of the storage layer 106 in an upper layer, and a right arrow indicates the magnetization direction of the storage layer 206 in a lower layer. Furthermore, in the following drawings, the MTJ element 100 is also referred to as a "first MTJ", and the MTJ element 200 is also referred to as a "second MTJ".

In the case as described above, when the magnetization directions of the storage layers 106 and 206 are both upward (↑↑), the MTJ element 100 is in the high resistance state and the MTJ element 200 is in the low resistance state in relation to the magnetization directions of the magnetization fixed layers 102 and 202. Similarly, when the magnetization directions of the storage layers 106 and 206 are both downward (↓↓), the MTJ element 100 is in the low resistance state and the MTJ element 200 is in the high resistance state in relation to the magnetization directions of the magnetization fixed layers 102 and 202. In addition, since the entire resistance value of the magnetoresistive element 3 is the sum of the resistance values of the MTJ elements 100 and 200, when the magnetization directions of the storage layers 106 and 206 are both upward (↑↑), the magnetoresistive element 3 becomes the low resistance state, and when the magnetization directions of the storage layers 106 and 206 are both downward (↓↓), the magnetoresistive element 3 becomes the high resistance state. Note that, in the present embodiment, the two storage layers 106 and 206 are exchange-coupled (ferromagnetically coupled) via the magnetic coupling layer 300, and only magnetization in the same direction exists.

Furthermore, in the case as described above, when the magnetization directions of the storage layers 106 and 206 are both upward (↑↑), the resistance value of the MTJ element 100 is higher than that of the MTJ element 200. Thus, a divided voltage of the MTJ element 100 increases when a voltage is applied to the magnetoresistive element 3. On the other hand, when the magnetization directions of the storage layers 106 and 206 are both downward (↓↓), the resistance value of the MTJ element 200 is higher than that of the MTJ element 100. Thus, a divided voltage of the MTJ element 200 increases when the voltage is applied to the magnetoresistive element 3. As described above, since the resistance value of the magnetoresistive element 3 changes, a state of the magnetoresistive element 3 can be detected, i.e., a stored state can be read, from the resistance value. Note that, in the present embodiment, the magnitude relationship of the resistance values of the MTJ elements 100 and 200 may be opposite from the above. In that case, the write voltage directions also become opposite.

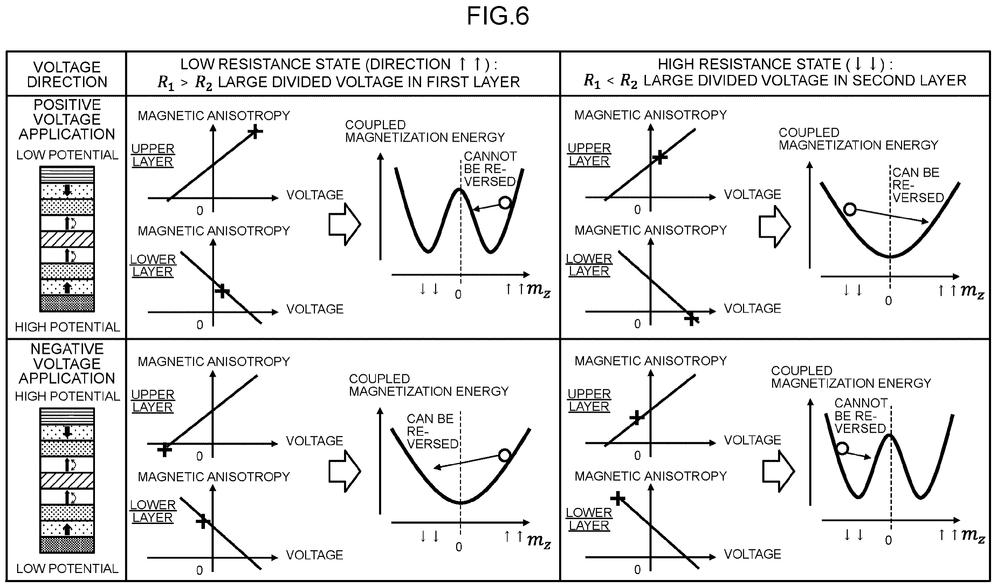

Next, FIG. 6 illustrates a schematic diagram of magnetic anisotropy of the storage layers 106 and 206 at the time of voltage application and magnetization energy obtained by coupling the two storage layers 106 and 206. In the following drawings, an "upper layer" means the storage layer 106 on the upper layer side, and a "lower layer" means the storage layer 206 on the lower layer side.

In the magnetoresistive element 3 according to the present embodiment, when the magnetization energy obtained by coupling the storage layers 106 and 206 forms a valley, the magnetization direction of either of the storage layers 106 and 206 moves to a low energy state while performing precession movement around the direction of the external magnetic field Hext, as an axis, and thus the magnetization direction is reversed.

First, a case where the positive voltage is applied to the magnetoresistive element 3 in the low resistance state will be described. In this case, the divided voltage of the MTJ element 100 is large, and the magnetic anisotropy of the storage layer 106 of the MTJ element 100 is large. Therefore, since the magnetic anisotropy becomes large in the entire magnetoresistive element 3, the magnetization energy forms a barrier (projected shape) and the magnetization direction cannot be reversed as illustrated in the upper left of FIG. 6.

Next, a case where the positive voltage is applied to the magnetoresistive element 3 in the high resistance state will be described. In this case, the divided voltage of the MTJ element 200 is large, and the magnetic anisotropy of the storage layer 206 of the MTJ element 200 is small. Therefore, since the magnetic anisotropy becomes small in the entire magnetoresistive element 3, the magnetization energy forms a valley and the magnetization direction can be reversed as illustrated in the upper right of FIG. 6.

Next, a case where the negative voltage is applied to the magnetoresistive element 3 in the low resistance state will be described. In this case, the divided voltage of the MTJ element 100 is large, and the magnetic anisotropy of the storage layer 106 of the MTJ element 100 is small. Therefore, since the magnetic anisotropy becomes small in the entire magnetoresistive element 3, the magnetization energy forms a valley and the magnetization direction can be reversed as illustrated in the lower left of FIG. 6.

Next, a case where a negative voltage is applied to the magnetoresistive element 3 in the high resistance state will be described. In this case, the divided voltage of the MTJ element 200 is large, and the magnetic anisotropy of the storage layer 106 of the MTJ element 200 is large. Therefore, since the magnetic anisotropy becomes large in the entire magnetoresistive element 3, the magnetization energy forms a barrier (projected shape) and the magnetization direction cannot be reversed as illustrated in the lower right of FIG. 6.

As described above, in the magnetoresistive element 3 according to the present embodiment, when the magnetization energy obtained by coupling the storage layers 106 and 206 of the MTJ elements 100 and 200 forms a valley, the magnetization direction is reversed since the magnetoresistive element 3 moves to a low energy state while performing precession movement about the direction of the external magnetic field Hext as an axis. Furthermore, in the present embodiment, as described below, when the magnetization direction is reversed and the resistance state is changed, the magnetic anisotropy and the magnetization energy are also changed. Therefore, a stable state in which the magnetization direction cannot be reversed is obtained.

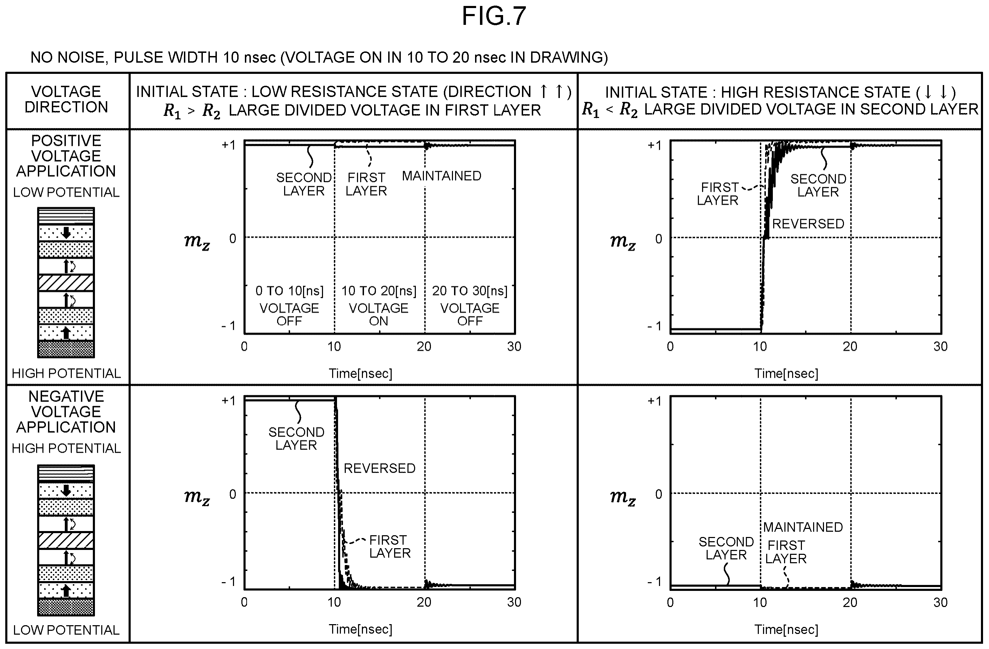

FIG. 7 illustrates behavior, obtained by computer simulation, of a magnetization vector during application of a voltage to the magnetoresistive element 3. In a graph in FIG. 7, a horizontal axis represents time, a vertical axis represents a z component m_{z} of magnetization, and m_{z} at +1 means upward (↑) and at -1 means downward (↓). As simulation conditions, a voltage is applied for 10 to 20 nsec, and a relaxation time (time not applying voltage) of 10 nsec is provided before and after the voltage application. Furthermore, in the following drawings, a "first layer" means the MTJ element 100 on the upper layer side, and a "second layer" means the MTJ element 200 on the lower layer side.

When the positive voltage is applied to the magnetoresistive element 3 in the low resistance state, as illustrated in the upper left of FIG. 7, the magnetization directions of the storage layers 106 and 206 are not reversed, and the state is maintained. In addition, when the positive voltage is applied to the magnetoresistive element 3 in the high resistance state, as illustrated in the upper right of FIG. 7, the magnetization directions of the storage layers 106 and 206 are reversed, and the state is maintained without vibration after the reversal. In addition, when the negative voltage is applied to the magnetoresistive element 3 in the low resistance state, as illustrated in the lower left of FIG. 7, the magnetization directions of the storage layers 106 and 206 are reversed, and the state is maintained without vibration after the reversal. In addition, when the negative voltage is applied to the magnetoresistive element 3 in the high resistance state as illustrated in the lower right of FIG. 7, the magnetization direction is not reversed in the storage layers 106 and 206, and the state is maintained.

More specifically, in the magnetoresistive element 3 according to the present embodiment, even when a pulse width of the voltage applied becomes as long as 20 [nsec] and the magnetization direction is reversed in both the storage layers 106 and 206, the state is maintained after the reversal. In other words, in the magnetoresistive element 3 according to the present embodiment, it has been found that the storage layers 106 and 206 maintain the magnetization directions expected even when the pulse width of the voltage applied becomes long.

In the method disclosed in Patent Literature 1 described above, since the magnetization direction goes around while voltage is applied, a success rate of reversing the magnetization direction to a desired direction is deteriorated when a pulse width of the voltage applied is increased. On the other hand, in the present embodiment, even when the pulse width of the applied voltage is increased, the state is maintained after the reversal. Specifically, in the present embodiment, as illustrated in FIG. 7, a magnetization direction after the reversal is maintained even when the voltage application is stopped at any timing after 2 to 3 [nsec] from a start of voltage application. In addition, the magnetoresistive element 3 according to the present embodiment does not need to increase the pulse width in order to lower a write error rate as in the STT-MRAM, and the pulse width can be further reduced when control can be realized. For example, in FIG. 7, simulation is performed assuming the pulse width of 10 [nsec] which is a cycle of a 100-MHz clock. The present embodiment is also applicable to a case where an operating frequency is improved and the cycle is shortened in the future.

Therefore, according to the present embodiment, since the probability of reversal of the magnetization direction of the storage layer does not deteriorate even when the pulse width of the applied voltage becomes long, a write operation can be easily performed without performing high-accuracy control of the pulse width. Furthermore, according to the present embodiments, a complicated and large-scale control circuit for controlling a short pulse width with high accuracy is not required.

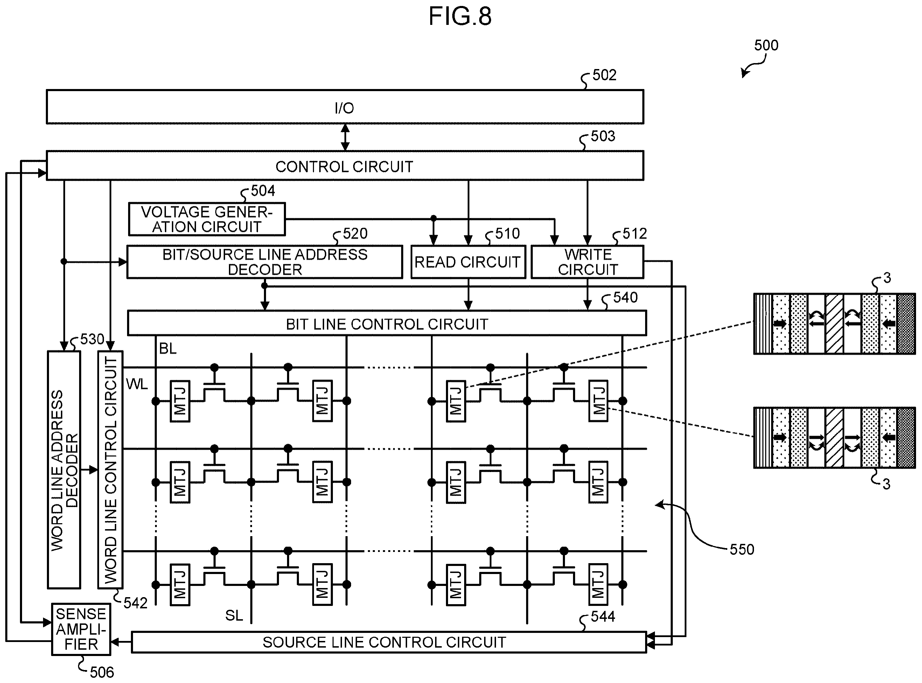

In addition, when the operation of the magnetoresistive element 3 according to the present embodiment is to be used, the positive voltage is applied, so as to write to the magnetoresistive element 3 in the low resistance state and maintain the low resistance state. In addition, when the operation of the magnetoresistive element 3 according to the present embodiment is to be used, the negative voltage is applied, so as to write to the magnetoresistive element 3 in the high resistance state and maintain the high resistance state. In other words, in the present embodiment, a write circuit 512 (see FIG. 8) to be described later controls the magnetoresistive element 3 such that a write voltage (first voltage) in the high resistance state and a write voltage (second voltage) in the low resistance state are opposite to each other.

In the method disclosed in Patent Literature 1 described above, since the magnetization direction is reversed during the voltage application, initial reading to confirm the state of the magnetoresistive element 3 is required. On the other hand, in the present embodiment, since a voltage corresponding to an expected state is applied and the expected state is maintained even after the reversal, initial reading to confirm the state of the magnetoresistive element 3 is not required. Therefore, according to the present embodiment, it is possible to avoid an increase in the write time. Thus, a characteristic of the VC-MRAM that writing is fast can be fully utilized.

### <2.4 Configuration example of memory device>

Next, a memory device (memory system) 500 including the magnetoresistive element 3 will be described with reference to FIG. 8. FIG. 8 is a block diagram of the memory device 500 according to the present embodiment.

As illustrated in FIG. 8, the memory device 500 mainly includes an input/output unit (I/O) 502, a control circuit 503, a voltage generation circuit 504, a sense amplifier 506, a read circuit 510, a write circuit 512, a bit/source line address decoder 520, a word line address decoder 530, a bit line control circuit 540, a word line control circuit 542, a source line control circuit 544, and a memory cell array 550. Furthermore, the memory cell array 550 includes a plurality of magnetoresistive elements 3 described above, a selection transistor (selection element), a bit line (BL), a word line (WL), and a source line (SL).

In the present embodiment, a command, an address, write data, and read data can be transferred through the input/output unit (I/O) 502. The voltage generation circuit 504 can generate a pulse voltage used for write and read. In addition, it is assumed that a voltage necessary for the circuit operation is supplied from a power supply (not illustrated). The bit/source line address decoder 520 and the word line address decoder 530 may obtain addresses of the bit/source line and the word line to be accessed according to the received address. The write circuit 512 and the read circuit 510 can control write/read with respect to the magnetoresistive element 3 according to the command. Specifically, the write circuit 512 controls the write pulse, the read circuit 510 controls a read pulse, and the sense amplifier 506 detects the read data.

### <2.5 Write flow>

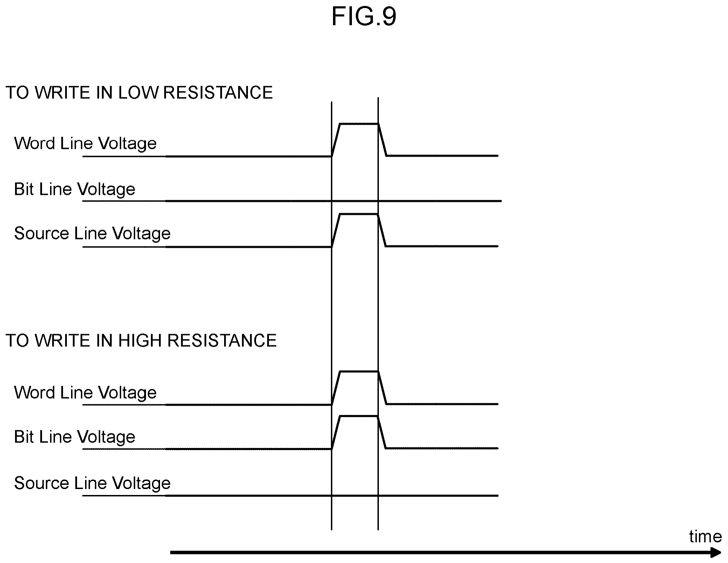

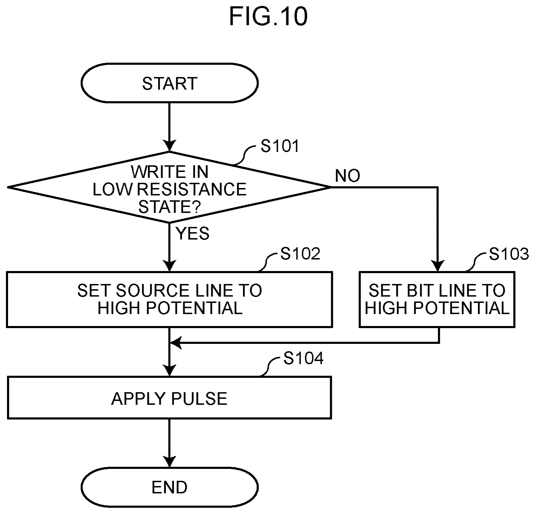

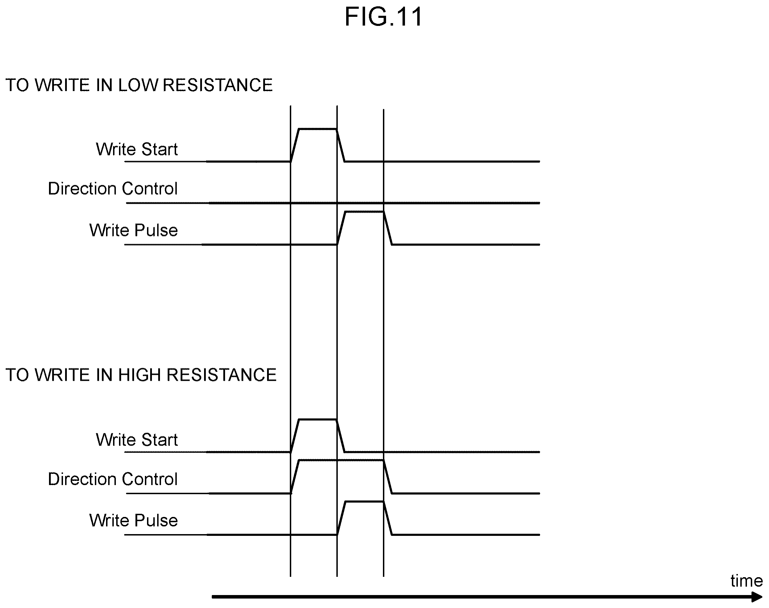

Next, a write flow of the magnetoresistive element 3 will be described with reference to FIGS. 9 to 11. FIG. 9 is a write timing chart of the memory device 500 according to the present embodiment, FIG. 10 is a write flowchart of the memory device 500 according to the present embodiment, and FIG. 11 is a timing chart of write voltage control in the memory device 500 according to the present embodiment.

As illustrated in FIG. 9, in the present embodiment, to write in the low resistance state and maintain the low resistance state, the source line is controlled to a high potential in order to apply the positive voltage to the magnetoresistive element 3. Further, in the present embodiment, to write in the high resistance state and maintain the high resistance state, the bit line is controlled to a high potential in order to apply the negative voltage to the magnetoresistive element 3. In the present embodiment, the laminated structure and electrical connection of the magnetoresistive elements 3 illustrated in FIGS. 1 to 3 and 8 are not limited to the illustrated form, and may be opposite. In other words, in the present embodiment, a voltage control relationship between the bit line and the source line may be opposite according to a connection relationship thereof or the like. In FIG. 9, pulse widths of voltages applied to the word line, the source line, and the bit line are the same, but the pulse widths may be different in the present embodiment. For example, the voltage of the word line may be turned on first, then the voltage of the source line or the bit line may be turned on/off, and finally the word line may be turned off.

FIG. 10 illustrates a flowchart of the present embodiment. In the memory device 500 having a block as illustrated in FIG. 8, for example, the write flow illustrated in FIG. 10 can be executed. As illustrated in FIG. 10, the flow is started by inputting a write command and the write data. Next, the memory device 500 determines whether to write in the low resistance state or to maintain the low resistance state (Step S101). When writing in the low resistance state or maintaining the low resistance state (Step S101: Yes), the memory device 500 proceeds to Step S102 and sets the source line to a high potential (Step S102). On the other hand, when writing in the low resistance state or maintaining the low resistance state is not performed (Step S101: No), the memory device 500 proceeds to Step S103 and sets the bit line to a high potential (Step S103). Then, the memory device 500 applies the pulse voltage (Step S104) according to determination in Step S102 or Step S104, and ends the flow.

FIG. 11 illustrates a write control timing chart of the memory device 500. In the present embodiment, when the flow of FIG. 10 is executed, the write circuit 512 issues a control signal illustrated in FIG. 11, and each control circuit generates a voltage as illustrated in FIG. 9. Further, when writing starts, the write circuit 512 issues a write start signal Write Start and a write direction control signal Direction Control. At this time, the write circuit 512 sets the write direction control signal Direction Control to Low when writing in the low resistance state and maintaining the low resistance state. When writing in the high resistance state and maintaining the high resistance state, the write circuit 512 sets the write direction control signal Direction Control to High. Then, the write circuit 512 issues a write pulse after issuing the control signal.

### <2.6 First modification>

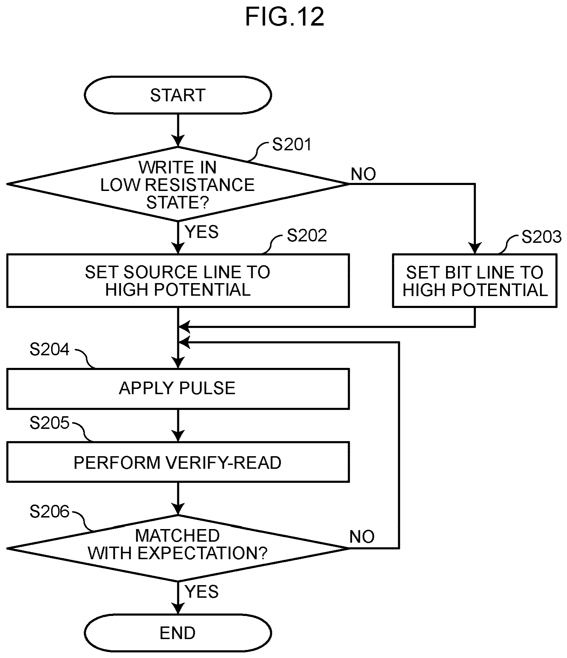

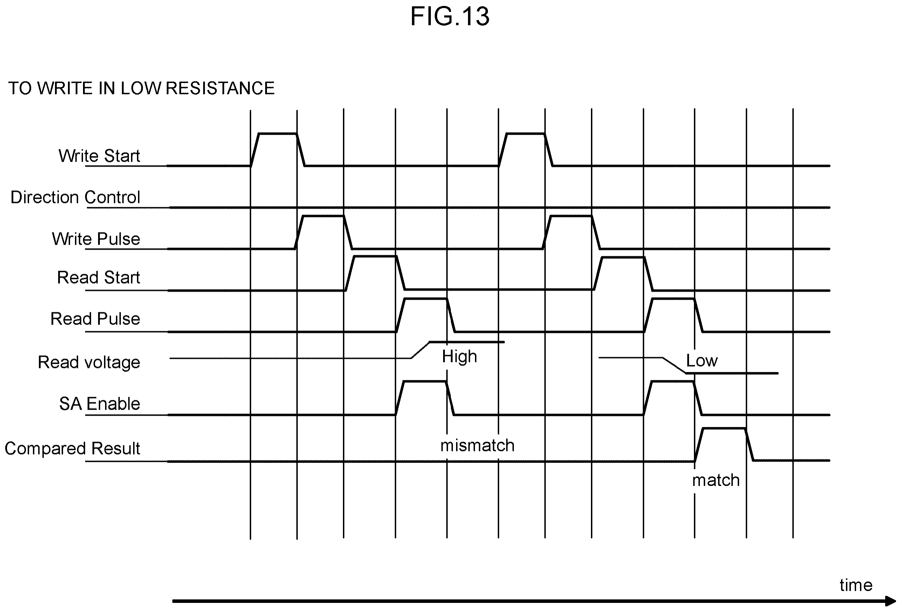

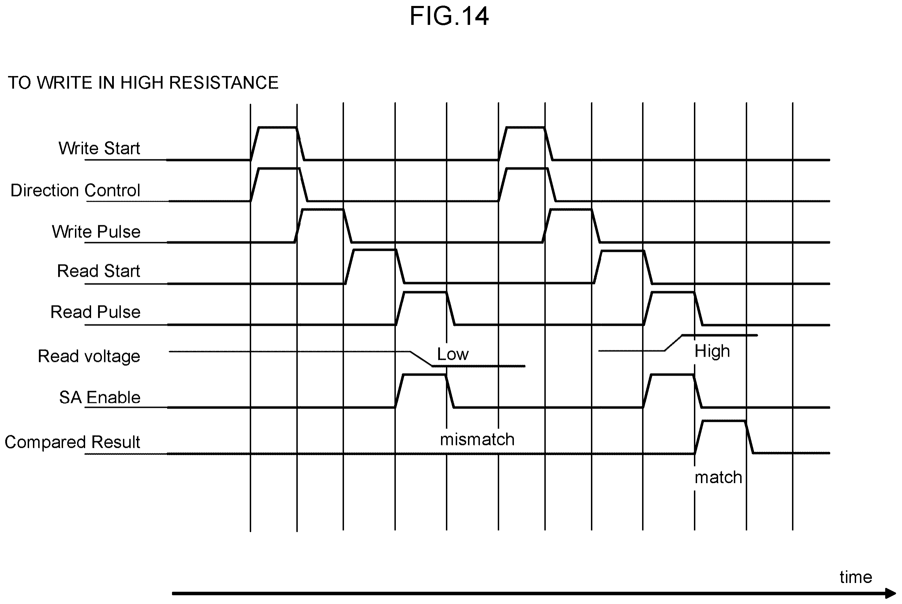

Next, a first modification of the present embodiment will be described with reference to FIGS. 12 to 14. FIG. 12 is a write flowchart of the memory device 500 according to the first modification, and FIGS. 13 and 14 are timing charts of write voltage control in the memory device 500 according to the first modification. In the first modification, unlike the present embodiment described above, a verify-read is performed to confirm whether the write operation is normally performed. Therefore, in the first modification, the write pulse is not issued once, but the verify-read is performed after applying the pulse, and the pulse is applied again when the pulse does not match an expectation.

FIG. 12 illustrates the flowchart of the first modification. Since Steps S201 to S204 in FIG. 12 are similar to Steps S101 to S104 of the present embodiment illustrated in FIG. 10, the description thereof is omitted here. Next, the memory device 500 performs the verify-read after applying the pulse (Step S205), and determines whether a read result matches the expectation (Step S206). The memory device 500 ends the flow when matched with the expectation (Step S206: Yes), and returns to Step S204 when mismatched with the expectation (Step S206: No).

FIG. 13 illustrates a write control timing chart in the low resistance state, and FIG. 14 illustrates a write control timing chart in the high resistance state of the memory device 500. In the first modification, when the flow in FIG. 12 is executed, the write circuit 512 issues the control signal, and each control circuit generates a voltage as illustrated in FIGS. 13 and 14, similarly to the present embodiment. Further, when writing starts, the write circuit 512 issues a write start signal Write Start and a write direction control signal Direction Control. Specifically, the write circuit 512 sets the write direction control signal Direction Control to Low when writing in the low resistance state and maintaining the low resistance state. On the other hand, when writing in the high resistance state and maintaining the high resistance state, the write circuit 512 sets the write direction control signal Direction Control to High. Then, the write circuit 512 issues a write pulse after issuing the control signal. Further, the memory device 500 executes reading after applying the write pulse. The read circuit 510 issues a read start signal Read Start and performs read pulse issue control. In the read pulse, either the bit line or the source line may be set to the high potential, but in the example illustrated in the drawing, the bit line is set to the high potential. Next, since the voltage of the source line changes according to the state of the magnetoresistive element 3, the sense amplifier 506 is enabled (SA Enable) to confirm matching with the expectation. If mismatched, the memory device 500 repeats the write control and the read control.

### <2.7 Second modification>

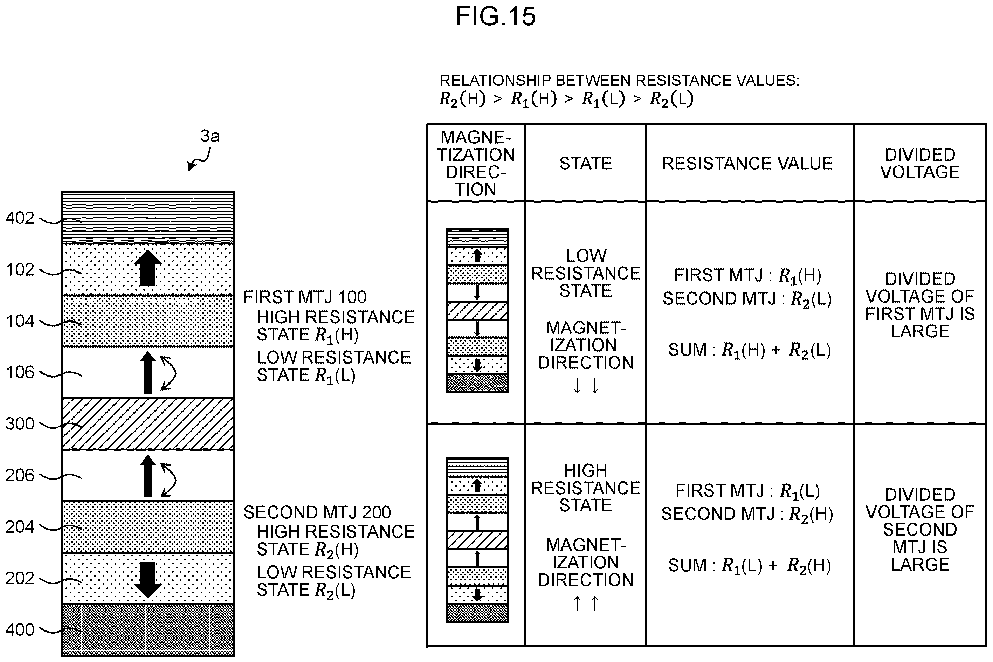

Hereinafter, a second modification of the present embodiment will be described with reference to FIG. 15. FIG. 15 is an explanatory diagram illustrating a configuration example and an operation principle of a magnetoresistive element 3a according to the second modification. In the present embodiment described above, the magnetization direction of the magnetization fixed layer 102 of the MTJ element 100 is downward, and the magnetization direction of the magnetization fixed layer 202 of the MTJ element 200 is directed upward. On the other hand, in the second modification, the magnetization direction of the magnetization fixed layer 102 of the MTJ element 100 is directed upward, and the magnetization direction of the magnetization fixed layer 202 of the MTJ element 200 is directed downward. Even with this configuration, operation similar to the present embodiment can be performed. In the following, description of points common to the first embodiment will be omitted, and points different from the first embodiment will be described.

First, FIG. 15 illustrates a relationship between the resistance state of the MTJ elements 100 and 200 and the magnetization direction. Also in the second modification, the resistance value R₁ (H) in the high resistance state and the resistance value R₁ (L) in the low resistance state of the MTJ element 100, and the resistance value R₂ (H) in the high resistance state and the resistance value R₂ (L) in the low resistance state of the MTJ element 200 have, for example, a magnitude relationship of R₂(H)>R₁(H)>R₁(L)>R₂(L). Note that, also in the second modification, the resistance values of the respective MTJ elements 100 and 200 in the low resistance state may be substantially equal, or may have a magnitude relationship of R₁(L)<R₂(L).

In the case as described above, when the magnetization directions of the storage layers 106 and 206 are both downward (↓↓), the MTJ element 100 is in the high resistance state, and the MTJ element 200 is in the low resistance state. In addition, when the magnetization directions of the storage layers 106 and 206 are both upward (↑↑), the MTJ element 100 is in the low resistance state, and the MTJ element 200 is in the high resistance state. In addition, with respect to the entire resistance value of the magnetoresistive element 3a, the magnetoresistive element 3a becomes the low resistance state when the magnetization directions of the storage layers 106 and 206 are both downward (↓↓), and the magnetoresistive element 3a becomes the high resistance state when the magnetization directions of the storage layers 106 and 206 are both upward (↑↑).

Furthermore, in the case as described above, when the magnetization directions of the storage layers 106 and 206 are both downward (↓↓), the resistance value of the MTJ element 100 is higher than that of the MTJ element 200. Thus, the divided voltage of the MTJ element 100 increases when the voltage is applied to the magnetoresistive element 3a. On the other hand, when the magnetization directions of the storage layers 106 and 206 are both upward (↑↑), the resistance value of the MTJ element 200 is higher than that of the MTJ element 100. Thus, the divided voltage of the MTJ element 200 increases when the voltage is applied to the magnetoresistive element 3a. Therefore, the second modification can be operated similarly to the present embodiment. Note that, also in the second modification, the magnitude relationship of the resistance values of the MTJ elements 100 and 200 may be opposite from the above. In that case, the write voltage directions also become opposite.

As described above, the configuration of the second modification can be operated similarly to the present embodiment. Note that the above-described first modification is also applicable to the second modification.

### <<3. Second embodiment>>

### <3.1 Configuration example of magnetoresistive element>

Next, a second embodiment of the present disclosure will be described with reference to FIG. 16. FIG. 16 is a schematic diagram illustrating a configuration example of a magnetoresistive element 3b according to the present embodiment. In the following, description of points common to the first embodiment will be omitted, and points different from the first embodiment will be described.

In the first embodiment described above, the magnetic coupling layer 300 exhibiting ferromagnetic coupling is provided between the two MTJ elements 100 and 200, but in the present embodiment, as illustrated in FIG. 16, an antiferromagnetic coupling layer 302 is provided. Specifically, the antiferromagnetic coupling layer 302 is provided so as to be sandwiched between the storage layer 106 of the MTJ element (one MTJ element) 100 and the storage layer 206 of the MTJ element (the other MTJ element) 200. In the present embodiment, antiferromagnetic coupling of the antiferromagnetic coupling layer 302 stabilizes the magnetization directions of the two storage layers 106 and 206 when the magnetization directions are oriented in opposite directions. Note that, in the present embodiment, the magnetization direction of the magnetization fixed layer 102 of the MTJ element 100 is downward, and the magnetization direction of the magnetization fixed layer 202 of the MTJ element 200 is downward.

### <3.2 Operation principle>

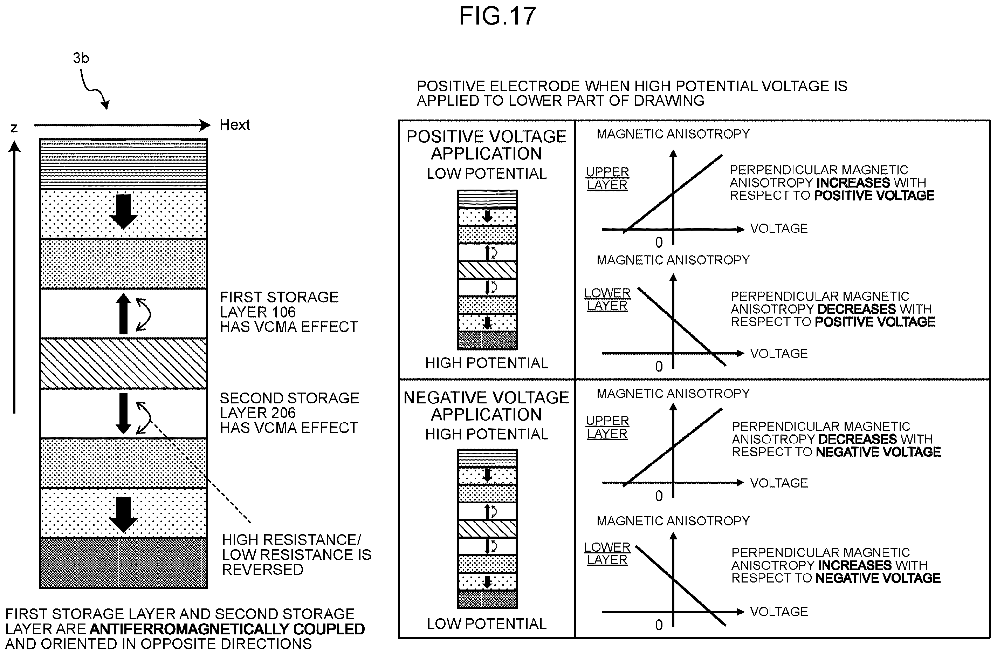

Next, an operation principle of the magnetoresistive element 3b according to the present embodiment will be described with reference to FIGS. 17 to 19. FIGS. 17 to 19 are explanatory diagrams illustrating the operation principle of the magnetoresistive element 3b according to the present embodiment.

As illustrated in FIG. 17, also in the magnetoresistive element 3b according to the present embodiment, when the positive voltage is applied, due to the VCMA effect, the perpendicular magnetic anisotropy of the storage layer 106 of the MTJ element 100 increases, and perpendicular magnetic anisotropy of the storage layer 206 of the MTJ element 200 decreases. Furthermore, also in the magnetoresistive element 3b according to the present embodiment, when the negative voltage is applied, due to the VCMA effect, the perpendicular magnetic anisotropy of the storage layer 106 of the MTJ element 100 decreases and the perpendicular magnetic anisotropy of the storage layer 206 of the MTJ element 200 increases.

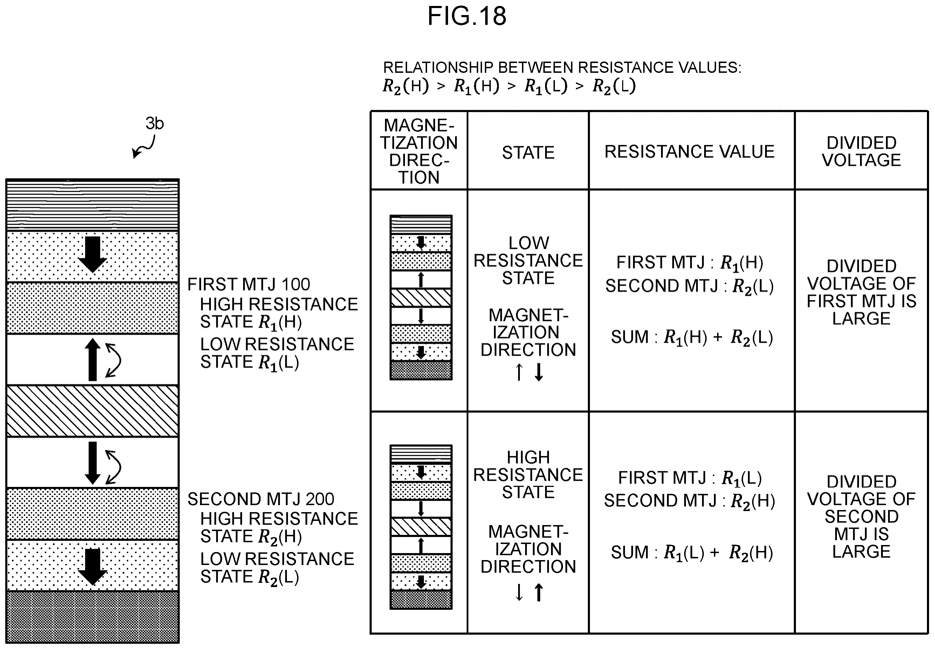

Next, FIG. 18 illustrates a relationship between the resistance state and the magnetization direction of the MTJ elements 100 and 200. Also in the present embodiment, the MTJ elements 100 and 200 have different resistance values. Specifically, in the present embodiment, a resistance value R₁ (H) in the high resistance state and a resistance value R₁ (L) in the low resistance state of the MTJ element 100, and a resistance value R₂ (H) in the high resistance state and a resistance value R₂ (L) in the low resistance state of the MTJ element 200 have, for example, a magnitude relationship of R₂(H)>R₁(H)>R₁(L)>R₂(L). Note that, in the present embodiment, the resistance values of the respective MTJ elements 100 and 200 in the low resistance state may be substantially equal, or may have the magnitude relationship of R₁(L)<R₂(L).

In the case as described above, when the magnetization directions of the storage layers 106 and 206 are different in directions (↑↓), the MTJ element 100 is in the high resistance state and the MTJ element 200 is in the low resistance state. In addition, in a direction in which the magnetization directions of the storage layers 106 and 206 are different in directions (↓↑), the MTJ element 100 is in the low resistance state, and the MTJ element 200 is in the high resistance state. In addition, with respect to the entire resistance value of the magnetoresistive element 3b, the magnetoresistive element 3b becomes the low resistance state when the magnetization directions of the storage layers 106 and 206 are different in directions (↑↓), and the magnetoresistive element 3b becomes the high resistance state when the magnetization directions of the storage layers 106 and 206 are different in directions (↓↑). Note that, in the present embodiment, there is only a case where the magnetization directions of the two storage layers 106 and 206 face opposite directions due to the antiferromagnetic coupling.

In addition, when the magnetization directions of the storage layers 106 and 206 are different in directions (↑↓), the resistance value of the MTJ element 100 is high. Thus, the divided voltage of the MTJ element 100 increases when the voltage is applied to the magnetoresistive element 3b. On the other hand, the magnetization directions of the storage layers 106 and 206 of the MTJ elements 100 and 200 are different in directions (↓↑), the resistance value of the MTJ element 200 is high. Thus, the divided voltage of the MTJ element 200 increases when the voltage is applied to the magnetoresistive element 3b. Note that, in the present embodiment, the magnitude relationship of the resistance values of the MTJ elements 100 and 200 may be opposite from the above. In that case, the write voltage directions also become opposite.

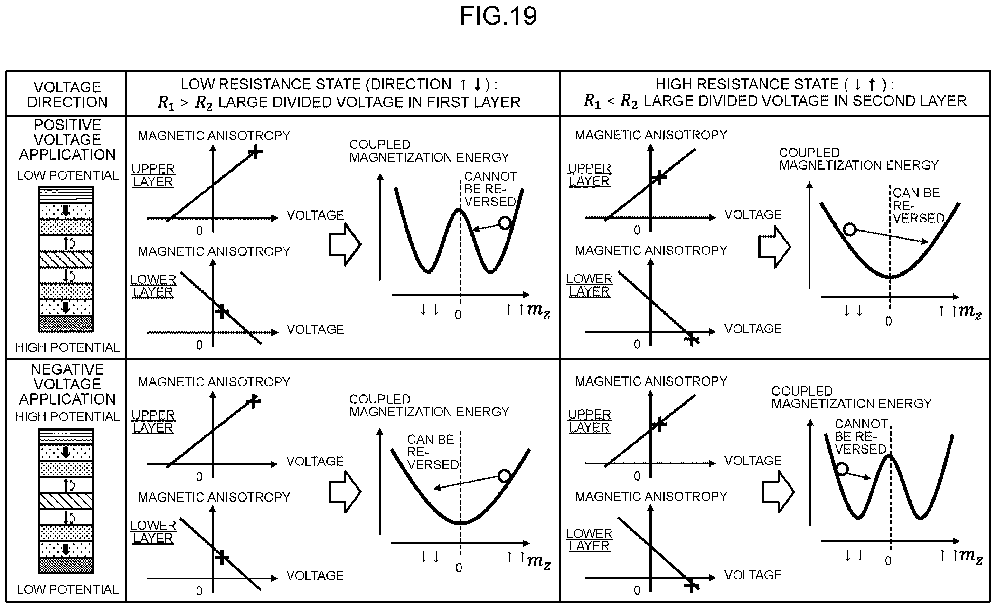

Next, FIG. 19 illustrates a schematic diagram of the magnetic anisotropy of the storage layers 106 and 206 of the MTJ elements 100 and 200 at the time of voltage application and the magnetization energy obtained by coupling the two storage layers 106 and 206. In the present embodiment, although the magnetization directions illustrated in the drawings are different from that of FIG. 6 of the first embodiment, the operation principle is similar to that of the first embodiment, and thus the description thereof is omitted here.

### <3.3 First modification>

The first modification of the first embodiment is also applicable to the second embodiment.

### <3.4 Second modification>

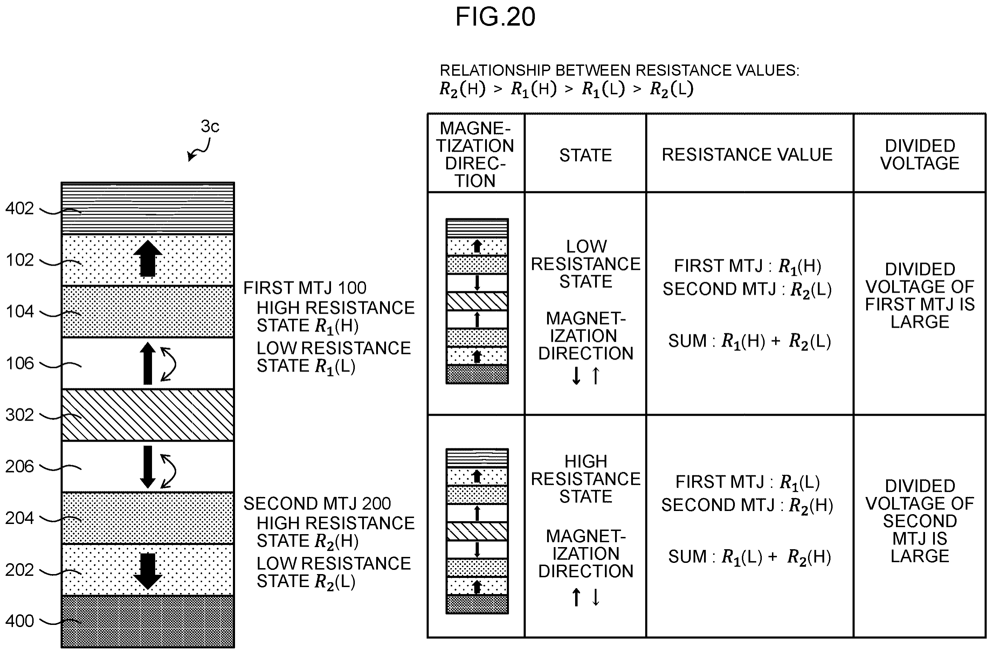

Next, a second modification of the present embodiment will be described with reference to FIG. 20. FIG. 20 is an explanatory diagram illustrating a configuration example and an operation principle of a magnetoresistive element 3c according to the second modification. In the present embodiment described above, the magnetization direction of the magnetization fixed layer 102 of the MTJ element 100 is directed downward, and the magnetization direction of the magnetization fixed layer 202 of the MTJ element 200 is directed downward. On the other hand, in the second modification, the magnetization direction of the magnetization fixed layer 102 of the MTJ element 100 is upward, and the magnetization direction of the magnetization fixed layer 202 of the MTJ element 200 is upward. Even with this configuration, operation similar to the present embodiment can be performed. Note that the above-described first modification is also applicable to the second modification.

Next, FIG. 20 illustrates a relationship between the resistance state and the magnetization direction of the MTJ elements 100 and 200. Also in the second modification, the resistance value R₁ (H) in the high resistance state and the resistance value R₁ (L) in the low resistance state of the MTJ element 100, and the resistance value R₂ (H) in the high resistance state and the resistance value R₂ (L) in the low resistance state of the MTJ element 200 have, for example, a magnitude relationship of R₂(H)>R₁(H)>R₁(L)>R₂(L). Note that, also in the second modification, the resistance values of the respective MTJ elements 100 and 200 in the low resistance state may be substantially equal or have a magnitude relationship of R₁(L)<R₂(L).

In the case as described above, when the magnetization directions of the storage layers 106 and 206 are different in directions (↓↑), the MTJ element 100 is in the high resistance state, and the MTJ element 200 is in the low resistance state. In addition, when the magnetization directions of the storage layers 106 and 206 are different in directions (↑↓), the MTJ element 100 is in the low resistance state, and the MTJ element 200 is in the high resistance state. Further, with respect to the entire resistance value of the magnetoresistive element 3c, when the magnetization directions of the storage layers 106 and 206 are different in directions (↓↑), the magnetoresistive element 3c becomes the low resistance state, and when the magnetization directions of the storage layers 106 and 206 are different in directions (↑↓), the magnetoresistive element 3c becomes the high resistance state. Note that, also in the second modification, there is only a case where the magnetization directions of the two storage layers 106 and 206 face opposite directions due to the antiferromagnetic coupling.

Furthermore, in the case as described above, when the magnetization directions of the storage layers 106 and 206 are different in directions (↓↑), the resistance value of the MTJ element 100 is high. Thus, the divided voltage of the MTJ element 100 increases when the voltage is applied to the magnetoresistive element 3c. On the other hand, when the magnetization directions of the storage layers 106 and 206 are different in directions (↑↓), the resistance value of the MTJ element 200 is high. Thus, the divided voltage of the MTJ element 200 increases when the voltage is applied to the magnetoresistive element 3c. Note that, also in the second modification, the magnitude relationship of the resistance values of the MTJ elements 100 and 200 may be opposite from the above. In that case, the write voltage directions also become opposite.

### <<4. Third embodiment>>

### <4.1 Configuration example of magnetoresistive element>

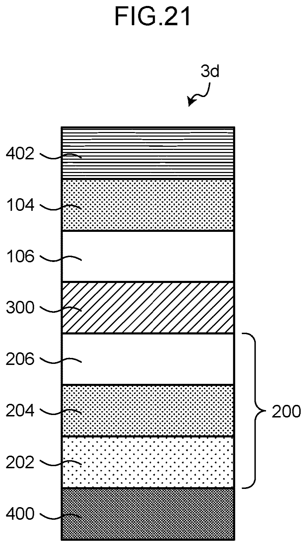

Next, a third embodiment of the present disclosure will be described with reference to FIG. 21. FIG. 21 is a schematic diagram illustrating a configuration example of a magnetoresistive element 3d according to the present embodiment. In the following, description of points common to the first and second embodiments will be omitted, and points different from the first and second embodiments will be described.

In the first embodiment described above, the magnetoresistive element 3 includes the two MTJ elements 100 and 200. In the present embodiment, as illustrated in FIG. 21, the magnetization fixed layer 102 is removed from the MTJ element 100 in the upper part. Specifically, the magnetoresistive element 3d includes the MTJ element 200 and the magnetic coupling layer 300 in contact with the storage layer 206 of the MTJ element 200. Furthermore, the magnetoresistive element 3d includes a resistive element including a storage layer (another storage layer) 106 in contact with the magnetic coupling layer 300 and a tunnel barrier layer (another tunnel barrier layer) 104 in contact with the storage layer 106. In the present embodiment, the ferromagnetic coupling of the magnetic coupling layer 300 stabilizes the magnetization directions of the two storage layers 106 and 206 when the magnetization directions are oriented in the same direction. Note that, in the present embodiment, the magnetization direction of the magnetization fixed layer 202 of the MTJ element 200 is upward.

### <4.2 Operation principle>

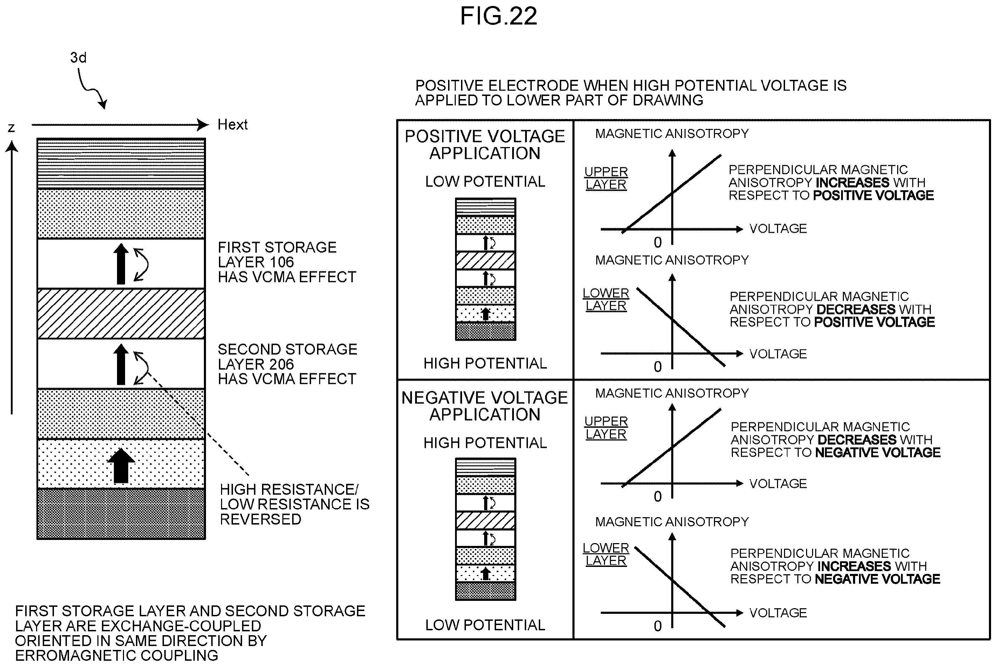

Next, an operation principle of the magnetoresistive element 3d according to the present embodiment will be described with reference to FIGS. 22 to 24. FIGS. 22 to 24 are explanatory diagrams illustrating the operation principle of the magnetoresistive element 3d according to the present embodiment.

As illustrated in FIG. 22, in the magnetoresistive element 3d according to the present embodiment, when the positive voltage is applied, the perpendicular magnetic anisotropy of the storage layer 106 increases, and the perpendicular magnetic anisotropy of the storage layer 206 of the MTJ element 200 decreases. Furthermore, in the magnetoresistive element 3b according to the present embodiment, when the negative voltage is applied, the perpendicular magnetic anisotropy of the storage layer 106 decreases, and the perpendicular magnetic anisotropy of the storage layer 206 of the MTJ element 200 increases.

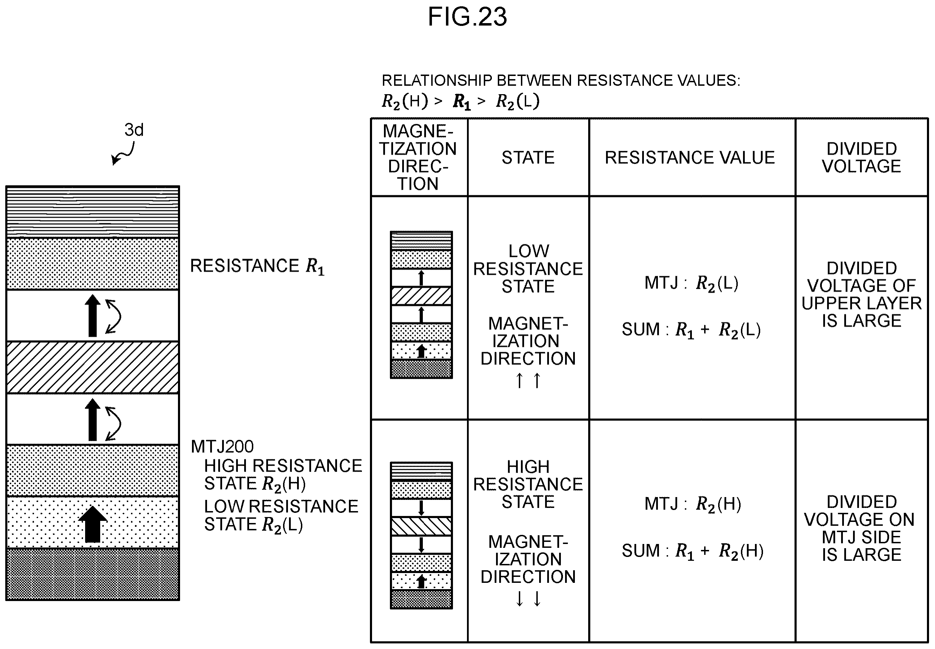

Next, FIG. 23 illustrates a relationship between the resistance state and the magnetization direction. Specifically, in the present embodiment, the resistance value R₁ of the upper layer, and the resistance value R₂ (H) in the high resistance state and the resistance value R₂ (L) in the low resistance state of the MTJ element 200 in the lower layer have, for example, a magnitude relationship of R₂(H)>R₁>R₂(L) .

In the case as described above, when the magnetization directions of the storage layers 106 and 206 are both upward (↑↑), the MTJ element 200 is in the low resistance state. In addition, when the magnetization directions of the storage layers 106 and 206 are both downward (↓↓), the MTJ element 200 is in the high resistance state. Further, with respect to the entire resistance value of the magnetoresistive element 3d, when the magnetization directions of the storage layers 106 and 206 are both upward (↑↑), the magnetoresistive element 3d becomes the low resistance state, and when the magnetization directions of the storage layers 106 and 206 are both downward (↓↓), the magnetoresistive element 3d becomes the high resistance state. Note that, in the present embodiment, there is only a case where the magnetization directions of the two storage layers 106 and 206 face the same direction due to the ferromagnetic coupling.

Furthermore, in the case as described above, when the magnetization directions of the storage layers 106 and 206 are both upward (↑↑), the resistance value of the upper layer is higher than that of the MTJ element 200. Thus, the divided voltage of the upper layer increases when the voltage is applied to the magnetoresistive element 3d. On the other hand, when the magnetization directions of the storage layers 106 and 206 are both downward (↓↓), the resistance value of the MTJ element 200 is higher than that of the upper layer. Thus, the divided voltage of the MTJ element 200 increases when the voltage is applied to the magnetoresistive element 3d. In the present embodiment, the magnitude relationship of the resistance values may be opposite from the above. In that case, the write voltage directions also become opposite.

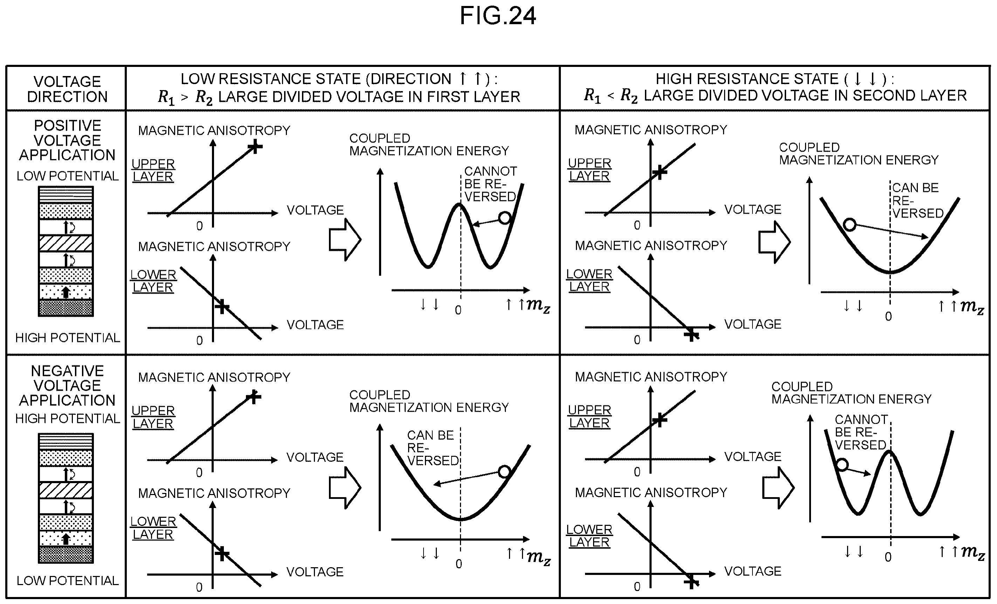

Next, FIG. 24 illustrates a schematic diagram of magnetic anisotropy of the storage layers 106 and 206 and magnetization energy obtained by coupling the two storage layers 106 and 206. In the present embodiment, since the operation principle is similar to that of the first embodiment, the description thereof is omitted here.

### <4.3 First modification>

Also in the third embodiment, the first modification of the first embodiment is applicable.

### <4.4 Second modification>

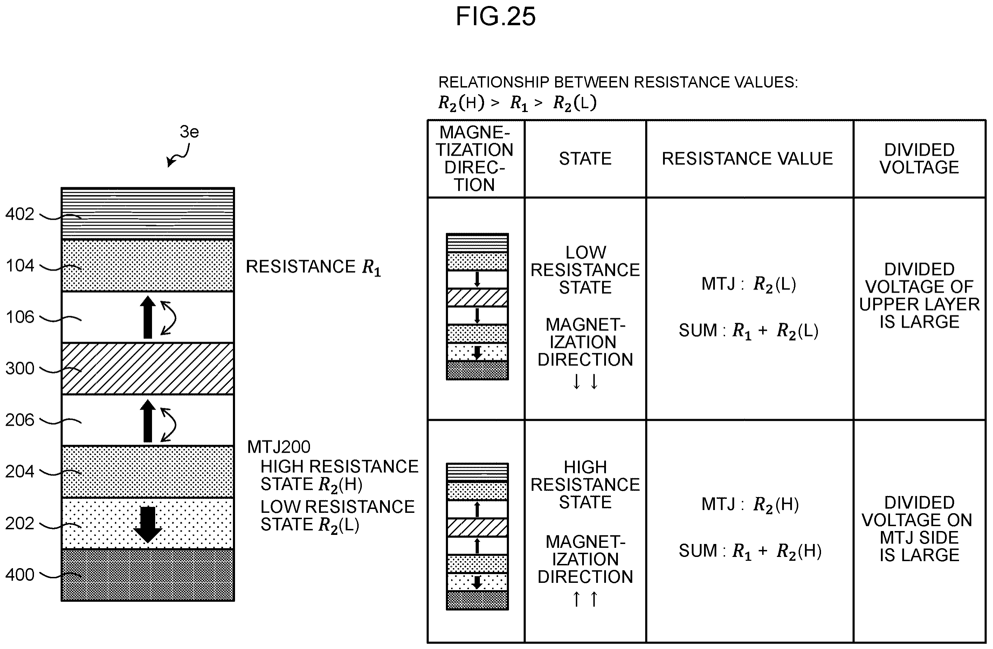

Hereinafter, the second modification of the present embodiment will be described with reference to FIG. 25. FIG. 25 is an explanatory diagram illustrating a configuration example and an operation principle of a magnetoresistive element 3e according to the second modification. In the present embodiment described above, the magnetization direction of the magnetization fixed layer 202 of the MTJ element 200 is directed upward. On the other hand, in the second modification, the magnetization direction of the magnetization fixed layer 202 of the MTJ element 200 is directed downward. Even with this configuration, operation similar to the present embodiment can be performed. Note that the above-described first modification is also applicable to the second modification.

Next, FIG. 25 illustrates a relationship between the resistance state and the magnetization direction. Specifically, in the second modification, the resistance value R₁ of the upper layer, and the resistance value R₂ (H) in the high resistance state and the resistance value R₂ (L) in the low resistance state of the MTJ element 200 have, for example, a magnitude relationship of R₂(H)>R₁>R₂(L).

In the case as described above, when the magnetization directions of the storage layers 106 and 206 are both downward (↓↓), the MTJ element 200 is in the low resistance state. In addition, when the magnetization directions of the storage layers 106 and 206 are both upward (↑↑), the MTJ element 200 is in the high resistance state. In addition, with respect to the entire resistance value of the magnetoresistive element 3e, when the magnetization directions of the storage layers 106 and 206 are both downward (↓↓), the magnetoresistive element becomes the low resistance state, and when the magnetization directions of the storage layers 106 and 206 are both upward (↑↑), the magnetoresistive element becomes the high resistance state. Note that, also in the second modification, there is only a case where the magnetization directions of the two storage layers 106 and 206 face the same direction due to the ferromagnetic coupling.

In addition, in the case as described above, when the magnetization directions of the storage layers 106 and 206 are both downward (↓↓), the resistance value of the upper layer is higher than that of the MTJ element 200. Thus, the divided voltage of the upper layer increases when the voltage is applied to the magnetoresistive element 3e. On the other hand, when the magnetization directions of the storage layers 106 and 206 are both upward (↑↑), the resistance value of the MTJ element 200 is higher than that of the upper layer. Thus, the divided voltage of the MTJ element 200 increases when the voltage is applied to the magnetoresistive element 3e. In the present modification, the magnitude relationship of the resistance values may be opposite from the above. In that case, the write voltage directions also become opposite.

### <4.5 Third modification>

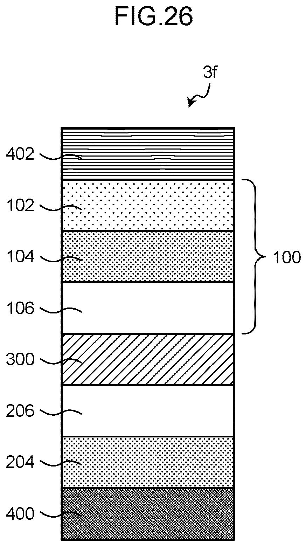

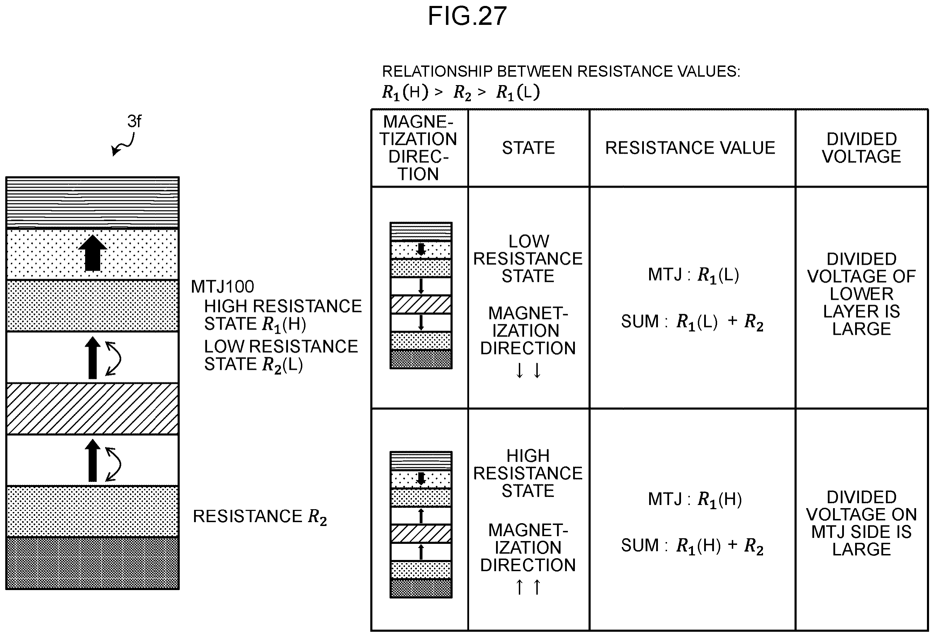

Next, a third modification of the present embodiment will be described with reference to FIGS. 26 and 27. FIG. 26 is a schematic diagram illustrating a configuration example of a magnetoresistive element 3f according to the third modification, and FIG. 26 is an explanatory diagram illustrating a configuration example and an operation principle of the magnetoresistive element 3f according to the third modification. In the present embodiment described above, the magnetoresistive element 3d has a configuration in which the magnetization fixed layer 102 is removed from the MTJ element 100 in the upper layer. In the third modification, as illustrated in FIG. 26, the magnetization fixed layer 202 is removed from the MTJ element 200 in the lower layer. Furthermore, in the third modification, the magnetization direction of the magnetization fixed layer 102 of the MTJ element 100 is directed downward. Even with this configuration, operation similar to the present embodiment can be performed. Note that the above-described first modification is also applicable to the third modification.

Next, FIG. 27 illustrates a relationship between the resistance state and the magnetization direction. Specifically, in the third modification, the resistance value R₁ (H) in the high resistance state and the resistance value R₁ (L) in the low resistance state of the MTJ element 100, and the resistance value R₂ of the lower layer have, for example, a magnitude relationship of R₁(H)>R₂>R₁(L) .

In the case as described above, when the magnetization directions of the storage layers 106 and 206 are both downward (↓↓), the MTJ element 100 is in the low resistance state. In addition, when the magnetization directions of the storage layers 106 and 206 are both upward (↑↑), the MTJ element 100 is in the high resistance state. Further, with respect to the entire resistance value of the magnetoresistive element 3f, when the magnetization directions of the storage layers 106 and 206 are both downward (↓↓), the magnetoresistive element 3f becomes the low resistance state, and when the magnetization directions of the storage layers 106 and 206 are both upward (↑↑), the magnetoresistive element 3f becomes the high resistance state.

In addition, in the case as described above, when the magnetization directions of the storage layers 106 and 206 are both downward (↓↓), the resistance value of the lower layer is higher than that of the MTJ element 100. Thus, the divided voltage of the lower layer increases when the voltage is applied to the magnetoresistive element 3f. On the other hand, when the magnetization directions of the storage layers 106 and 206 are both upward (↑↑), the resistance value of the MTJ element 100 is higher than that of the lower layer. Thus, the divided voltage of the MTJ element 100 increases when the voltage is applied to the magnetoresistive element 3f. In the present modification, the magnitude relationship of the resistance values may be opposite from the above. In that case, the write voltage directions also become opposite.

### <4.6 Fourth modification>

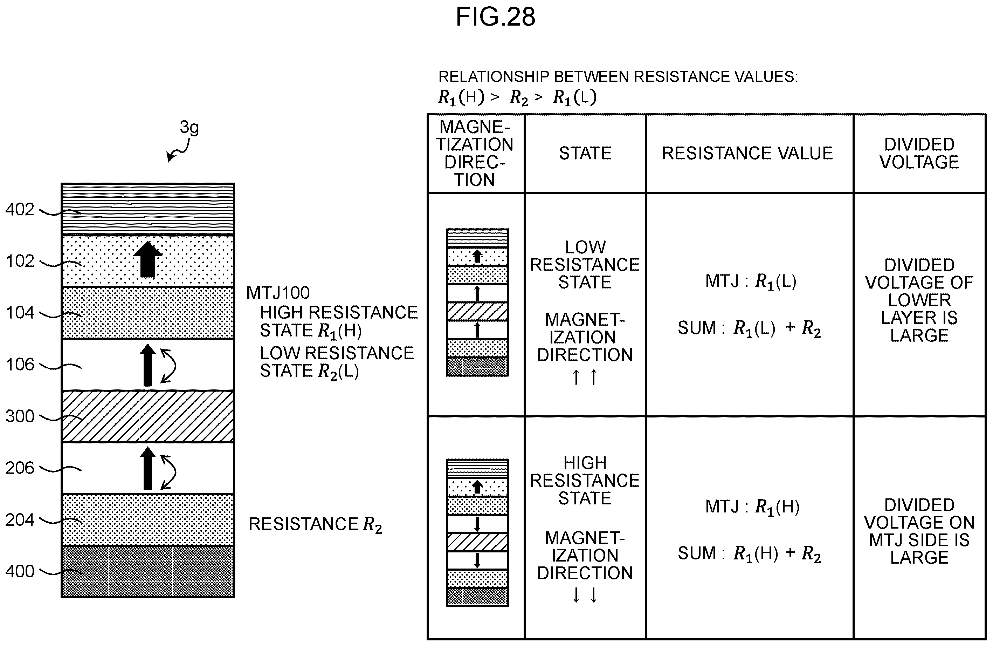

Next, a fourth modification of the present embodiment will be described with reference to FIG. 28. FIG. 28 is an explanatory diagram illustrating a configuration example and an operation principle of a magnetoresistive element 3g according to the fourth modification. In the above-described third modification, the magnetization direction of the magnetization fixed layer 102 of the MTJ element 100 is directed downward. On the other hand, in the fourth modification, the magnetization direction of the magnetization fixed layer 102 of the MTJ element 100 is directed upward. Even with this configuration, operation similar to the present embodiment can be performed. Note that the above-described first modification is also applicable to the fourth modification.

Next, FIG. 28 illustrates a relationship between the resistance state and the magnetization direction. Specifically, in the present fourth modification, the resistance value R₁ (H) in the high resistance state and the resistance value R₁ (L) in the low resistance state of the MTJ element 100, and the resistance value R₂ of the lower layer have, for example, a magnitude relationship of R₁(H)>R₂>R₁(L) .

In the case as described above, when the magnetization directions of the storage layers 106 and 206 are both upward (↑↑), the MTJ element 100 is in the low resistance state. In addition, when the magnetization directions of the storage layers 106 and 206 are both downward (↓↓), the MTJ element 100 is in the high resistance state. In addition, with respect to the entire resistance value of the magnetoresistive element 3g, when the magnetization directions of the storage layers 106 and 206 are both upward (↑↑), the magnetoresistive element 3g becomes the low resistance state, and when the magnetization directions of the storage layers 106 and 206 are both downward (↓↓), the magnetoresistive element 3g becomes the high resistance state.

Furthermore, in the case as described above, when the magnetization directions of the storage layers 106 and 206 are both upward (↑↑), the resistance value of the lower layer is higher than that of the MTJ element 100. Thus, the divided voltage of the lower layer increases when the voltage is applied to the magnetoresistive element 3g. On the other hand, when the magnetization directions of the storage layers 106 and 206 are both downward (↓↓), the resistance value of the MTJ element 100 is higher than that of the lower layer. Thus, the divided voltage of the MTJ element 100 increases when the voltage is applied to the magnetoresistive element 3g. In the present modification, the magnitude relationship of the resistance values may be opposite from the above. In that case, the write voltage directions also become opposite.

### <<5. Fourth embodiment>>

### <5.1 Configuration example of magnetoresistive element>

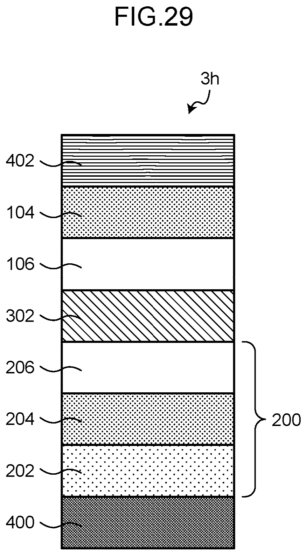

Next, a fourth embodiment of the present disclosure will be described with reference to FIG. 29. FIG. 29 is a schematic diagram illustrating a configuration example of a magnetoresistive element 3h according to the present embodiment. In the following, description of points common to the first to third embodiments will be omitted, and points different from the first to third embodiments will be described.

In the present embodiment, as illustrated in FIG. 29, the antiferromagnetic coupling layer 302 is provided instead of the magnetic coupling layer 300 of the third embodiment described above. In the present embodiment, the antiferromagnetic coupling of the antiferromagnetic coupling layer 302 stabilizes when the magnetization directions of the two storage layers 106 and 206 are oriented in opposite directions. Note that, in the present embodiment, the magnetization direction of the magnetization fixed layer 202 of the MTJ element 200 is upward.

### <5.2 Operation principle>

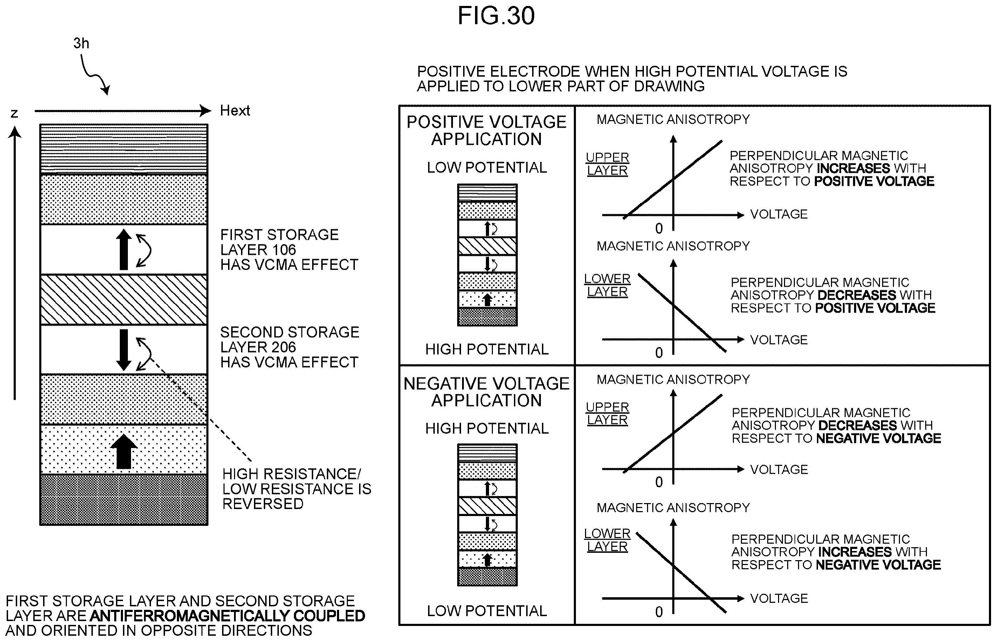

Next, an operation principle of the magnetoresistive element 3h according to the present embodiment will be described with reference to FIGS. 30 to 32. FIGS. 30 to 32 are explanatory diagrams illustrating the operation principle of the magnetoresistive element 3h according to the present embodiment.

As illustrated in FIG. 30, in the magnetoresistive element 3h according to the present embodiment, when the positive voltage is applied, the perpendicular magnetic anisotropy of the storage layer 106 increases, and the perpendicular magnetic anisotropy of the storage layer 206 of the MTJ element 200 decreases. Furthermore, in the magnetoresistive element 3h according to the present embodiment, when the negative voltage is applied, the perpendicular magnetic anisotropy of the storage layer 106 decreases, and the perpendicular magnetic anisotropy of the storage layer 206 of the MTJ element 200 increases.

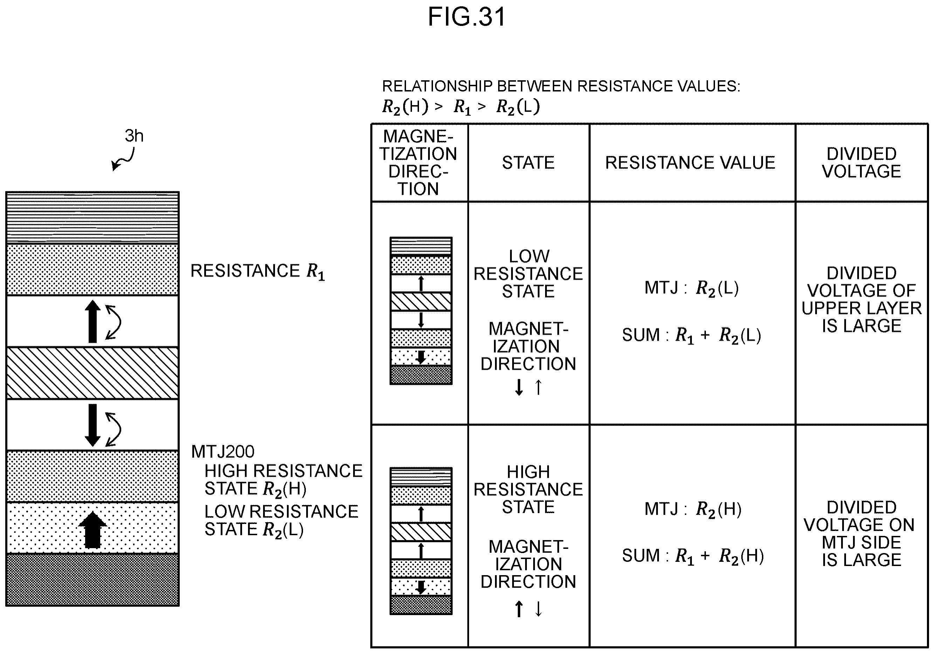

Next, FIG. 31 illustrates a relationship between the resistance state and the magnetization direction. Specifically, in the present embodiment, the resistance value R₁ of the upper layer, and the resistance value R₂ (H) in the high resistance state and the resistance value R₂ (L) in the low resistance state of the MTJ element 200 have, for example, a magnitude relationship of R₂(H)>R₁>R₂(L) .

In the case as described above, when the magnetization directions of the storage layers 106 and 206 are different in directions (↓↑), the MTJ element 200 is in the low resistance state. In addition, when the magnetization directions of the storage layers 106 and 206 are different in directions (↑↓), the MTJ element 200 is in the high resistance state. Further, with respect to the entire resistance value of the magnetoresistive element 3h, when the magnetization directions of the storage layers 106 and 206 are different in directions (↓↑), the magnetoresistive element 3h becomes the low resistance state, and when the magnetization directions of the storage layers 106 and 206 are different in directions (↑↓), the magnetoresistive element 3h becomes the high resistance state. Note that, in the present embodiment, there is only a case where the magnetization directions of the two storage layers 106 and 206 face different directions due to the ferromagnetic coupling.

Furthermore, in the case as described above, when the magnetization directions of the storage layers 106 and 206 are different in directions (↓↑), the resistance value of the upper layer is higher than that of the MTJ element 200. Thus, the divided voltage of the upper layer increases when the voltage is applied to the magnetoresistive element 3h. On the other hand, when the magnetization directions of the storage layers 106 and 206 are different in directions (↑↓), the resistance value of the MTJ element 200 is higher than that of the upper layer. Thus, the divided voltage of the MTJ element 200 increases when the voltage is applied to the magnetoresistive element 3h. In the present embodiment, the magnitude relationship of the resistance values may be opposite from the above. In that case, the write voltage directions also become opposite.

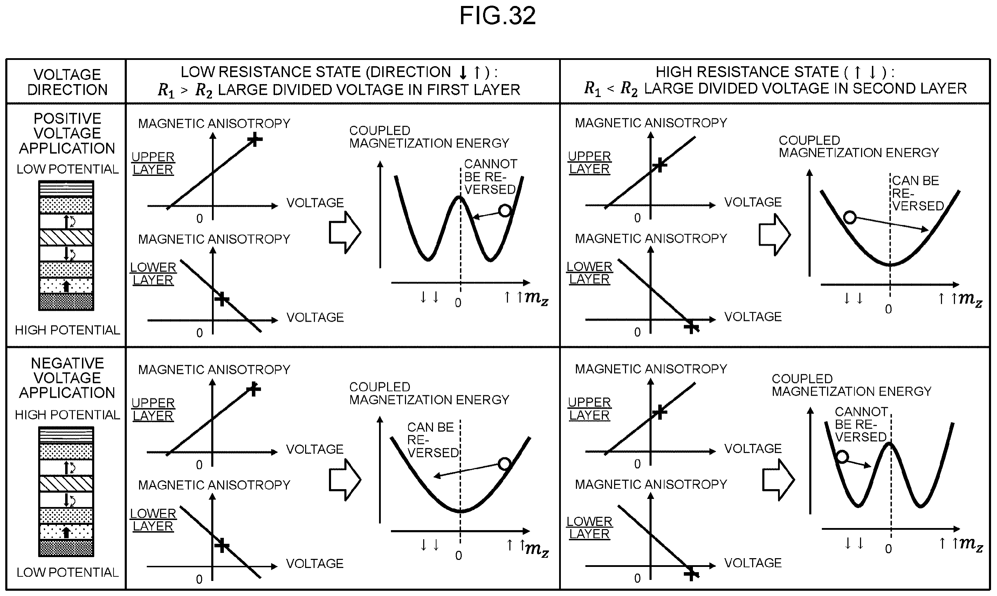

Next, FIG. 32 illustrates a schematic diagram of magnetic anisotropy of the storage layers 106 and 206 and magnetization energy obtained by coupling the two storage layers 106 and 206. In the present embodiment, since the operation principle is similar to that of the first embodiment, the description thereof is omitted here.

### <5.3 First modification>

Also in the fourth embodiment, the first modification of the first embodiment is applicable.

### <5.4 Second modification>

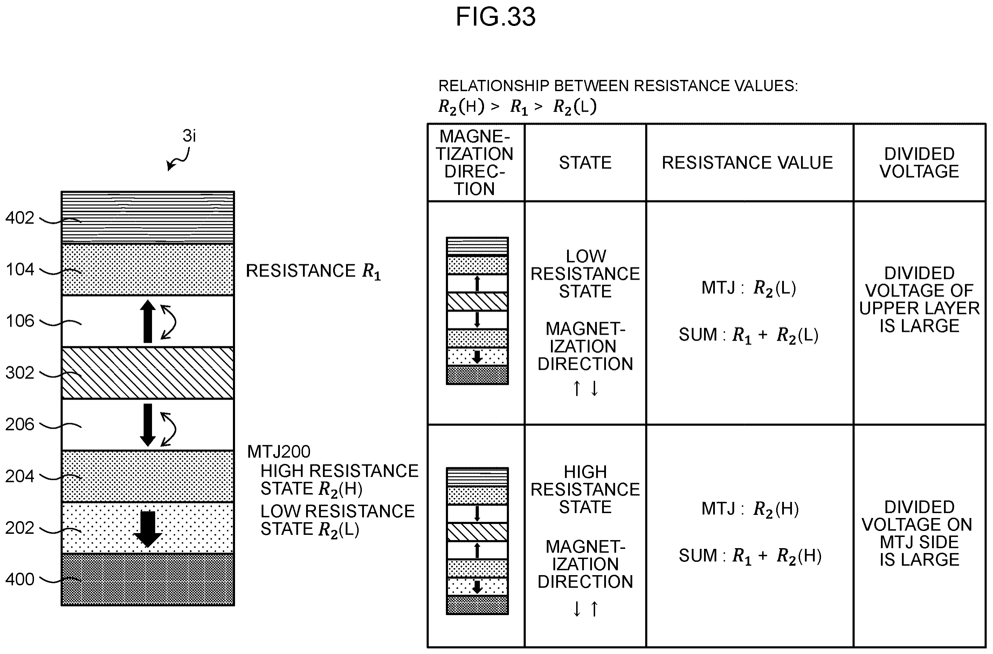

Next, a second modification of the present embodiment will be described with reference to FIG. 33. FIG. 33 is an explanatory diagram illustrating a configuration example and an operation principle of a magnetoresistive element 3i according to the second modification. In the present embodiment described above, the magnetization direction of the magnetization fixed layer 202 of the MTJ element 200 is directed upward. On the other hand, in the second modification, the magnetization direction of the magnetization fixed layer 202 of the MTJ element 200 is directed downward. Even with this configuration, operation similar to the present embodiment can be performed. Note that the above-described first modification is also applicable to the second modification.

Next, FIG. 33 illustrates a relationship between the resistance state and the magnetization direction. Specifically, in the second modification, the resistance value R₁ of the upper layer, and the resistance value R₂ (H) in the high resistance state and the resistance value R₂ (L) in the low resistance state of the MTJ element 200 have, for example, a magnitude relationship of R₂(H)>R₁>R₂(L).

In the case as described above, when the magnetization directions of the storage layers 106 and 206 are different in directions (↑↓), the MTJ element 200 is in the low resistance state. In addition, when the magnetization directions of the storage layers 106 and 206 are different in directions (↓↑), the MTJ element 200 is in the high resistance state. In addition, when the magnetization directions of the storage layers 106 and 206 are different in directions (↑↓), the entire magnetoresistive element 3i becomes the low resistance state. When the magnetization directions of the storage layers 106 and 206 are different in directions (↓↑), the entire magnetoresistive element 3i becomes the high resistance state.

In addition, in the case as described above, when the magnetization directions of the storage layers 106 and 206 are different in directions (↑↓), the resistance value of the upper layer is high. Thus, the divided voltage of the upper layer increases when the voltage is applied to the magnetoresistive element 3i. On the other hand, when the magnetization directions of the storage layers 106 and 206 are different in directions (↓↑), the resistance value of the MTJ element 200 is high. Thus, the divided voltage of the MTJ element 200 increases when the voltage is applied to the magnetoresistive element 3i. In the present modification, the magnitude relationship of the resistance values may be opposite from the above. In that case, the write voltage directions also become opposite.

### <5.5 Third modification>

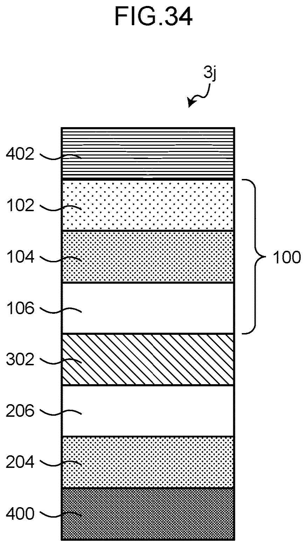

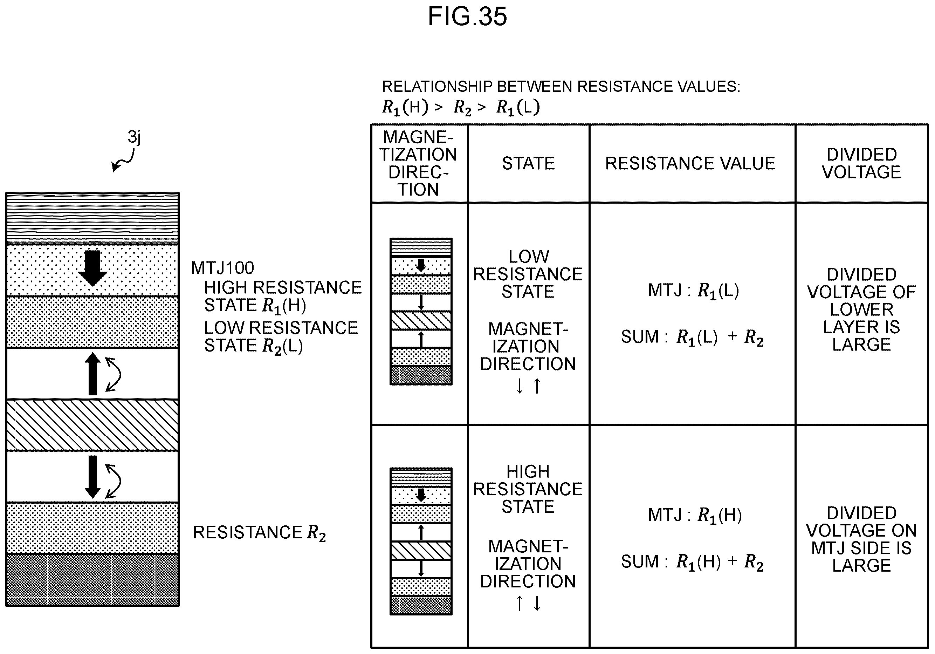

Next, a third modification of the present embodiment will be described with reference to FIGS. 34 and 35. FIG. 34 is a schematic diagram illustrating a configuration example of a magnetoresistive element 3j according to the third modification, and FIG. 35 is an explanatory diagram illustrating a configuration example and an operation principle of the magnetoresistive element 3j according to the third modification. In the present embodiment described above, the magnetoresistive element 3h has a configuration in which the magnetization fixed layer 102 is removed from the MTJ element 100 in the upper part. In the third modification, as illustrated in FIG. 34, the magnetization fixed layer 202 is removed from the MTJ element 200 in the lower part. Note that, in the third modification, the magnetization direction of the magnetization fixed layer 102 of the MTJ element 100 is downward. Even with this configuration, operation similar to the present embodiment can be performed. Note that the above-described first modification is also applicable to the third modification.

Next, FIG. 35 illustrates a relationship between the resistance state and the magnetization direction. Specifically, in the third modification, the resistance value R₁ (H) in the high resistance state and the resistance value R₁ (L) in the low resistance state of the MTJ element 100, and the resistance value R₂ of the lower layer have, for example, a magnitude relationship of R₁(H)>R₂>R₁(L) .

In the case as described above, when the magnetization directions of the storage layers 106 and 206 are different in directions (↓↑), the MTJ element 100 is in the low resistance state. In addition, when the magnetization directions of the storage layers 106 and 206 are different in directions (↑↓), the MTJ element 100 is in the high resistance state. Further, with respect to the entire resistance value of the magnetoresistive element 3j, when the magnetization directions of the storage layers 106 and 206 are different in directions (↓↑), the magnetoresistive element 3j becomes the low resistance state, and when the magnetization directions of the storage layers 106 and 206 are different in directions (↑↓), the magnetoresistive element 3j becomes the high resistance state.

Furthermore, in the case as described above, when the magnetization directions of the storage layers 106 and 206 are different in directions (↓↑), the resistance value of the lower layer is higher than that of the MTJ element 100. Thus, the divided voltage of the lower layer increases when the voltage is applied to the magnetoresistive element 3j. On the other hand, when the magnetization directions of the storage layers 106 and 206 are different in directions (↑↓), the resistance value of the MTJ element 100 is higher than that of the lower layer. Thus, the divided voltage of the MTJ element 100 increases when the voltage is applied to the magnetoresistive element 3j. In the present modification, the magnitude relationship of the resistance values may be opposite from the above. In that case, the write voltage directions also become opposite.

### <5.6 Fourth modification>

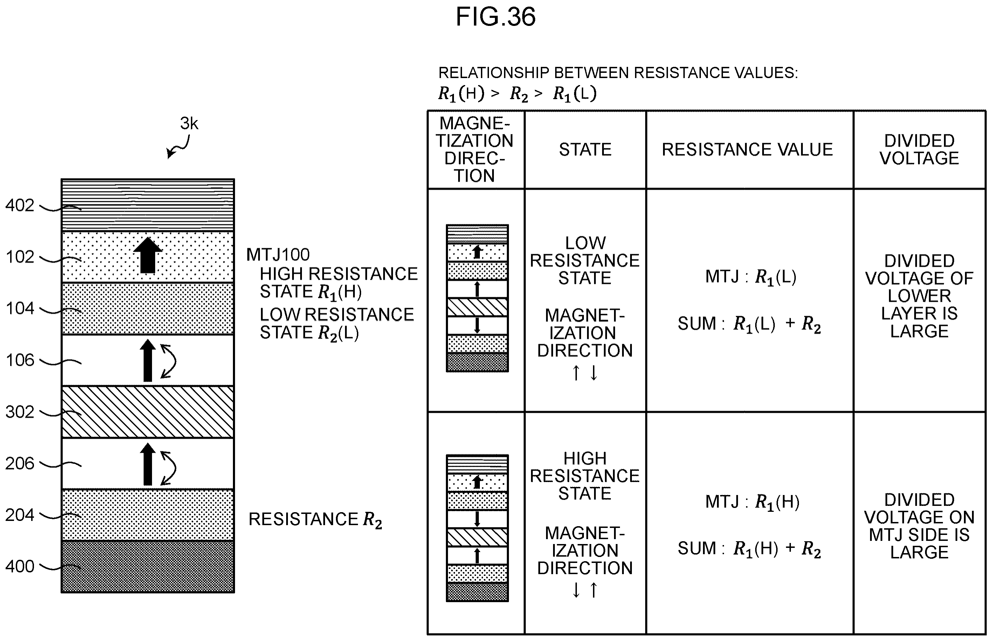

Next, a fourth modification of the present embodiment will be described with reference to FIG. 36. FIG. 36 is an explanatory diagram illustrating a configuration example and an operation principle of a magnetoresistive element 3k according to the fourth modification. In the above-described third modification, the magnetization direction of the magnetization fixed layer 102 of the MTJ element 100 is directed downward. On the other hand, in the fourth modification, the magnetization direction of the magnetization fixed layer 102 of the MTJ element 100 is directed upward. Even with this configuration, operation similar to the present embodiment can be performed. Note that the above-described first modification is also applicable to the fourth modification.

Next, FIG. 36 illustrates a relationship between the resistance state and the magnetization direction. Specifically, in the present fourth modification, the resistance value R₁ (H) in the high resistance state and the resistance value R₁ (L) in the low resistance state of the MTJ element 100, and the resistance value R₂ of the lower layer have, for example, a magnitude relationship of R₁(H)>R₂>R₁(L) .

In the case as described above, when the magnetization directions of the storage layers 106 and 206 are different in directions (↑↓), the MTJ element 100 is in the low resistance state. In addition, when the magnetization directions of the storage layers 106 and 206 are different in directions (↓↑), the MTJ element 100 is in the high resistance state. Further, with respect to the entire resistance value of the magnetoresistive element 3k, when the magnetization directions of the storage layers 106 and 206 are different in directions (↑↓), the magnetoresistive element 3k becomes the low resistance state, and when the magnetization directions of the storage layers 106 and 206 are different in directions (↓↑), the magnetoresistive element 3k becomes the high resistance state.

Furthermore, in the case as described above, when the magnetization directions of the storage layers 106 and 206 are different in directions (↑↓), the resistance value of the lower layer is high. Thus, the divided voltage of the lower layer increases when the voltage is applied to the magnetoresistive element 3k. On the other hand, when the magnetization directions of the storage layers 106 and 206 are different in directions (↓↑), the resistance value of the MTJ element 100 is high. Thus, the divided voltage of the MTJ element 100 increases when the voltage is applied to the magnetoresistive element 3k. In the present modification, the magnitude relationship of the resistance values may be opposite from the above. In that case, the write voltage directions also become opposite.

### <<6. Fifth embodiment>>

### <6.1 Configuration example of magnetoresistive element>

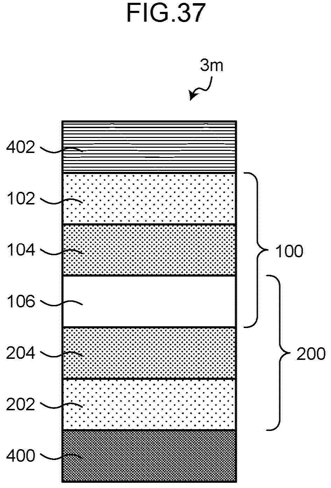

Next, a fifth embodiment of the present disclosure will be described with reference to FIG. 37. FIG. 37 is a schematic diagram illustrating a configuration example of a magnetoresistive element 3m according to the present embodiment. In the following, description of points common to the first to fourth embodiments will be omitted, and points different from the first to fourth embodiments will be described.

In the present embodiment, as illustrated in FIG. 37, the magnetoresistive element 3m includes two MTJ elements 100 and 200, but the magnetic coupling layer 300 and the antiferromagnetic coupling layer 302 are not provided therebetween. Further, in the present embodiment, the two MTJ elements 100 and 200 share one storage layer 106. Note that, in the present embodiment, the magnetization direction of the magnetization fixed layer 102 of the MTJ element 100 is directed downward, and the magnetization direction of the magnetization fixed layer 202 of the MTJ element 200 is directed upward.

### <6.2 Operation principle>

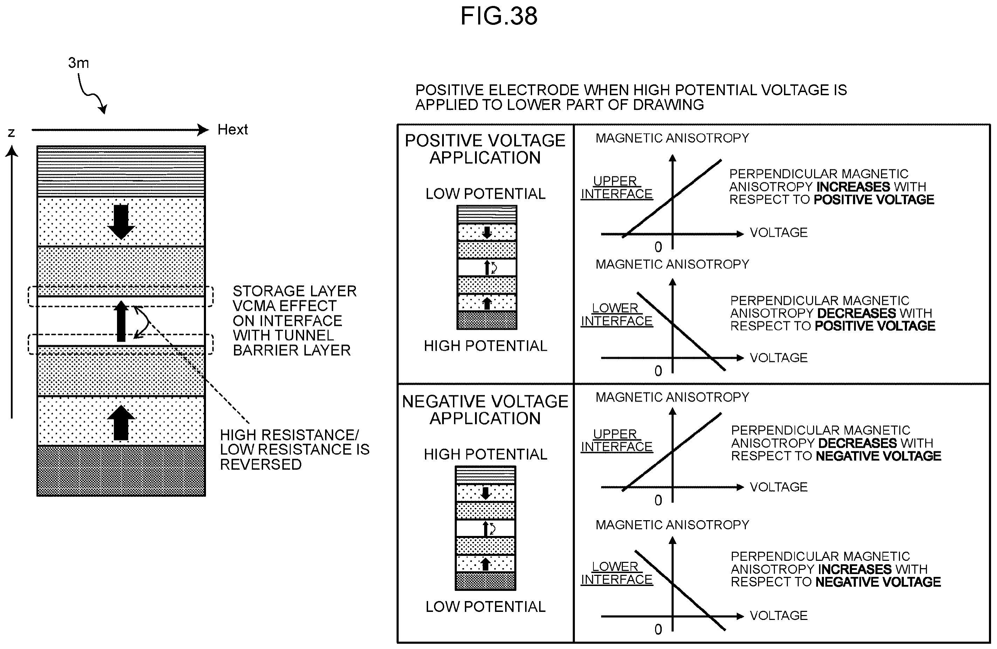

Next, an operation principle of the magnetoresistive element 3m according to the present embodiment will be described with reference to FIGS. 38 to 40. FIGS. 38 to 40 are explanatory diagrams illustrating the operation principle of the magnetoresistive element 3m according to the present embodiment. Note that, in the following drawings, an "upper interface" means an interface between the tunnel barrier layer 104 and the storage layer 106 in the upper layer, and a "lower interface" means an interface between the tunnel barrier layer 204 and the storage layer 106 in the lower layer.

As illustrated in FIG. 38, in the magnetoresistive element 3m according to the present embodiment, when the positive voltage is applied, due to the VCMA effect, the perpendicular magnetic anisotropy is increased at the interface between the tunnel barrier layer 104 and the storage layer 106 in the upper layer, and the perpendicular magnetic anisotropy is decreased at the interface between the tunnel barrier layer 204 and the storage layer 106 in the lower layer. Furthermore, in the magnetoresistive element 3m according to the present embodiment, when the negative voltage is applied, due to the VCMA effect, the vertical magnetic anisotropy is decreased at the interface between the tunnel barrier layer 104 and the storage layer 106 in the upper layer, and the vertical magnetic anisotropy is increased at the interface between the tunnel barrier layer 204 and the storage layer 106 in the lower layer.

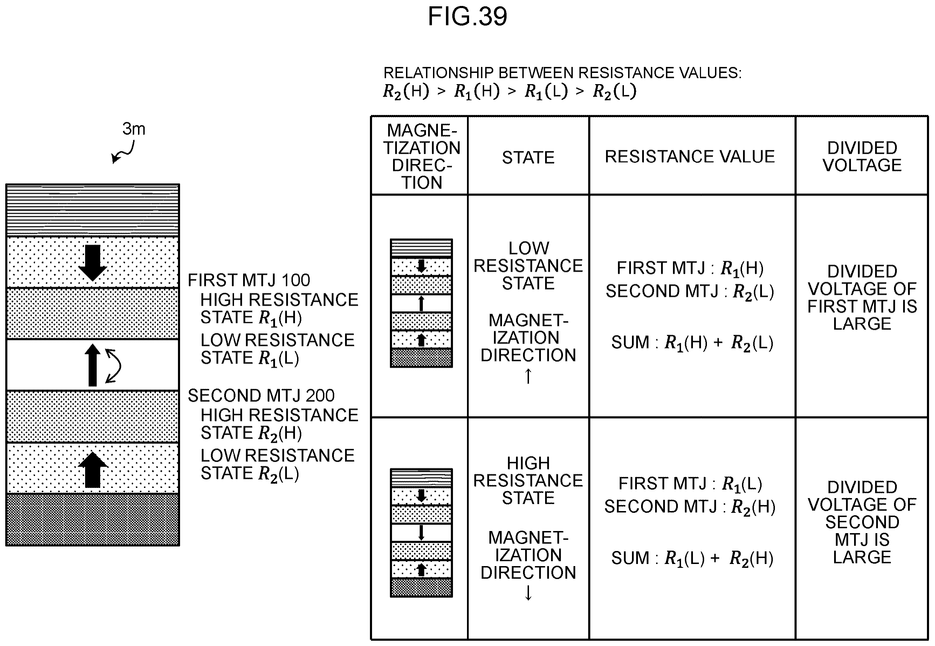

Next, FIG. 39 illustrates a relationship between the resistance state and the magnetization direction of the MTJ elements 100 and 200. In the present embodiment, the MTJ elements 100 and 200 have different resistance values. Specifically, in the present embodiment, a resistance value R₁ (H) in the high resistance state and a resistance value R₁ (L) in the low resistance state of the MTJ element 100, and a resistance value R₂ (H) in the high resistance state and a resistance value R₂ (L) in the low resistance state of the MTJ element 200 have, for example, a magnitude relationship of R₂(H)>R₁(H)>R₁(L)>R₂(L). In the present embodiment, the resistance values of the respective MTJ elements 100 and 200 in the low resistance state may be substantially equal, or may have a magnitude relationship of R₁(L)<R₂(L).

In the case as described above, when the magnetization direction of the storage layer 106 is upward (↑), the MTJ element 100 is in the high resistance state, and the MTJ element 200 is in the low resistance state. Furthermore, when the magnetization direction of the storage layer 106 is downward (↓), the MTJ element 100 is in the low resistance state, and the MTJ element 200 is in the high resistance state. In addition, since the entire resistance value of the magnetoresistive element 3m is the sum of the resistance values of the MTJ elements 100 and 200, when the magnetization direction of the storage layer 106 is upward (↑), the magnetoresistive element 3m becomes the low resistance state, and when the magnetization direction of the storage layer 106 is downward (↓), the magnetoresistive element 3m becomes the high resistance state.

Furthermore, in the case as described above, when the magnetization direction of the storage layer 106 is upward (↑), the resistance value of the MTJ element 100 is high. Thus, the divided voltage of the MTJ element 100 increases when the voltage is applied to the magnetoresistive element 3m. On the other hand, when the magnetization direction of the storage layer 106 is downward (↓), the resistance value of the MTJ element 200 is high. Thus, the divided voltage of the MTJ element 200 increases when the voltage is applied to the magnetoresistive element 3m. Note that, in the present embodiment, the magnitude relationship of the resistance values of the MTJ elements 100 and 200 may be opposite from the above. In that case, the write voltage directions also become opposite.

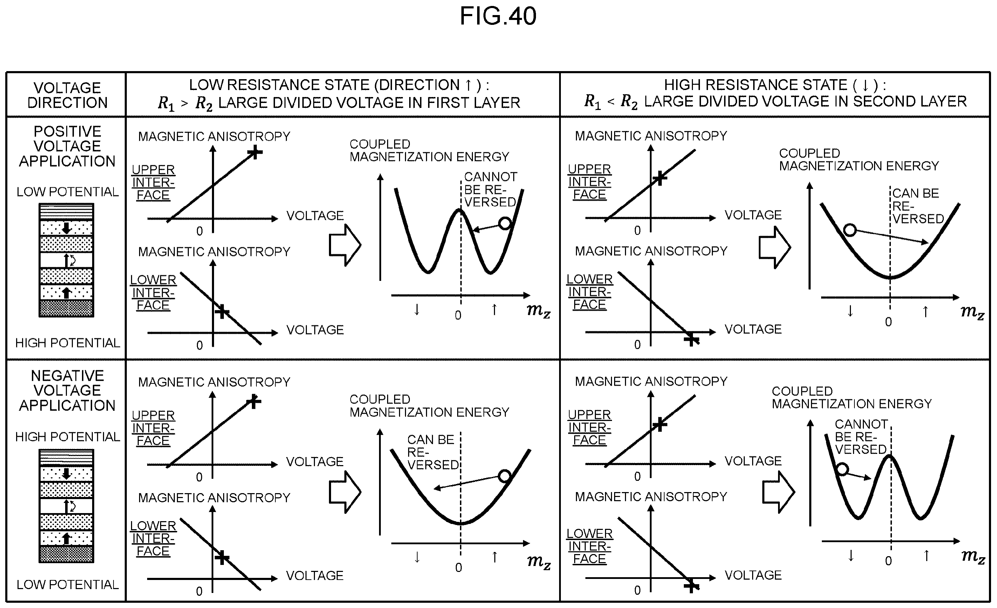

Next, FIG. 40 illustrates a schematic diagram of magnetic anisotropy and magnetization energy of the interface between the tunnel barrier layer 104 and the storage layer 106 in the upper layer and the interface between the tunnel barrier layer 204 and the storage layer 106 in the lower layer. In the present embodiment, since the operation principle is similar to that of the first embodiment, the description thereof is omitted here.

### <6.3 First modification>

The first modification of the first embodiment is also applicable to the fifth embodiment.

### <6.4 Second modification>

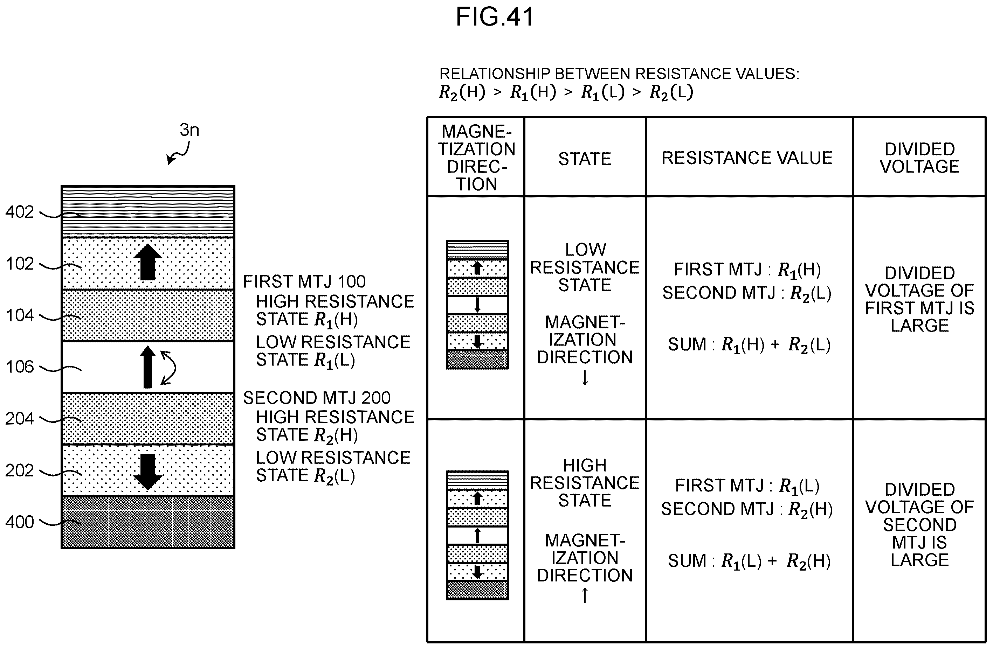

Next, a second modification of the present embodiment will be described with reference to FIG. 41. FIG. 41 is an explanatory diagram illustrating a configuration example and an operation principle of a magnetoresistive element 3n according to the second modification. In the present embodiment described above, the magnetization direction of the magnetization fixed layer 102 of the MTJ element 100 is directed downward, and the magnetization direction of the magnetization fixed layer 202 of the MTJ element 200 is directed upward. On the other hand, in the second modification, the magnetization direction of the magnetization fixed layer 102 of the MTJ element 100 is directed upward, and the magnetization direction of the magnetization fixed layer 202 of the MTJ element 200 is directed downward. Even with this configuration, operation similar to the present embodiment can be performed. Note that the above-described first modification is also applicable to the second modification.

Next, FIG. 41 illustrates a relationship between the resistance state and the magnetization direction of the MTJ elements 100 and 200. Also in the second modification, the MTJ elements 100 and 200 have different resistance values. Specifically, in the present embodiment, a resistance value R₁ (H) in the high resistance state and a resistance value R₁ (L) in the low resistance state of the MTJ element 100, and a resistance value R₂ (H) in the high resistance state and a resistance value R₂ (L) in the low resistance state of the MTJ element 200 have, for example, a magnitude relationship of R₂(H)>R₁(H)>R₁(L)>R₂(L). Note that, in the present embodiment, the resistance values of the respective MTJ elements 100 and 200 in the low resistance state may be substantially equal, or may have the magnitude relationship of R₁(L)<R₂(L).

In the case as described above, when the magnetization direction of the storage layer 106 of the MTJ element 100 is downward (↓), the MTJ element 100 is in the high resistance state, and the MTJ element 200 is in the low resistance state. Furthermore, when the magnetization direction of the storage layer 106 is upward (↑), the MTJ element 100 is in the low resistance state, and the MTJ element 200 is in the high resistance state. In addition, with respect to the entire resistance value of the magnetoresistive element 3n, when the magnetization direction of the storage layer 106 is downward (↓), the magnetoresistive element 3n becomes the low resistance state, and when the magnetization direction of the storage layer 106 is upward (↑), the magnetoresistive element 3n becomes the high resistance state.

Furthermore, in the case as described above, when the magnetization direction of the storage layer 106 is downward (↓), the resistance value of the MTJ element 100 is high. Thus, the divided voltage of the MTJ element 100 increases when the voltage is applied to the magnetoresistive element 3n. On the other hand, when the magnetization direction of the storage layer 106 is upward (↑), the resistance value of the MTJ element 200 is high. Thus, the divided voltage of the MTJ element 200 increases when the voltage is applied to the magnetoresistive element 3n. Note that, in the present embodiment, the magnitude relationship of the resistance values of the MTJ elements 100 and 200 may be opposite from the above. In that case, the write voltage directions also become opposite.

### <<7. Sixth embodiment>>

### <7.1 Configuration example of magnetoresistive element>

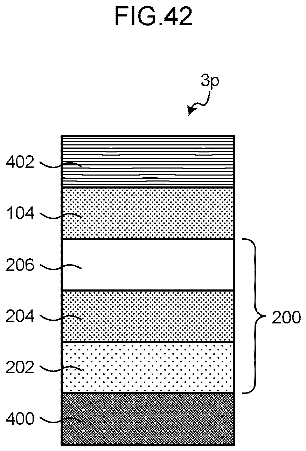

Next, a sixth embodiment of the present disclosure will be described with reference to FIG. 42. FIG. 42 is a schematic diagram illustrating a configuration example of a magnetoresistive element 3p according to the present embodiment. In the following, description of points common to the first to fifth embodiments will be omitted, and points different from the first to fifth embodiments will be described.

In the above-described fifth embodiment, the magnetoresistive element 3m includes the two MTJ elements 100 and 200, but one storage layer 106 is shared. The present embodiment has a configuration in which the magnetization fixed layer 102 is removed from the MTJ element 100 in the upper part according to the fifth embodiment. Specifically, the magnetoresistive element 3p according to the present embodiment includes the MTJ element 200. Furthermore, the magnetoresistive element 3p includes a resistive element having a tunnel barrier layer (another tunnel barrier layer) 104 in contact with the storage layer 206 of the MTJ element 200. Note that, in the present embodiment, the magnetization direction of the magnetization fixed layer 202 of the MTJ element 200 is upward.

### <7.2 Operation principle>

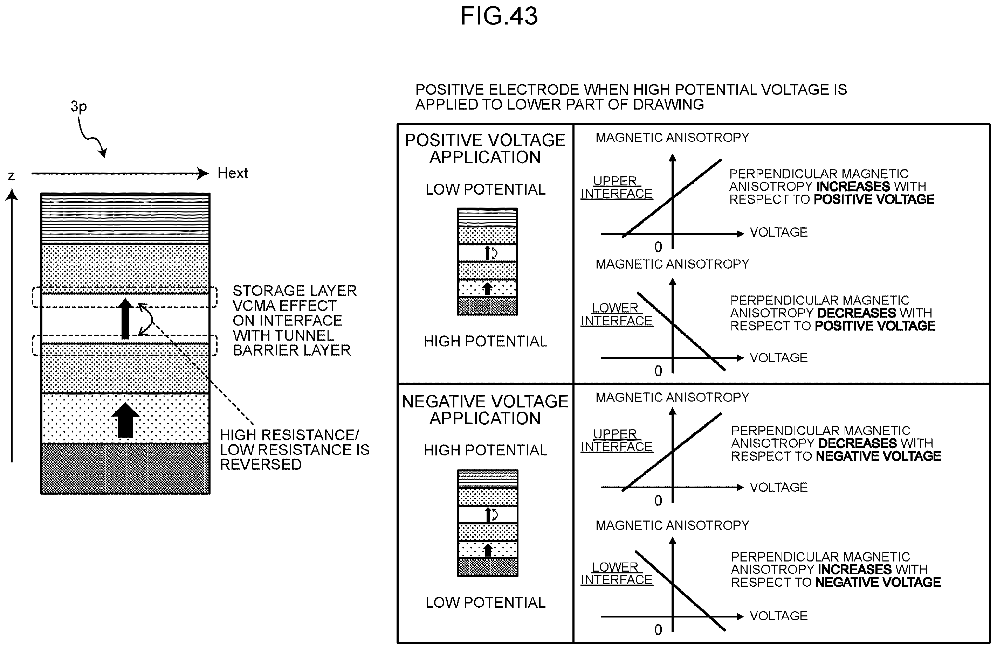

Next, an operation principle of the magnetoresistive element 3p according to the present embodiment will be described with reference to FIGS. 43 to 45. FIGS. 43 to 45 are explanatory diagrams illustrating the operation principle of the magnetoresistive element 3p according to the present embodiment. Note that, in the following drawings, an "upper interface" means an interface between the tunnel barrier layer 104 and the storage layer 206 in the upper layer, and a "lower interface" means an interface between the tunnel barrier layer 204 and the storage layer 206 in the lower layer.

As illustrated in FIG. 43, in the magnetoresistive element 3p according to the present embodiment, when the positive voltage is applied, due to the VCMA effect, the perpendicular magnetic anisotropy is increased at the interface between the tunnel barrier layer 104 and the storage layer 206 in the upper layer, and the perpendicular magnetic anisotropy is decreased at the interface between the tunnel barrier layer 204 and the storage layer 206 in the lower layer. Furthermore, in the magnetoresistive element 3p according to the present embodiment, when the negative voltage is applied, due to the VCMA effect, the vertical magnetic anisotropy is decreased at the interface between the tunnel barrier layer 104 and the storage layer 206 in the upper layer, and the vertical magnetic anisotropy is increased at the interface between the tunnel barrier layer 204 and the storage layer 206 in the lower layer.

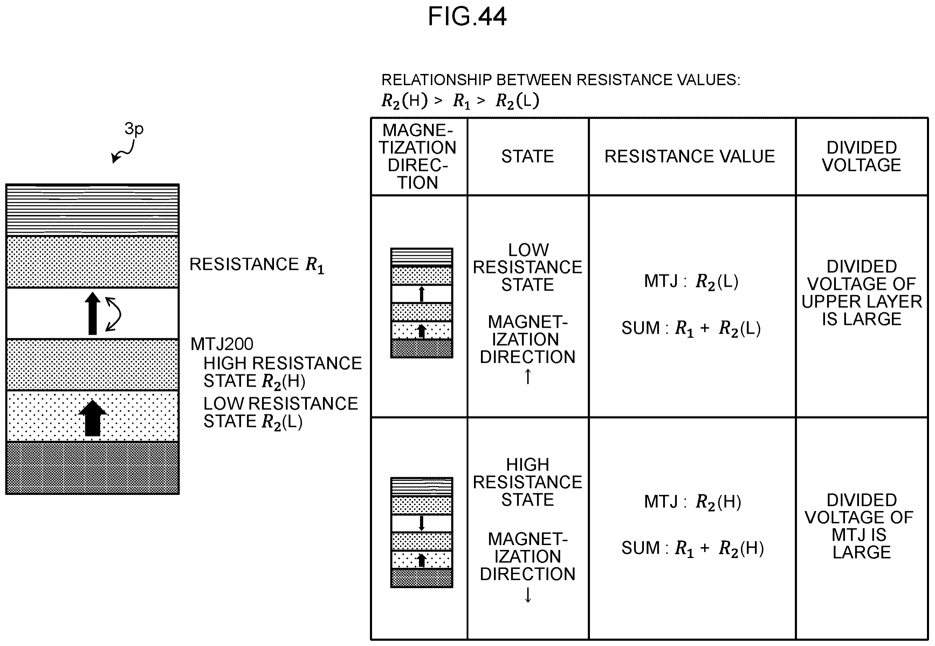

Next, FIG. 44 illustrates a relationship between the resistance state and the magnetization direction. Specifically, in the present embodiment, the resistance value R₁ of the upper layer, and the resistance value R₂ (H) in the high resistance state and the resistance value R₂ (L) in the low resistance state of the MTJ element 200 have, for example, a magnitude relationship of R₂(H)>R₁>R₂(L) .

In the case as described above, when the magnetization direction of the storage layer 206 is upward (↑), the MTJ element 200 is in the low resistance state. In addition, when the magnetization direction of the storage layer 206 is downward (↓), the MTJ element 200 is in the high resistance state. In addition, with respect to the entire resistance value of the magnetoresistive element 3p, when the magnetization direction of the storage layer 206 is upward (↑), the magnetoresistive element 3p becomes the low resistance state, and when the magnetization direction of the storage layer 206 is downward (↓), the magnetoresistive element 3p becomes the high resistance state.

In addition, in the case as described above, when the magnetization direction of the storage layer 206 is upward (↑), the resistance value of the upper layer is high. Thus, the divided voltage of the upper layer increases when the voltage is applied to the magnetoresistive element 3p. On the other hand, when the magnetization direction of the storage layer 206 is downward (↓), the resistance value of the MTJ element 200 is high. Thus, the divided voltage of the MTJ element 200 increases when the voltage is applied to the magnetoresistive element 3p. In the present embodiment, the magnitude relationship of the resistance values may be opposite from the above. In that case, the write voltage directions also become opposite.

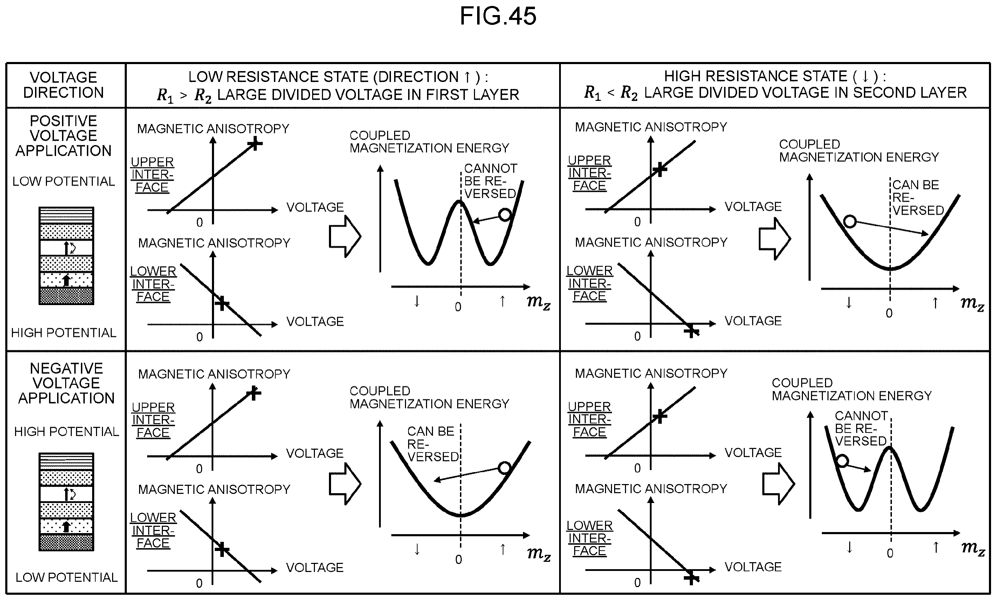

Next, FIG. 45 illustrates a schematic diagram of magnetic anisotropy and magnetization energy of the interface between the tunnel barrier layer 104 and the storage layer 206 in the upper layer and the interface between the tunnel barrier layer 204 and the storage layer 206 in the lower layer. Note that the operation principle of the present embodiment is similar to that of the first embodiment, and thus description thereof is omitted here.

### <7.3 First modification>

Also in the sixth embodiment, the first modification of the first embodiment is applicable.

### <7.4 Second modification>

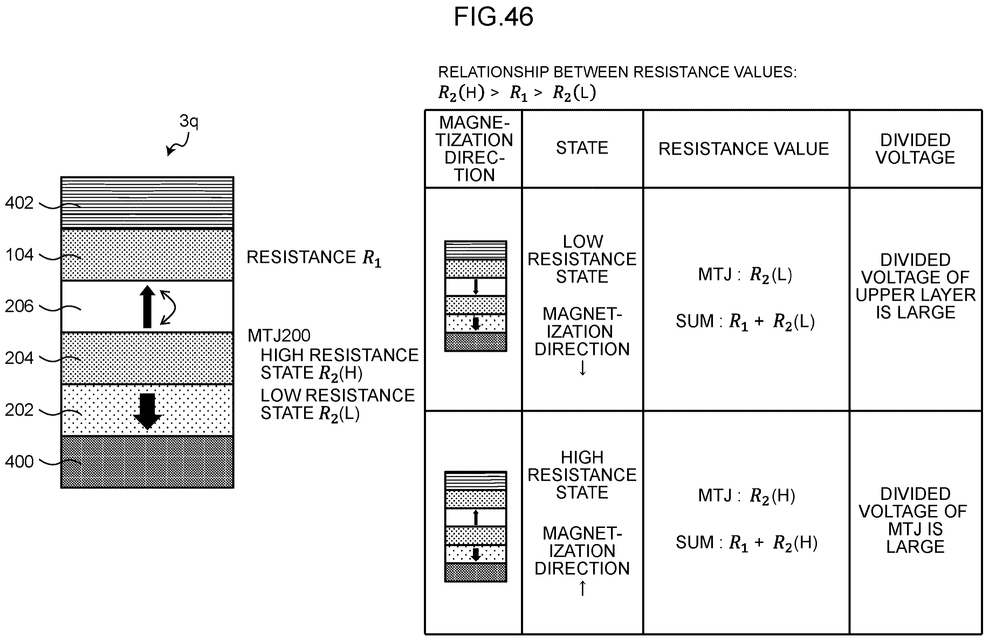

Next, a second modification of the present embodiment will be described with reference to FIG. 46. FIG. 46 is an explanatory diagram illustrating a configuration example and an operation principle of a magnetoresistive element 3q according to the second modification. In the present embodiment described above, the magnetization direction of the magnetization fixed layer 202 of the MTJ element 200 is directed upward. On the other hand, in the second modification, the magnetization direction of the magnetization fixed layer 202 of the MTJ element 200 is directed downward. Even with this configuration, operation similar to the present embodiment can be performed. Note that the above-described first modification is also applicable to the second modification.

Next, FIG. 46 illustrates a relationship between the resistance state and the magnetization direction. Specifically, in the second modification, the resistance value R₁ of the upper layer, and the resistance value R₂ (H) in the high resistance state and the resistance value R₂ (L) in the low resistance state of the MTJ element 200 have, for example, a magnitude relationship of R₂(H)>R₁>R₂(L).

In the case as described above, when the magnetization direction of the storage layer 206 is downward (↓), the MTJ element 200 is in the low resistance state. Furthermore, when the magnetization direction of the storage layer 206 is upward (↑), the MTJ element 200 is in the high resistance state. In addition, with respect to the entire resistance value of the magnetoresistive element 3q, when the magnetization direction of the storage layer 206 is downward (↓), the magnetoresistive element 3q becomes the low resistance state, and when the magnetization direction of the storage layer 206 is upward (↑), the magnetoresistive element 3q becomes the high resistance state.

In addition, in the case as described above, when the magnetization direction of the storage layer 206 is downward (↓), the resistance value of the upper layer is high. Thus, the divided voltage of the upper layer increases when the voltage is applied to the magnetoresistive element 3q. On the other hand, when the magnetization direction of the storage layer 206 is upward (↑), the resistance value of the MTJ element 200 is high. Thus, the divided voltage of the MTJ element 200 increases when the voltage is applied to the magnetoresistive element 3q. In the present embodiment, the magnitude relationship of the resistance values may be opposite from the above. In that case, the write voltage directions also become opposite.

### <7.5 Third modification>

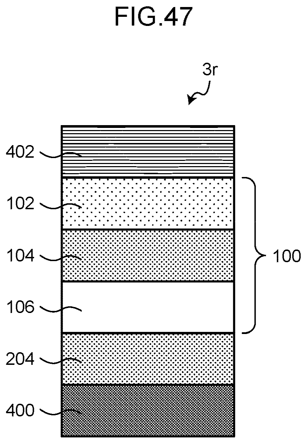

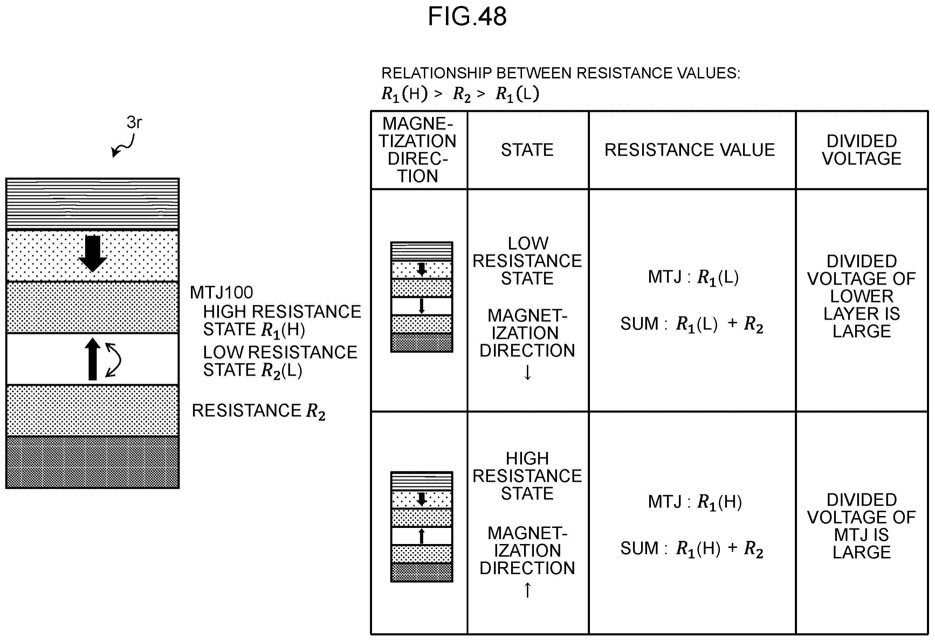

Next, a third modification of the present embodiment will be described with reference to FIGS. 47 and 48. FIG. 47 is a schematic diagram illustrating a configuration example of a magnetoresistive element 3r according to the third modification, and FIG. 48 is an explanatory diagram illustrating a configuration example and an operation principle of the magnetoresistive element 3r according to the third modification. In the present embodiment described above, the magnetoresistive element 3p has a configuration in which the magnetization fixed layer 102 is removed from the MTJ element 100 in the upper part. In the third modification, as illustrated in FIG. 47, the magnetization fixed layer 202 is removed from the MTJ element 200 in the lower part. In the third modification, the magnetization direction of the magnetization fixed layer 102 of the MTJ element 100 is directed downward. Even with this configuration, operation similar to the present embodiment can be performed. Note that the above-described first modification is also applicable to the third modification.

Next, FIG. 48 illustrates a relationship between the resistance state and the magnetization direction. Specifically, in the third modification, the resistance value R₂ of the lower layer, and the resistance value R₁(H) in the high resistance state and the resistance value R₁(L) in the low resistance state of the MTJ element 100 have, for example, a magnitude relationship of R₁ (H) >R₂>R₁ (L) .

In the case as described above, when the magnetization direction of the storage layer 106 is downward (↓), the MTJ element 100 is in the low resistance state. In addition, when the magnetization direction of the storage layer 106 is upward (↑), the MTJ element 100 is in the high resistance state. Further, with respect to the entire resistance value of the magnetoresistive element 3r, when the magnetization direction of the storage layer 106 is downward (↓), the magnetoresistive element 3r becomes the low resistance state, and when the magnetization direction of the storage layer 106 is upward (↑), the magnetoresistive element 3r becomes the high resistance state.

Furthermore, in the case as described above, when the magnetization direction of the storage layer 106 is downward (↓), the resistance value of the lower layer is high. Thus, the divided voltage of the lower layer increases when the voltage is applied to the magnetoresistive element 3r. On the other hand, when the magnetization direction of the storage layer 106 is upward (↑), the resistance value of the MTJ element 100 is high. Thus, the divided voltage of the MTJ element 100 increases when the voltage is applied to the magnetoresistive element 3r. In the present embodiment, the magnitude relationship of the resistance values may be opposite from the above. In that case, the write voltage directions also become opposite.

### <7.6 Fourth modification>

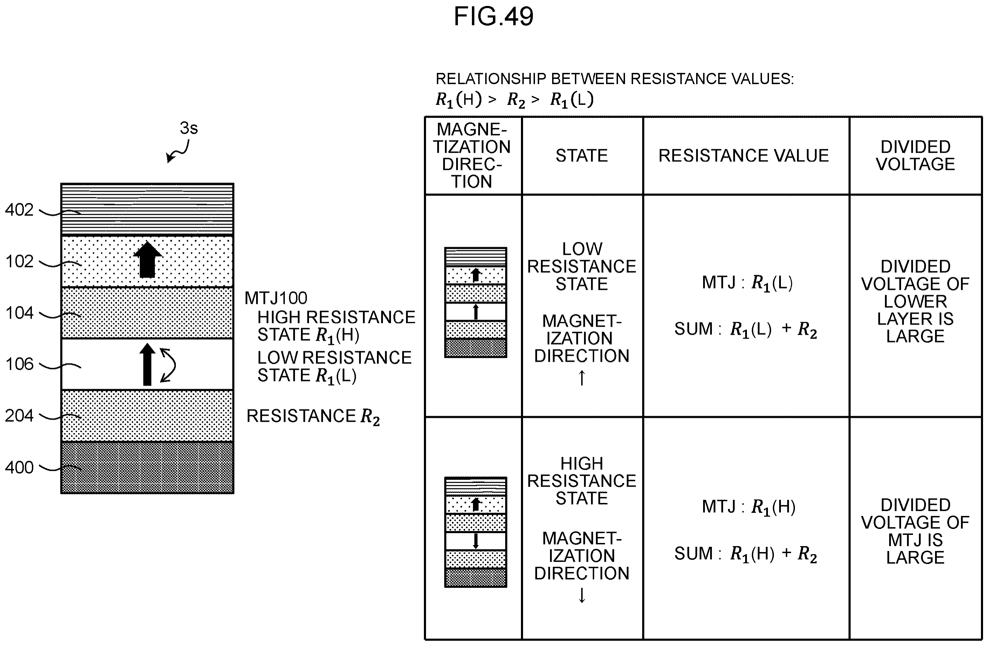

Next, a fourth modification of the present embodiment will be described with reference to FIG. 49. FIG. 49 is an explanatory diagram illustrating a configuration example and an operation principle of a magnetoresistive element 3s according to the fourth modification. In the above-described third modification, the magnetization direction of the magnetization fixed layer 102 of the MTJ element 100 is directed downward. On the other hand, in the fourth modification, the magnetization direction of the magnetization fixed layer 102 of the MTJ element 100 is directed upward. Even with this configuration, operation similar to the present embodiment can be performed. Note that the above-described first modification is also applicable to the fourth modification.

Next, FIG. 49 illustrates a relationship between the resistance state and the magnetization direction. Specifically, in the present fourth modification, the resistance value R₂ of the lower layer, and the resistance value R₁ (H) in the high resistance state and the resistance value R₁ (L) in the low resistance state of the MTJ element 100 have, for example, a magnitude relationship of R₁ (H) >R₂>R₁ (L) .

In the case as described above, when the magnetization direction of the storage layer 106 is upward (↑), the MTJ element 100 is in the low resistance state. In addition, when the magnetization direction of the storage layer 106 is downward (↓), the MTJ element 100 is in the high resistance state. In addition, with respect to the entire resistance value of the magnetoresistive element 3s, when the magnetization direction of the storage layer 106 is upward (↑), the magnetoresistive element 3s becomes the low resistance state, and when the magnetization direction of the storage layer 106 is downward (↓), the magnetoresistive element 3s becomes the high resistance state.

In addition, in the case as described above, when the magnetization direction of the storage layer 106 is upward (↑), the resistance value of the lower layer is high. Thus, the divided voltage of the lower layer increases when the voltage is applied to the magnetoresistive element 3s. On the other hand, when the magnetization direction of the storage layer 106 is downward (↓), the resistance value of the MTJ element 100 is high. Thus, the divided voltage of the MTJ element 100 increases when the voltage is applied to the magnetoresistive element 3s. In the present embodiment, the magnitude relationship of the resistance values may be opposite from the above. In that case, the write voltage directions also become opposite.

### <<8. Seventh embodiment>>

### <8.1 Embodiment>

The magnetoresistive elements 3 according to the first to sixth embodiments and the modifications of the present disclosure described above can be applied to a cross-point memory (cross-point type memory array) having a cross-point structure. The cross-point structure is a structure in which a memory cell (magnetoresistive element 3) is disposed in each of regions where a plurality of word lines and a plurality of bit lines intersect.

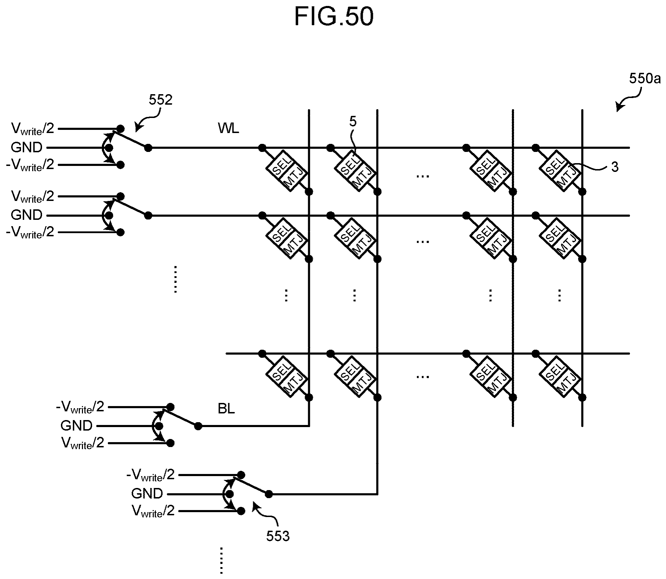

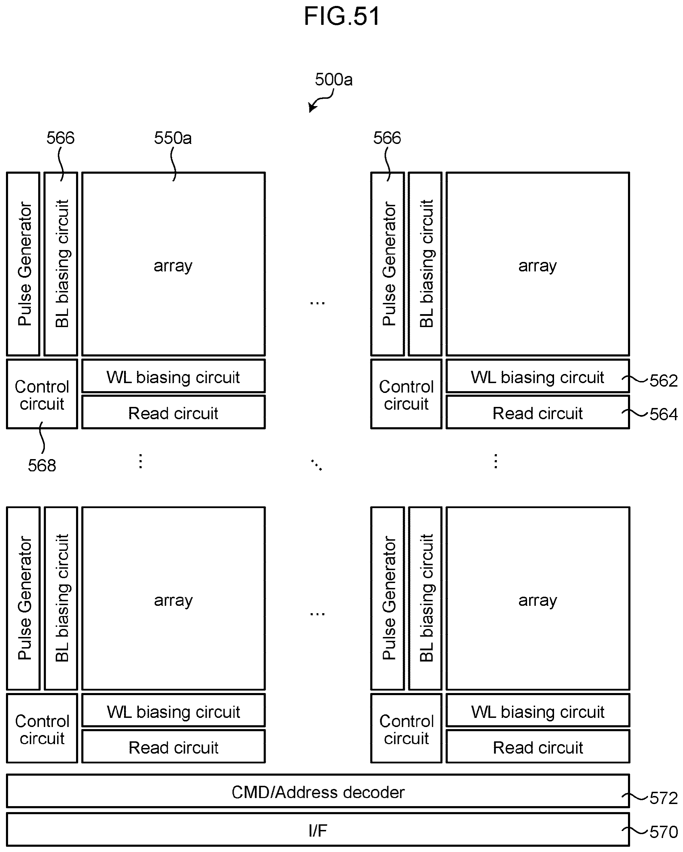

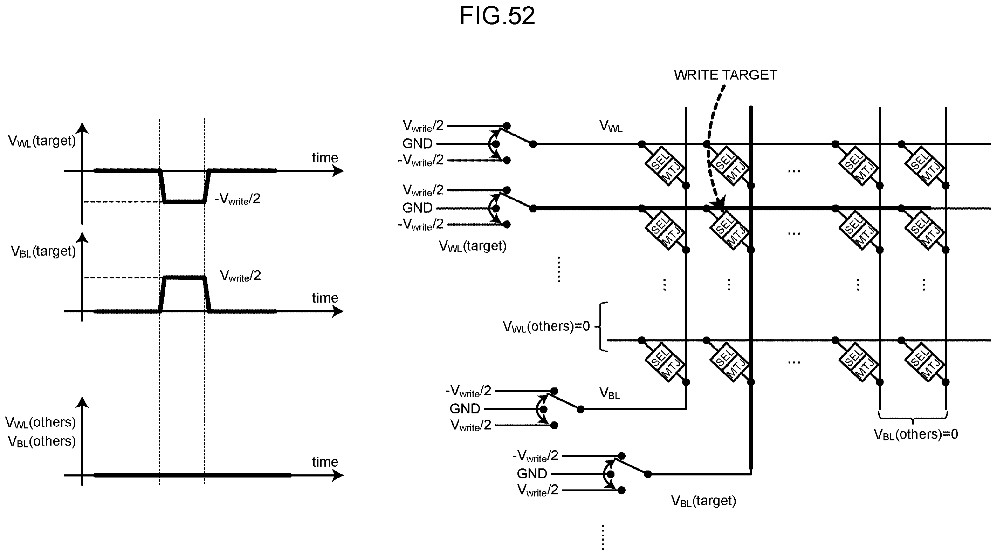

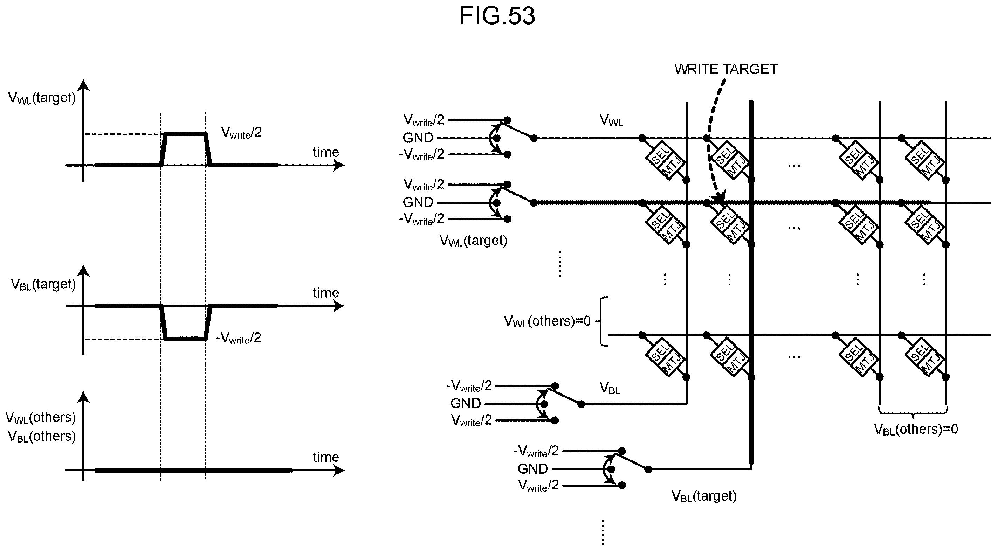

Therefore, an embodiment of the cross-point memory to which the first to sixth embodiments and the modifications are applied will be described as a seventh embodiment of the present disclosure with reference to FIGS. 50 to 53. FIG. 50 is a circuit diagram of a memory cell array 550a according to the present embodiment, and FIG. 51 is a block diagram illustrating a configuration example of a memory device 500a according to the present embodiment. FIG. 52 is an explanatory diagram illustrating write pulse control to the low resistance state in the present embodiment, and FIG. 53 is an explanatory diagram illustrating write pulse control to the high resistance state in the present embodiment.

As illustrated in FIG. 50, in the memory cell array 550a of the present embodiment, a plurality of magnetoresistive elements 3 and selection elements 5 are arranged along a row direction and a column direction. Specifically, in the memory cell array 550a of the present embodiment, the magnetoresistive elements 3 and the selection elements 5 according to the first to sixth embodiments and the modifications are arranged at intersections of the word line (WL) and the bit line (BL). More specifically, one end of the magnetoresistive element 3 in the same row is electrically connected to a common Bit Line (BL) (first control line), and the other end of the magnetoresistive element 3 in the same row is electrically connected to a common Word Line (WL) (second control line). The selection element is connected in series to one of terminals of the magnetoresistive element 3. Furthermore, the memory cell array 550a of the present embodiment includes a switch 552 that selects a memory cell and an applied voltage. In FIG. 50, a voltage that causes the magnetoresistive element 3 to reverse is V _write, and the switch 552 sets the Word Line (WL) and the Bit Line (BL) to one of three potentials (V_write/2, GND, -V_write/2).

FIG. 51 illustrates a configuration example of the memory device 500a according to the present embodiment. In FIG. 51, illustration of functional units that do not directly affect write/read processing, such as a power supply and voltage generation, is omitted. The selection switch 552 is disposed in a BL biasing circuit 560 and a WL biasing circuit 562 in FIG. 51. A read circuit 564 can read from the memory cell. The control pulse is generated by a pulse generator 566. Write control such as a control pulse generation timing is performed by a control circuit 568. In the memory device 500a according to the present embodiment, a plurality of memory cell arrays 550a is mounted, and the memory cell arrays 550a as many as the number of bits to be accessed can be operated simultaneously. An input/output unit (I/F) 570 receives a command address for write/read or the like, and an address decoder (CMD/Address Decoder) 572 interprets the command address and converts the command address into an internal signal and transmits the signal to the control circuit 568 of each memory cell array 550a together with write data in the case of writing. Note that, in the present embodiment, an existing method can be used for reading.

FIG. 52 illustrates the write pulse control to the low resistance state in the present embodiment. In the present embodiment, as illustrated in FIG. 52, the WL and BL connected to the memory cell serving as a write target are selected, and -V _Write/2 is applied to the WL selected and V_Write/2 is applied to the BL selected. Other WLs and BLs are kept at 0 [V] (GND). Therefore, the voltage V_Write is applied only to the target memory cell selected. In other memory cells in the same column or the same row of the target memory cell, the voltage V_Write/2 is applied. Thus, the magnetization direction is not reversed.

FIG. 53 illustrates the write pulse control to the high resistance state in the present embodiment. In the present embodiment, as illustrated in FIG. 53, the WL and the BL connected to a target memory cell to write are selected, and V_Write/2 is applied to the WL selected and -V_Write/2 is applied to the BL selected. Other WLs and BLs are kept at 0 [V] (GND). Therefore, the voltage V_Write is applied only to the target memory cell selected. In other memory cells in the same column or the same row of the target memory cell, the voltage V_Write/2 is applied. Thus, the magnetization direction is not reversed.

### <8.2 Modification>

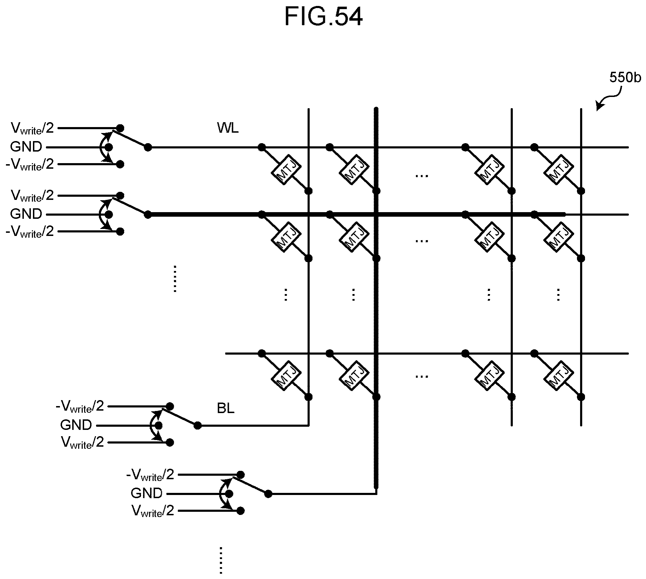

Next, a modification of the present embodiment will be described with reference to FIG. 54. FIG. 54 is a circuit diagram of a memory cell array 550b according to the present modification. In the present modification, unlike the above-described present embodiment, the memory cell does not include the selection element 5. Also in the present modification, the voltage V_Write is applied when writing is performed on the magnetoresistive element 3 of the memory cell. In the above case, even when a half of the write voltage, i.e., the voltage V_Write/2, is applied to the magnetoresistive element 3 of the memory cell, the magnetization direction is not reversed, and writing is not performed. Therefore, in the present modification, by using the above characteristics, writing can be performed only on a target memory cell without providing the selection element 5. Specifically, in the present modification, the voltage V_Write/2 is applied to other memory cells in the same column or the same row of the target memory cell, but the magnetization direction will not be reversed. Therefore, also in the present modification, the magnetization direction of only the target memory cell is reversed to perform writing.

### <<9. Eighth embodiment>>

### <9.1 Embodiment>

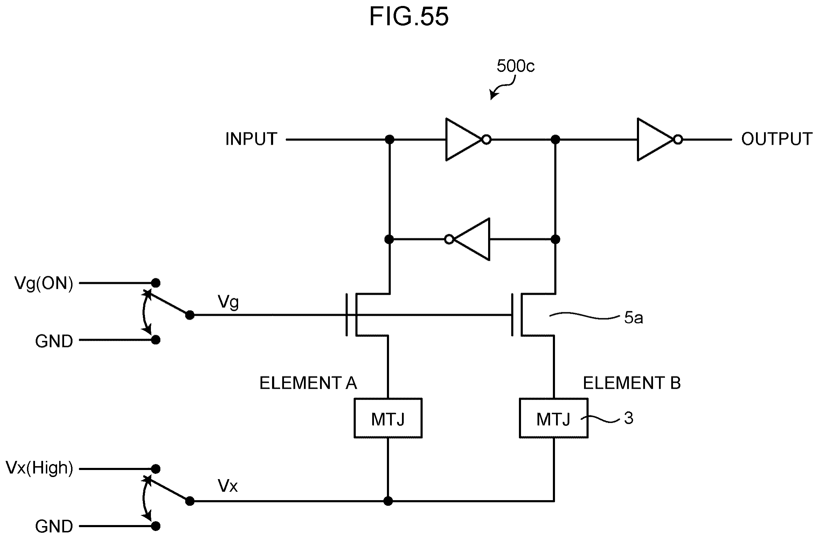

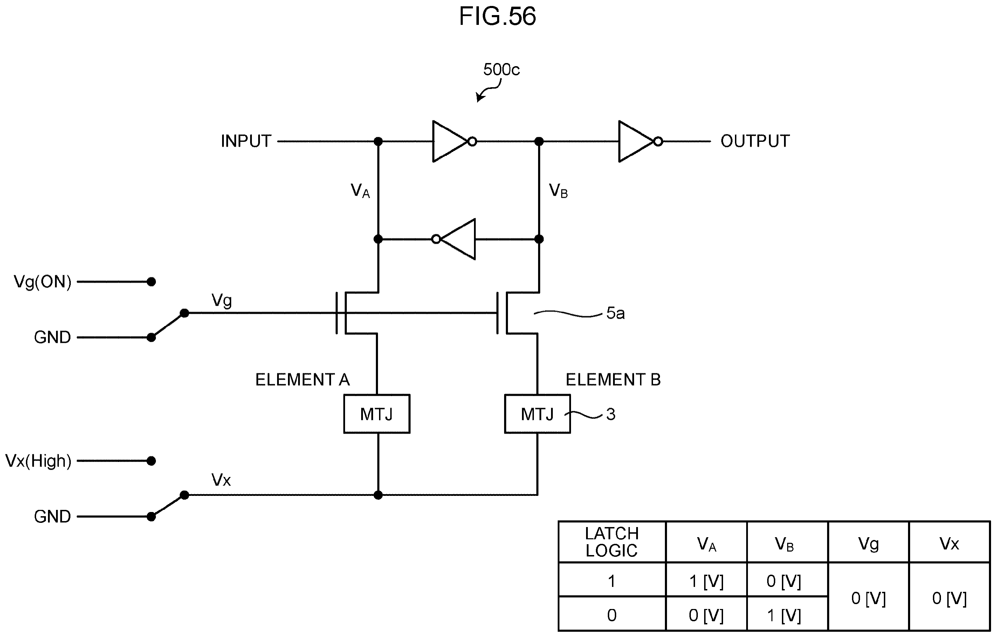

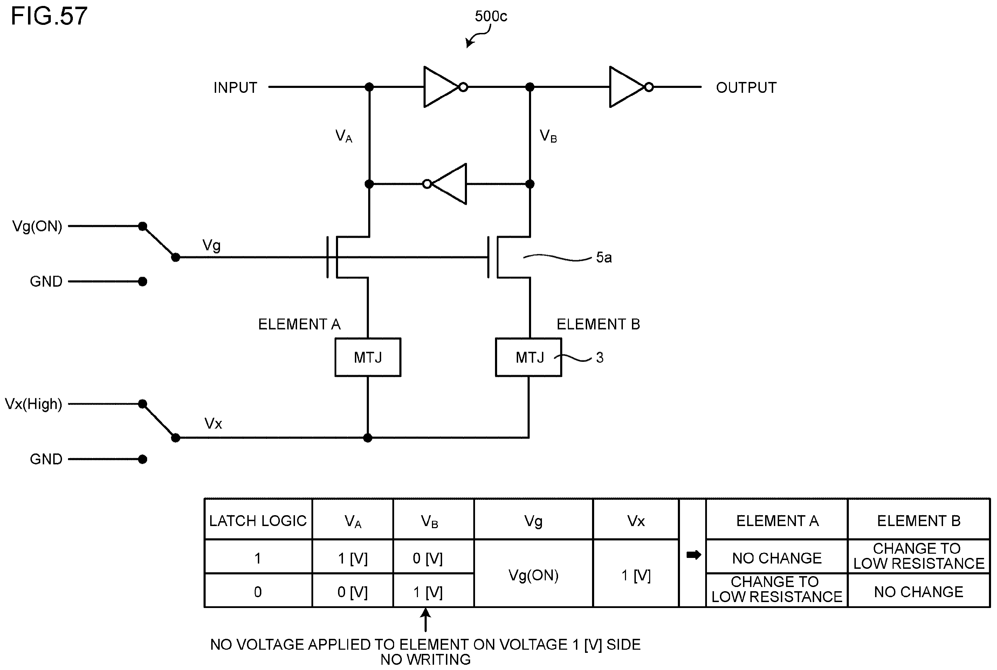

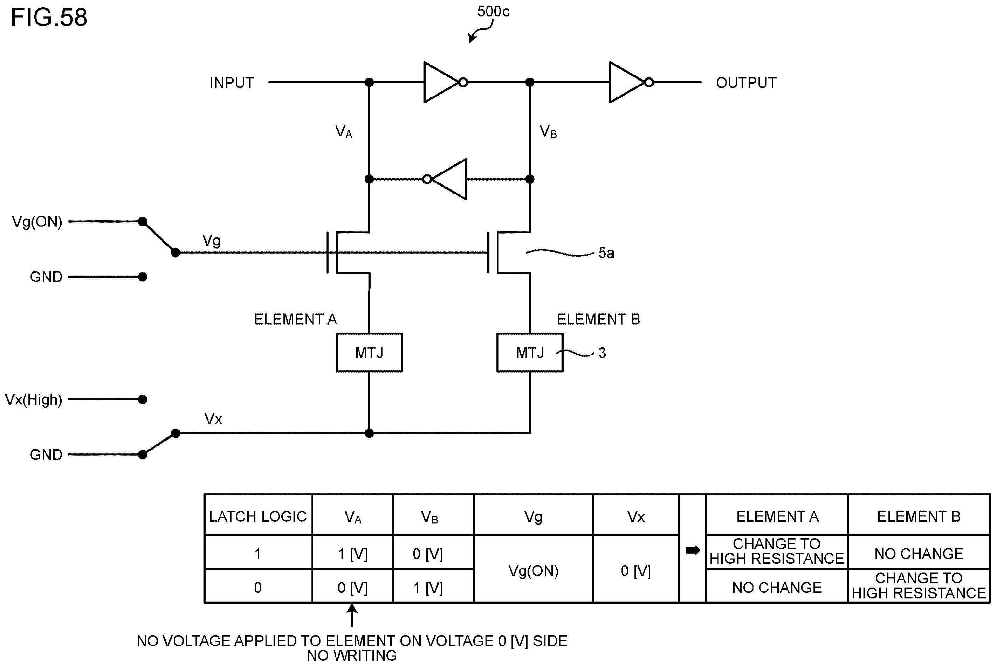

The magnetoresistive elements 3 according to the first to sixth embodiments and the modifications of the present disclosure described above can also be applied to a memory device having a latch circuit that temporarily holds a signal. Therefore, an embodiment of a memory device having a nonvolatile latch circuit to which the first to sixth embodiments and the modifications are applied will be described as an eighth embodiment of the present disclosure with reference to FIGS. 55 to 58. FIG. 55 is a circuit diagram of a memory device 500c according to the present embodiment. FIG. 56 is an explanatory diagram illustrating an operation when the memory device 500c according to the present embodiment functions as the latch circuit. FIGS. 57 and 58 are explanatory diagrams illustrating the operation at the time of storing the memory device 500c according to the present embodiment. In the following drawings, "element A" means a magnetoresistive element A, and "element B" means a magnetoresistive element B.

As illustrated in FIG. 55, the memory device 500c according to the present embodiment includes the latch circuit, two magnetoresistive elements 3, and two transistors 5a. In the present embodiment, the magnetoresistive elements 3 are assigned to data logics in the high resistance state and the low resistance state to record, respectively. In the present embodiment, the magnetoresistive element 3 can be the magnetoresistive element according to the first to sixth embodiments and the modifications. Specifically, in the present embodiment, writing in the high resistance state and maintaining the high resistance state are performed when a high potential voltage is applied to an upper terminal (upper side in FIG. 55) of the magnetoresistive element 3, and writing in the low resistance state and maintaining the low resistance state are performed when a low potential voltage is applied to the upper terminal of the magnetoresistive element 3.

As illustrated in FIG. 56, when the memory device 500c according to the present embodiment is caused to function as the latch circuit, the two transistors are turned off (Vg=0), and data is input and output as illustrated in FIG. 56. Although the case of operating at voltage 1 [V] has been described as an example, the present embodiment is not limited thereto. For example, when a latched logic is "1", the states are VA = 1 [V] and VB = 0 [V]. On the other hand, when the latched logic is "0", the states are VA = 0 [V] and VB = 1 [V].

Furthermore, in the present embodiment, the memory device 500c can store, for example, data latched before voltage interruption in the magnetoresistive element 3. Writing to the magnetoresistive element 3 (generic term for magnetoresistive element A and magnetoresistive element B) can be performed in two steps.

In the first step illustrated in FIG. 57, a gate voltage Vg of the transistor is set to Vg (ON) and a lower end voltage Vx of the magnetoresistive element 3 is set to Vx (High), so as to write in the low resistance state. For example, Vx (High) is set to 1 [V]. For example, when the latched logic is "1", the state is VB = 0 [V]. A voltage of -1 [V] is applied to the magnetoresistive element B, and 0 [V] is applied to the magnetoresistive element A. Since no voltage is applied to the magnetoresistive element A, reversal does not occur, and only the magnetoresistive element B is reversed to the low resistance state. Alternatively, when the magnetoresistive element B is in the low resistance state, the state is maintained. Further, for example, when the latched logic is "0", the state is VA = 0 [V]. A voltage of -1 [V] is applied to the magnetoresistive element A, and 0 [V] is applied to the magnetoresistive element B. Since no voltage is applied to the magnetoresistive element B, reversal does not occur, and only the magnetoresistive element A is reversed to the low resistance state. Alternatively, when the magnetoresistive element A is in the low resistance state, the state is maintained.

In the second step illustrated in FIG. 58, the gate voltage Vg is set to Vg (ON) and the lower end voltage Vx of the magnetoresistive element 3 is set to GND, so as to write in the high resistance state. When the latched logic is "1", the state is VA = 1 [V]. A voltage of 1 [V] is applied to the magnetoresistive element A, and a voltage of 0 [V] is applied to the magnetoresistive element B. Since no voltage is applied to the magnetoresistive element B, reversal does not occur. The state in the first step is maintained, and only the magnetoresistive element A is reversed to the high resistance state. Alternatively, when the magnetoresistive element A is in the high resistance state, the state is maintained. When the latched logic is "0", the state is VB = 1 [V]. A voltage of 1 [V] is applied to the magnetoresistive element B, and 0 [V] is applied to the magnetoresistive element A. Since no voltage is applied to the magnetoresistive element A, reversal does not occur. The state in the first step is maintained, and only the magnetoresistive element B is reversed to the high resistance state. Alternatively, when the magnetoresistive element B is in the high resistance state, the state is maintained.

### <9.2 First modification>

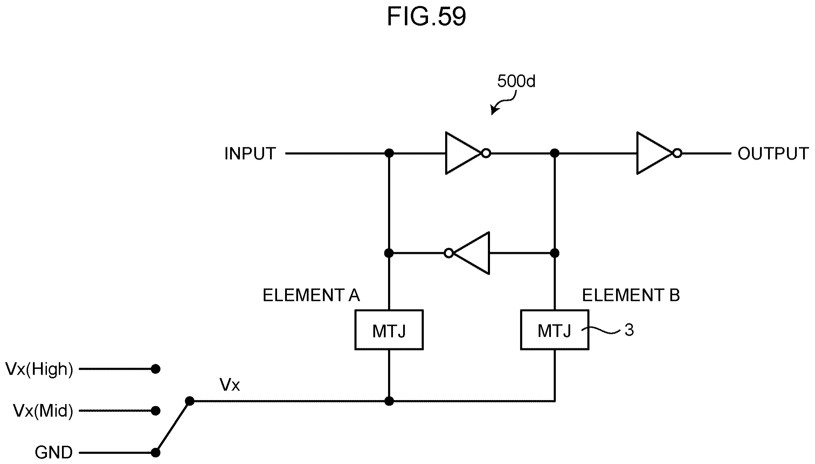

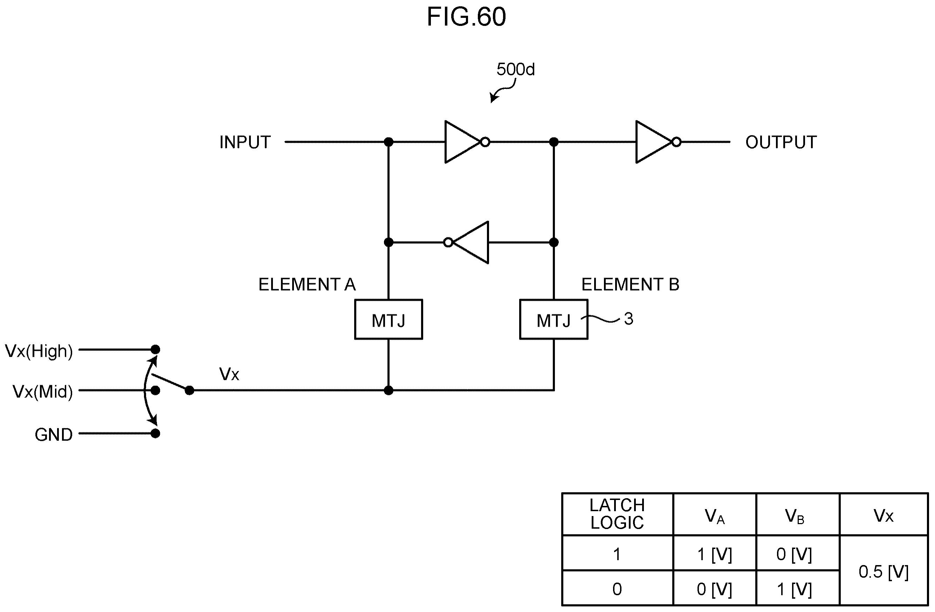

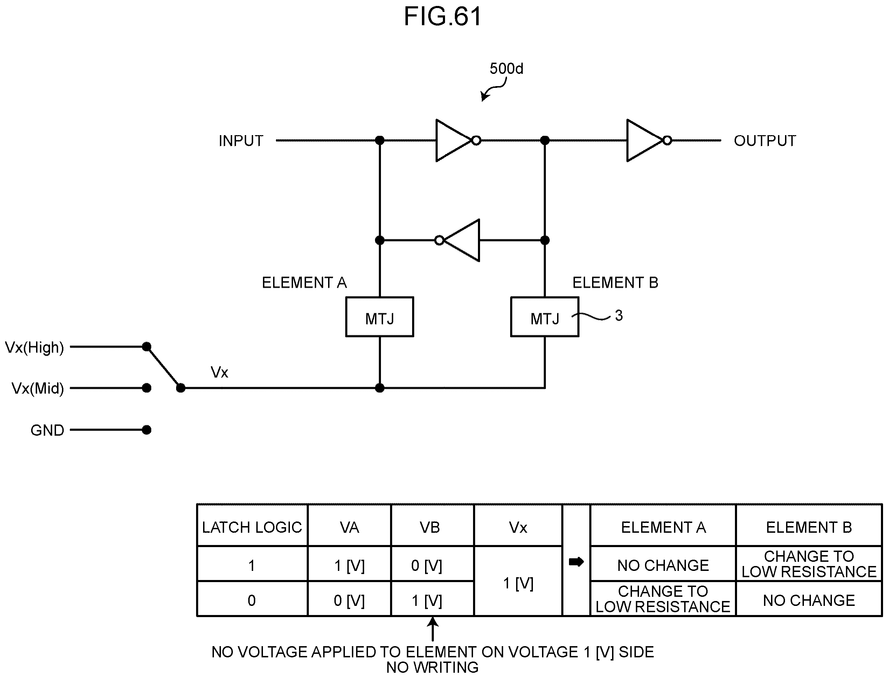

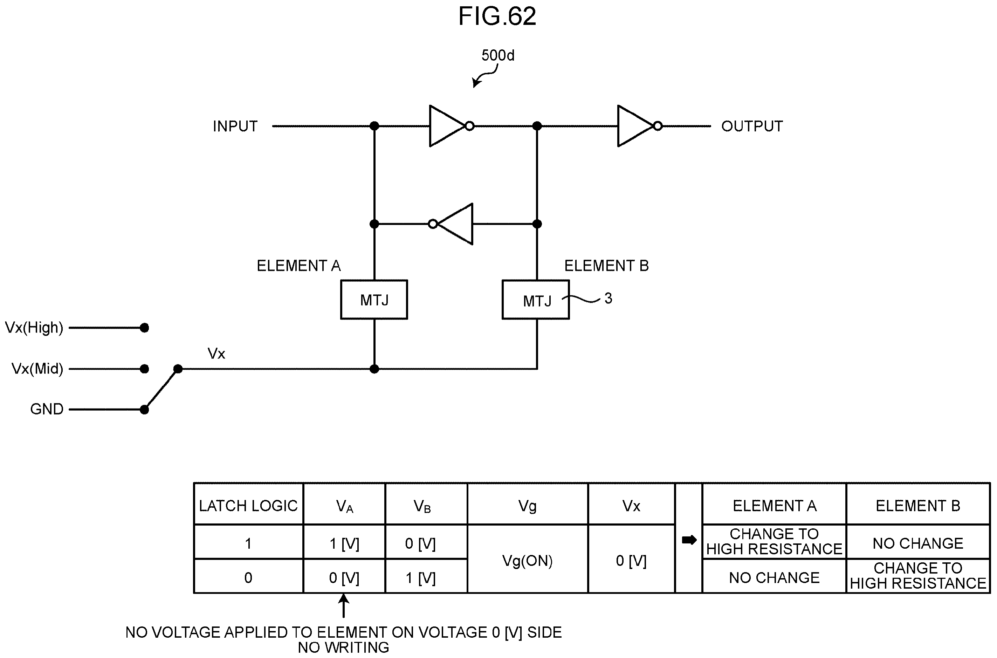

Next, a first modification of the present embodiment will be described with reference to FIGS. 59 to 62. FIG. 59 is a circuit diagram of a memory device 500d according to the first modification. FIG. 60 is an explanatory diagram illustrating an operation when the memory device 500d according to the first modification functions as the latch circuit. FIGS. 61 and 62 are explanatory diagrams illustrating the operation at storing in the memory device 500d according to the first modification. In the first modification, as illustrated in FIG. 59, the memory device 500d does not include the transistors 5a unlike the above-described present embodiment.

In the present modification, as illustrated in FIG. 60, when the memory device 500d is caused to function as the latch circuit, a lower end voltage Vx of the magnetoresistive element 3 is set to Vx = 0.5 [V] (Mid), and data is input and output as illustrated in FIG. 60. Although the case of operating at voltage 1 [V] has been described as an example, the present embodiment is not limited thereto. For example, when a latched logic is "1", the states are VA = 1 [V] and VB = 0 [V]. On the other hand, when the latched logic is "0", the states are VA = 0 [V] and VB = 1 [V]. When the write voltage of the magnetoresistive element 3 is set to ±1 [V], reversal does not occur even when ±0.5 [V] is applied to the magnetoresistive element 3.

In the first step illustrated in FIG. 61, the lower end voltage Vx of the magnetoresistive element 3 is set to Vx (High), so as to write in the low resistance state. For example, Vx (High) is set to 1 [V]. For example, when the latched logic is "1", the state is VB = 0 [V]. A voltage of -1 [V] is applied to the magnetoresistive element B, and 0 [V] is applied to the magnetoresistive element A. Since no voltage is applied to the magnetoresistive element A, reversal does not occur, and only the magnetoresistive element B is reversed to the low resistance state. Alternatively, when the magnetoresistive element B is in the low resistance state, the state is maintained. Further, for example, when the latched logic is "0", the state is VA = 0 [V]. A voltage of -1 [V] is applied to the magnetoresistive element A, and 0 [V] is applied to the magnetoresistive element B. Since no voltage is applied to the magnetoresistive element B, reversal does not occur, and only the magnetoresistive element A is reversed to the low resistance state. Alternatively, when the magnetoresistive element A is in the low resistance state, the state is maintained.

In the second step illustrated in FIG. 62, the lower end voltage Vx of the magnetoresistive element 3 is set to GND, so as to write in the high resistance state. When the latched logic is "1", the state is VA = 1 [V]. A voltage of 1 [V] is applied to the magnetoresistive element A, and a voltage of 0 [V] is applied to the magnetoresistive element B. Since no voltage is applied to the magnetoresistive element B, reversal does not occur. The state in the first step is maintained, and only the magnetoresistive element A is reversed to the high resistance state. Alternatively, when the magnetoresistive element A is in the high resistance state, the state is maintained. When the latched logic is "0", the state is VB = 1 [V]. A voltage of 1 [V] is applied to the magnetoresistive element B, and 0 [V] is applied to the magnetoresistive element A. Since no voltage is applied to the magnetoresistive element A, reversal does not occur. The state in the first step is maintained, and only the magnetoresistive element B is reversed to the high resistance state. Alternatively, when the magnetoresistive element B is in the high resistance state, the state is maintained.

### <9.3 Second modification>

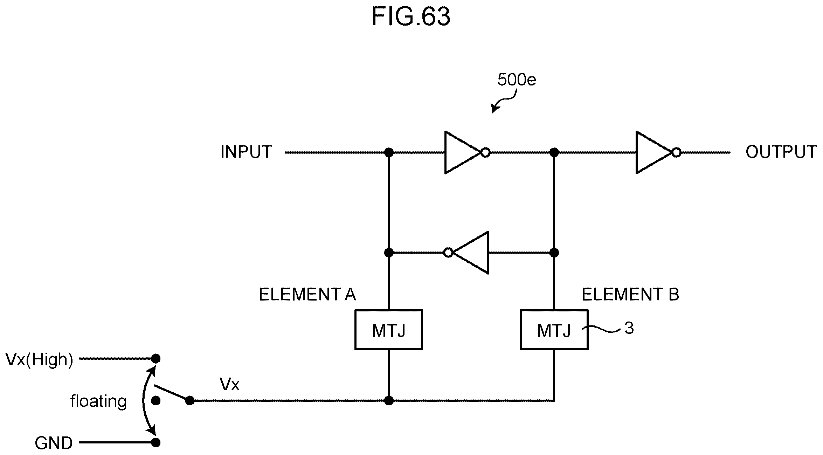

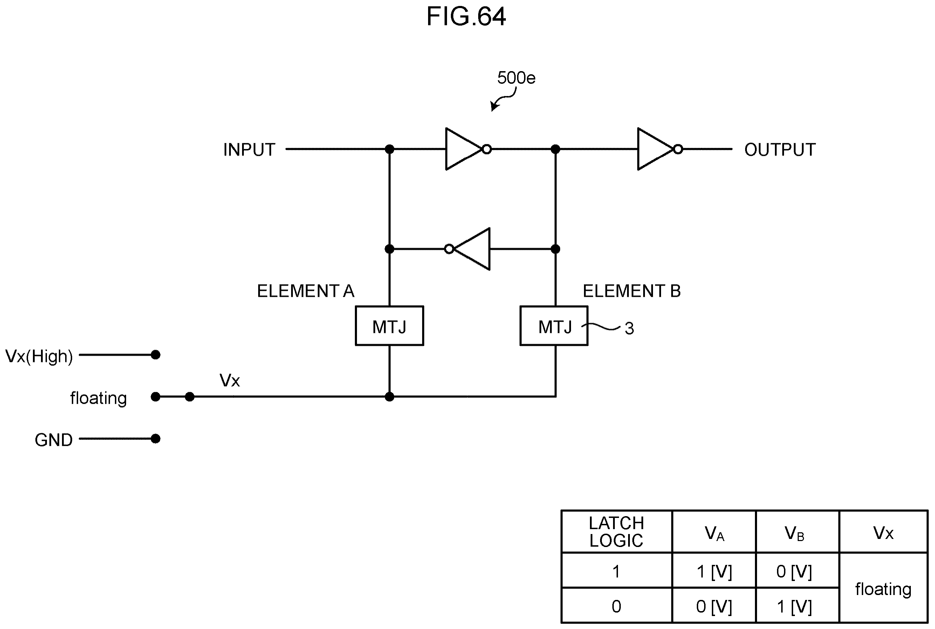

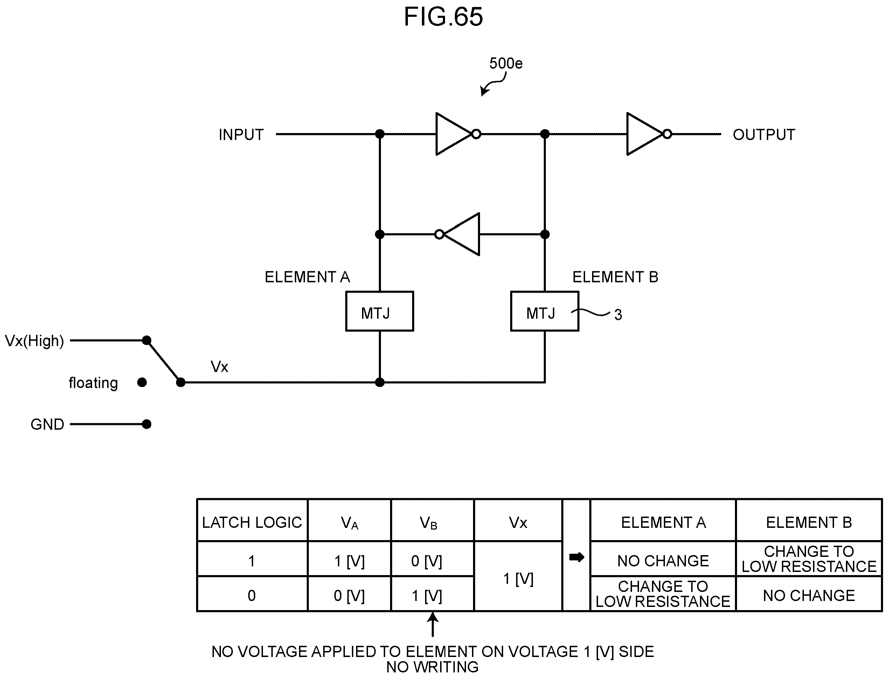

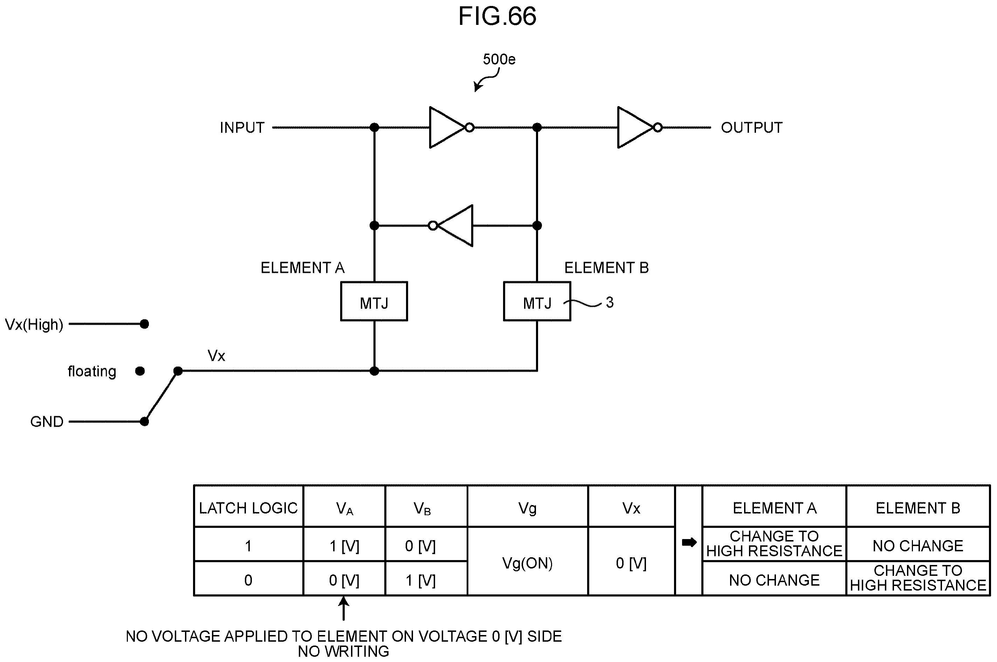

Next, a second modification of the present embodiment will be described with reference to FIGS. 63 to 66. FIG. 63 is a circuit diagram of a memory device 500e according to the second modification. FIG. 64 is an explanatory diagram illustrating an operation when the memory device 500e according to the second modification functions as the latch circuit. FIGS. 65 and 66 are explanatory diagrams illustrating the operation at storing in the memory device 500e according to the second modification. In the second modification, as illustrated in FIG. 63, the memory device 500e makes the lower end of the magnetoresistive element 3 floating when operating as the latch circuit.

Specifically, in the present modification, as illustrated in FIG. 64, when the memory device 500e is caused to function as the latch circuit, the lower end voltage Vx of the magnetoresistive element 3 is set to be floating, and data is input and output as illustrated in FIG. 64. Although the case of operating at voltage 1 [V] has been described as an example, the present embodiment is not limited thereto. For example, when a latched logic is "1", the states are VA = 1 [V] and VB = 0 [V]. On the other hand, when the latched logic is "0", the states are VA = 0 [V] and VB = 1 [V]. When a resistance ratio of the high resistance state to the low resistance state of the magnetoresistive element 3 is doubled, 2/3 of a voltage between the two magnetoresistive elements 3 is applied to the magnetoresistive element 3 in the high resistance state, and 1/3 of the voltage between the two magnetoresistive elements 3 is applied to the magnetoresistive element 3 in the low resistance state. When the write voltage of the magnetoresistive element 3 is set to ±1 [V], a reversal probability of the magnetoresistive element 3 is low even when 2/3 [V] is applied.

In the first step illustrated in FIG. 65, the lower end voltage Vx of the magnetoresistive element 3 is set to Vx (High), so as to write in the low resistance state. For example, Vx (High) is set to 1 [V]. For example, when the latched logic is "1", the state is VB = 0 [V]. A voltage of -1 [V] is applied to the magnetoresistive element B, and 0 [V] is applied to the magnetoresistive element A. Since no voltage is applied to the magnetoresistive element A, reversal does not occur, and only the magnetoresistive element B is reversed to the low resistance state. Alternatively, when the magnetoresistive element B is in the low resistance state, the state is maintained. Further, for example, when the latched logic is "0", the state is VA = 0 [V]. A voltage of -1 [V] is applied to the magnetoresistive element A, and 0 [V] is applied to the magnetoresistive element B. Since no voltage is applied to the magnetoresistive element B, reversal does not occur, and only the magnetoresistive element A is reversed to the low resistance state. Alternatively, when the magnetoresistive element A is in the low resistance state, the state is maintained.

In the second step illustrated in FIG. 66, the lower end voltage Vx of the magnetoresistive element 3 is set to GND, so as to write in the high resistance state. When the latched logic is "1", the state is VA = 1 [V]. A voltage of 1 [V] is applied to the magnetoresistive element A, and a voltage of 0 [V] is applied to the magnetoresistive element B. Since no voltage is applied to the magnetoresistive element B, reversal does not occur. The state in the first step is maintained, and only the magnetoresistive element A is reversed to the high resistance state. Alternatively, when the magnetoresistive element A is in the high resistance state, the state is maintained. When the latched logic is "0", the state is VB = 1 [V]. A voltage of 1 [V] is applied to the magnetoresistive element B, and 0 [V] is applied to the magnetoresistive element A. Since no voltage is applied to the magnetoresistive element A, reversal does not occur. The state in the first step is maintained, and only the magnetoresistive element B is reversed to the high resistance state. Alternatively, when the magnetoresistive element B is in the high resistance state, the state is maintained.

### <<10. Ninth embodiment>>

### <10.1 Embodiment>

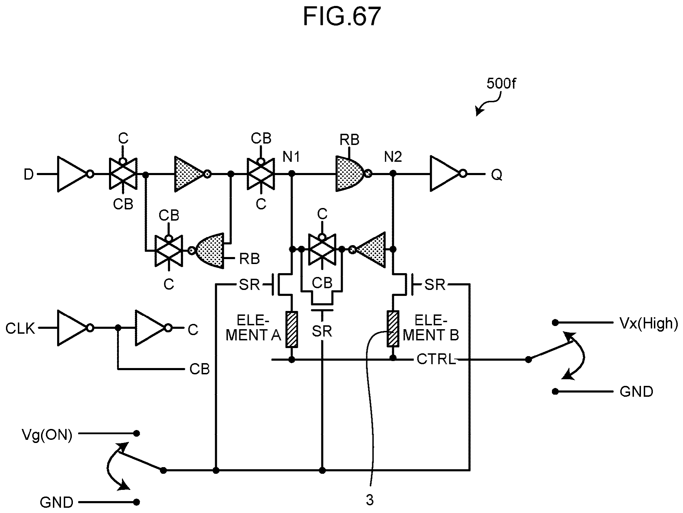

In the above-described eighth embodiment, the magnetoresistive elements 3 according to the first to sixth embodiments and the modifications are applied to the memory device 500c having the latch circuit that temporarily holds a signal. In the present embodiment, a memory device 500f having a flip-flop circuit that temporarily holds a signal is applied instead of the latch circuit. Hereinafter, a ninth embodiment of the present disclosure will be described with reference to FIG. 67. FIG. 67 is a circuit diagram of the memory device 500f according to the present embodiment.

In the present embodiment, as illustrated in FIG. 67, the magnetoresistive elements 3 according to the first to sixth embodiments and the modifications are applied to a slave latch circuit of a general flip-flop. Here, voltages of nodes N1 and N2 correspond to VA and VB in the eighth embodiment, a voltage of a node SR corresponds to Vg in the eighth embodiment, and a voltage of a node CTRL corresponds to Vx in the eighth embodiment. The operation is the same as that of a general flip-flop circuit. States of the nodes N1 and N2 are stored in the magnetoresistive element 3 before the power supply is shut off, and restored after the power supply is recovered. In other words, since the operation is similar to that of the above-described eighth embodiment, the description thereof is omitted here.

### <10.2 First modification>

Also in the ninth embodiment, the first modification of the eighth embodiment is applicable.

### <10.3 Second modification>

Also in the ninth embodiment, the second modification of the eighth embodiment is applicable.

### <10.4 Third modification>

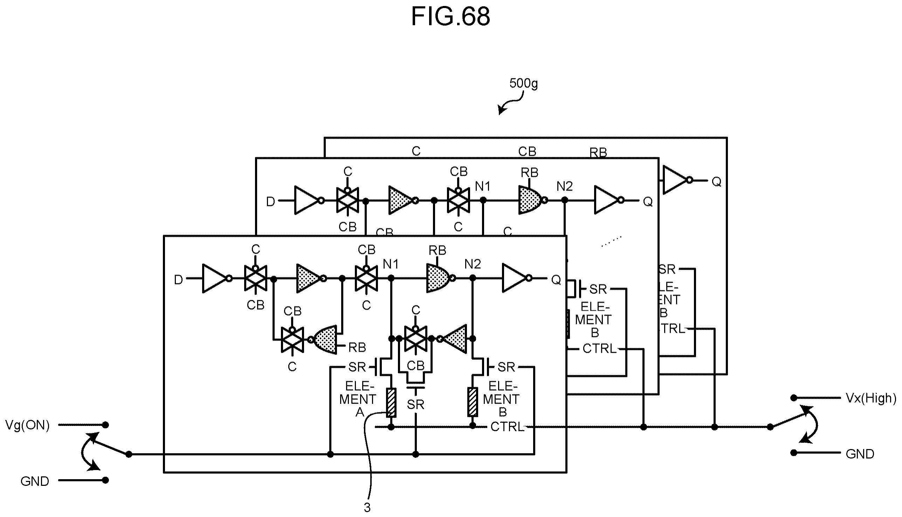

Next, a second modification of the present embodiment will be described with reference to FIG. 68. FIG. 68 is a circuit diagram of a memory device 500g according to the third modification. In the third modification, as illustrated in FIG. 68, a plurality of flip-flop circuits may be included and controlled simultaneously. Further, the first modification and the second modification described above are also applicable to the third modification.

### <<11. Tenth embodiment>>

### <11.1 Embodiment>

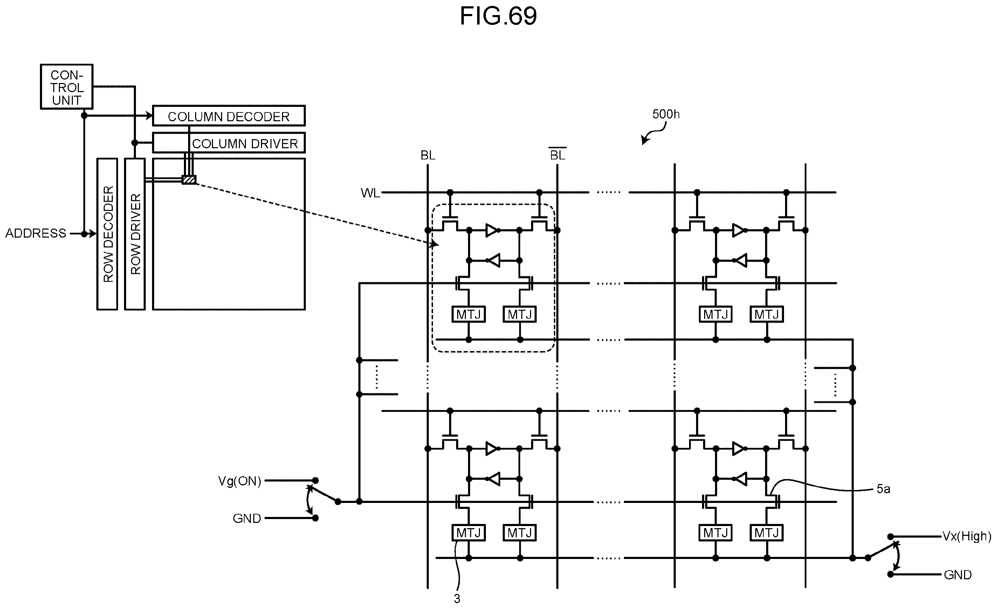

The memory device 500c having the latch circuit of the eighth embodiment described above can be applied to a nonvolatile static random access memory (SRAM). Hereinafter, a tenth embodiment of the present disclosure will be described with reference to FIG. 69. FIG. 69 is a circuit diagram of a memory device 500h according to the present embodiment. FIG. 69 illustrates a block diagram of a general SRAM, and the above-described eighth embodiment is applied to each of latch circuits of the SRAM. The operation is the same as that of the general SRAM. States are stored in the magnetoresistive element 3 before the power supply is shut off, and restored after the power supply is recovered. In other words, since the operation is similar to that of the above-described eighth embodiment, the description thereof is omitted here.

### <11.2 First modification>

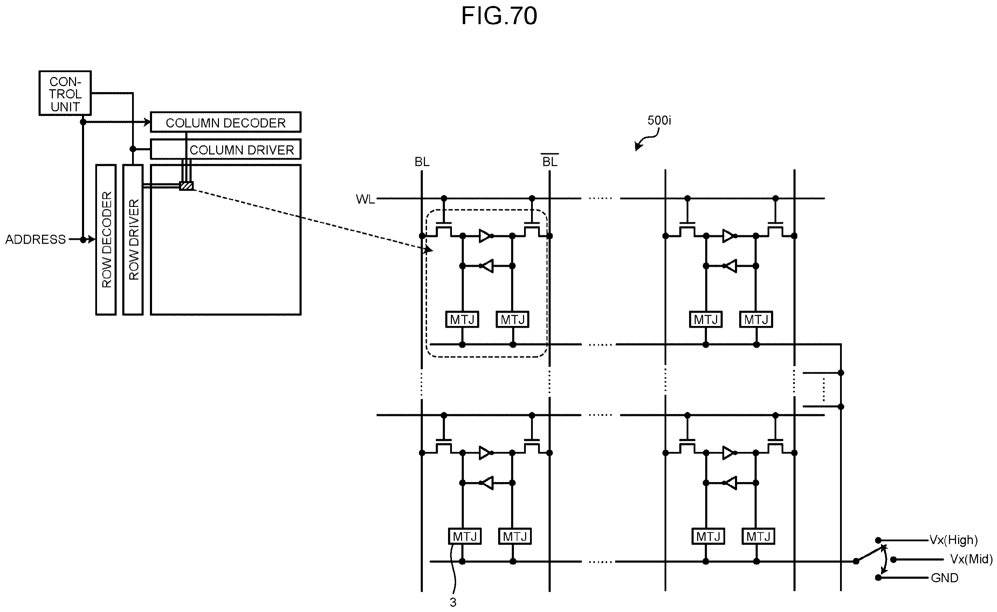

Next, a first modification of the present embodiment will be described with reference to FIG. 70. FIG. 70 is a circuit diagram of a memory device 500i according to the first modification. In the first modification, as illustrated in FIG. 70, the first modification of the eighth embodiment can be applied.

### <11.3 Second modification>

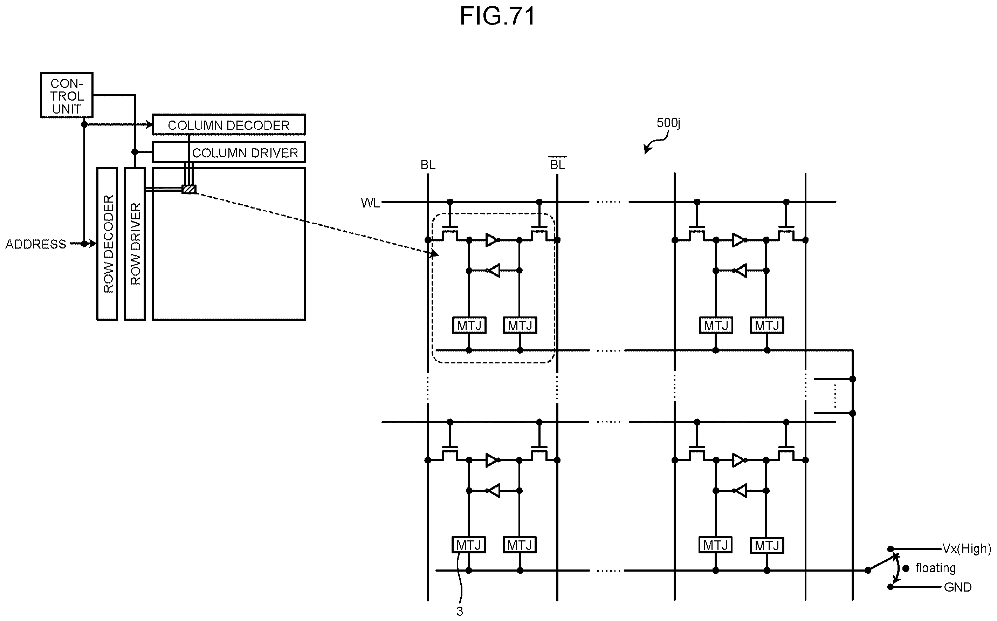

Next, a second modification of the present embodiment will be described with reference to FIG. 71. FIG. 71 is a circuit diagram of a memory device 500j according to the second modification. In the second modification, as illustrated in FIG. 71, the second modification of the eighth embodiment can be applied.

### <<12. Eleventh embodiment>>

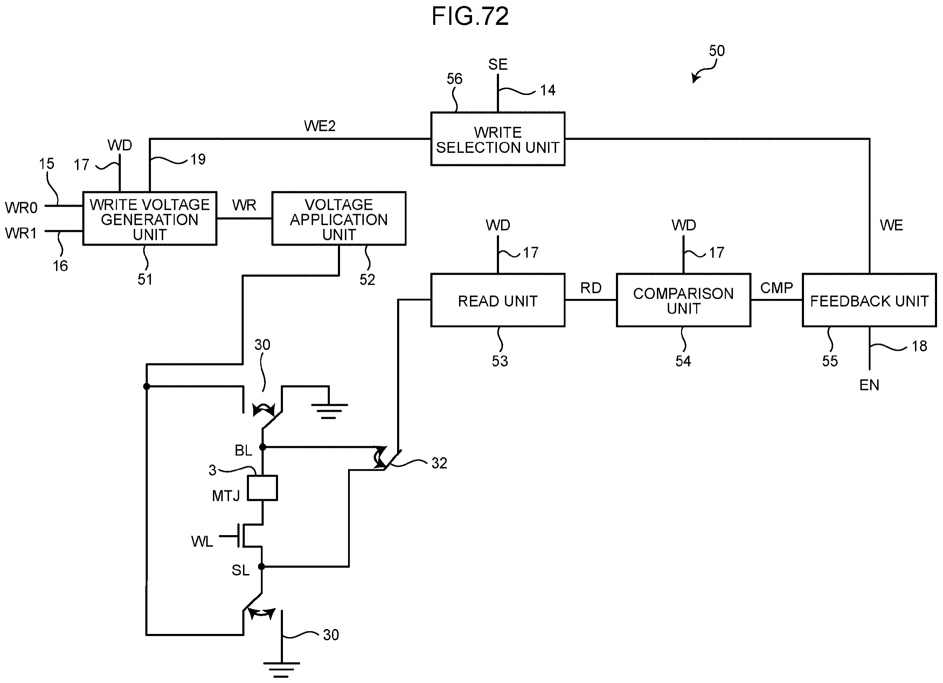

The magnetoresistive elements 3 according to the first to sixth embodiments and the modifications of the present disclosure described above can also be applied to a memory device that implements a self-adaptive write operation. The memory device that implements the self-adaptive write operation can continue writing when read data and write data are different, and can stop writing when the read data and the write data become the same. An embodiment of the memory device that implements the self-adaptive write operation to which the first to sixth embodiments and the modifications are applied will be described as an eleventh embodiment of the present disclosure with reference to FIG. 72. FIG. 72 is a circuit diagram of a write unit 50 included in the memory device that implements the self-adaptive write operation according to the present embodiment.

Specifically, as illustrated in FIG. 72, the write unit 50 includes a write voltage generation unit 51, a voltage application unit 52, a read unit 53, a comparison unit 54, a feedback unit 55, and a write selection unit 56.

The write voltage generation unit 51 has a state 0 write voltage line 15 (WR0), a state 1 write voltage line 16 (WR1), a write data line 17 (WD), and a write signal line 19 (WE2) as input terminals. The state 0 write voltage line 15, the state 1 write voltage line 16, and the write data line 17 are connected to a write control unit (not illustrated). The write signal line 19 is connected to the write selection unit 56.

Under the control of the write control unit (not illustrated), a voltage for writing a state 0 is applied to the state 0 write voltage line 15, and a voltage for writing a state 1 is applied to the state 1 write voltage line 16. In addition, under the control of the write control unit, an OFF voltage is applied to the write data line 17 when the state 0 is written, and an ON voltage is applied to the write data line 17 when the state 1 is written.

The write voltage generation unit 51 outputs one of a voltage (WR) of the state 0 write voltage line 15 and the voltage of the state 1 write voltage line 16 to the voltage application unit 52 according to the voltage applied from the write data line 17.

The voltage application unit 52 outputs a voltage depending on the voltage output from the write voltage generation unit 51 to the bit line BL or the source line SL. The bit line BL and the source line SL are provided with a switch 30, and the voltage output from the voltage application unit 52 can be switched between the case of applying the voltage to an upper end of the magnetoresistive element 3 and the case of applying the voltage to a lower end of the magnetoresistive element 3. Further, the switch 30 connects the terminal of the magnetoresistive element 3 to which no voltage is applied with GND. In this way, in the present embodiment, a reverse voltage can be applied to the magnetoresistive element 3 according to a state desired to write to the magnetoresistive element 3, i.e., an expected state.

The read unit 53 can read the state of the magnetoresistive element 3 that is a target to write. At this time, the read unit 53 is connected to the terminal on the high potential side of the magnetoresistive element 3 by the switch 32. Further, the read unit 53 outputs read data, i.e., a read voltage corresponding to the read data, to the comparison unit 54.

The comparison unit 54 compares the read data (e.g., state of the magnetoresistive element 3 read) with write data (e.g., state of the target magnetoresistive element 3) with reference to the voltage output from the read unit 53. Comparison unit 54 has the write data line 17 as another input terminal. For comparison, a voltage from the write data line 17 can be used. The comparison unit 54 outputs a comparison voltage corresponding to a comparison result to the feedback unit 55.

The feedback unit 55 refers to the voltage output from the comparison unit 54 to determine whether to continue or stop writing. The feedback unit 55 has a write start signal line 18 (EN) as another input terminal, and a voltage of the write start signal line 18 can be used for determine whether to continue or stop writing.

The write selection unit 56 refers to the voltage output from the feedback unit 55 and selects whether to continue or stop writing. The write selection unit 56 has a write selection line 14 (SE) as another input terminal, and a voltage of the write selection line 14 can be used for selecting whether to continue or stop writing.

As described above, by using the write unit 50, it is possible to realize the self-adaptive write operation in which writing is continued when the read data and the write data are different and writing is stopped when the read data and the write data become the same.

### <<13. Twelfth embodiment>>

The magnetoresistive elements 3 according to the first to sixth embodiments and the modifications of the present disclosure described above can also be applied to, for example, a frame memory of a logic circuit stacked with an image sensor. Furthermore, the magnetoresistive element 3 described above is not limited to application to the logic circuit for the image sensor. Since the magnetoresistive element 3 is a nonvolatile memory element, the magnetoresistive element 3 can be applied to, for example, a memory used for storing an arithmetic program such as a microcontroller or a digital signal processor (DSP) and storing coefficient data of artificial intelligence (AI) recognition processing. The magnetoresistive elements 3 according to the first to sixth embodiments and the modifications of the present disclosure can be used in place of the SRAM because of its writing with low energy, a low delay, space-saving compared with the SRAM, and a low leakage.

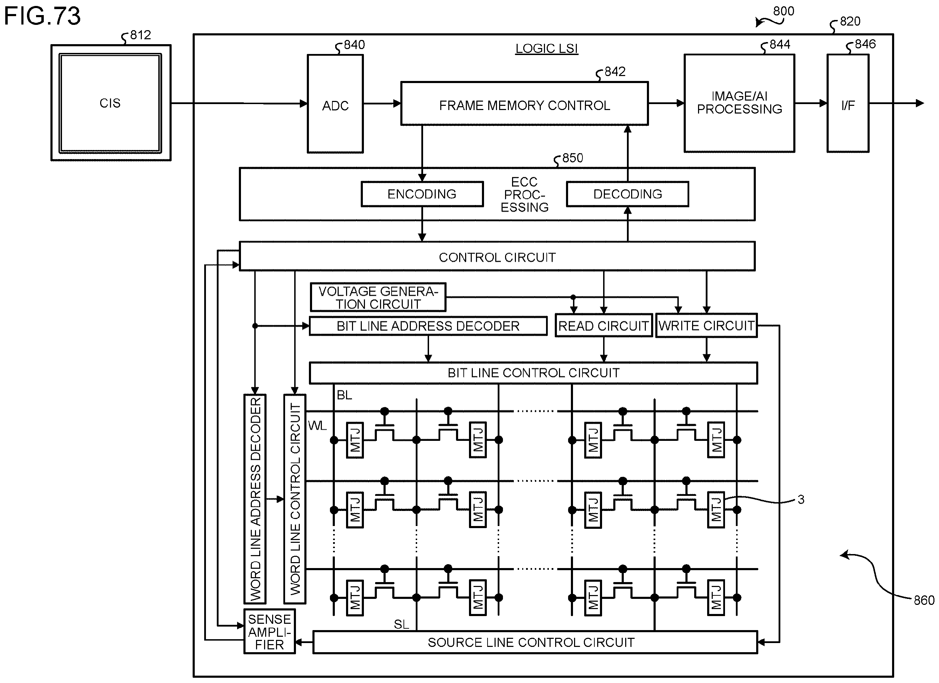

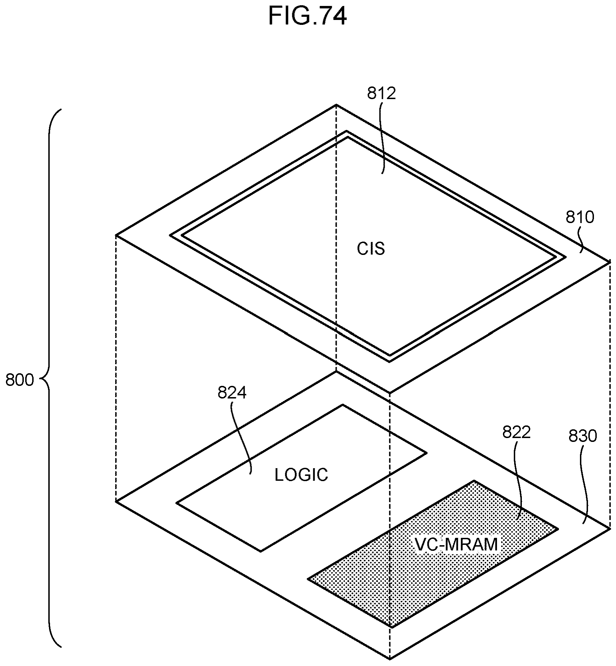

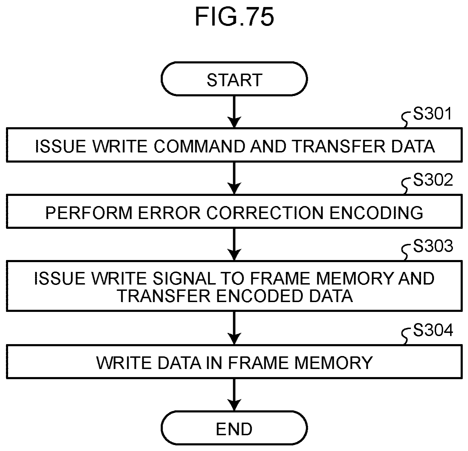

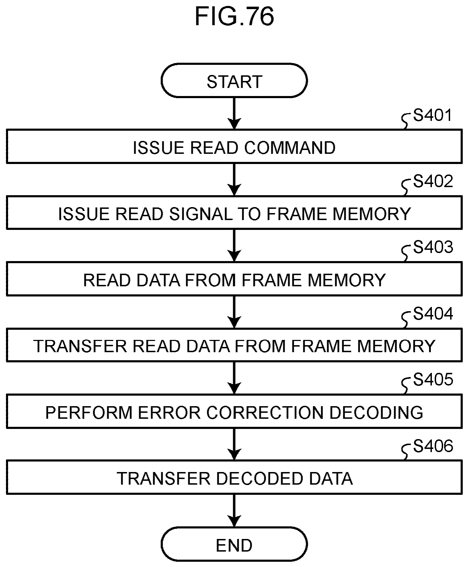

Therefore, an embodiment of a logic large scale integration (LSI) for an image sensor to which the magnetoresistive elements 3 according to the first to sixth embodiments and the modifications are applied will be described as a twelfth embodiment of the present disclosure with reference to FIGS. 73 to 76. FIG. 73 is a block diagram of an imaging device 800 according to the present embodiment, and FIG. 74 is a schematic diagram illustrating an example of the laminated structure of the imaging device 800 according to the present embodiment. FIG. 75 is a write flowchart in the present embodiment, and FIG. 76 is a read flowchart in the present embodiment.

As illustrated in FIG. 73, the imaging device 800 includes an image sensor (CIS) 812 and a logic LSI 820. The logic LSI 820 includes, as representative functional units, an analog/digital (A/D) converter (ADC) 840 that digitally converts output data from the image sensor 812, a frame memory control unit 842 that performs control for recording in a frame memory 860, an image/AI processing unit 844 that performs image processing and AI processing, and an output unit (I/F) 846 that outputs data. Furthermore, the logic LSI 820 may include an error correction unit (ECC processing unit) 850 for correcting an error at the time of memory recording. The logic LSI 820 may have an encoding function of adding error correction redundant data at the time of writing, a decoding function of correcting an error at the time of reading, and the like in the ECC processing. When an error rate of the VC-MRAM is high against the application, the error correction function is used. However, when the error rate is sufficiently low, the error correction function may not be provided.

When data is output from the image sensor 812, the data is temporarily buffered in the frame memory 860, then read, and image processing or AI processing is performed. Image data after processing, metadata recognized by AI, and the like are output from the output unit 846. The magnetoresistive elements 3 according to the first to sixth embodiments and the modifications of the present disclosure can be applied to the frame memory 860. The VC-MRAM is non-volatile, and has a smaller area compared with the SRAM, smaller leakage, and smaller write energy compared with the STT-MRAM and the SOT-MRAM. Therefore, by applying the magnetoresistive elements 3 according to the first to sixth embodiments and the modifications of the present disclosure, it is possible to obtain a compact logic LSI 820 with low power consumption. In addition, by applying the magnetoresistive elements 3 according to the first to sixth embodiments and the modifications of the present disclosure, the write control is facilitated.

Further, in the present embodiment, as illustrated in FIG. 74, the imaging device 800 can be made more compact by stacking a substrate 810 on which the image sensor 812 is mounted and a substrate 830 on which a memory unit 822 and a logic unit 824 are mounted.

FIG. 75 illustrates a write flowchart of the present embodiment. First, the logic LSI 820 receives data subjected to analog/digital (A/D) conversion, issues a write command, and transfers the data to the ECC process (Step S301). Next, the logic LS 820 performs an encoding process in the ECC process (Step S302), issues a write signal, and transfers the data, to which error correction redundant data is added, to the frame memory 860 (Step S303). Then, the frame memory 860 writes error-correction-encoded data (Step S304).

FIG. 76 illustrates a read flowchart of the present embodiment. First, the logic LSI 820 writes data subjected to analog/digital (A/D) conversion into the frame memory 860, reads the data, and performs image processing and AI processing. Further, the frame memory control unit 842 issues a read command (Step S401). Next, the logic LSI 820 issues a read signal to the frame memory 860 via the ECC processing unit 850 (Step S402). Note that, in the present embodiment, the read signal may be issued to the frame memory 860 without passing through the ECC process. Then, the frame memory 860 reads the data (Step S403) and transfers the data to the ECC processing unit 850 (Step S404). Then, the ECC processing unit 850 decodes (Step S405) and transfers decoded data to the frame memory control unit 842 (Step S406).

### <<14. Summary>>

As described above, in each embodiment of the present disclosure, even when the pulse width of the applied voltage becomes long, the probability of reversal of the magnetization direction of the storage layer does not deteriorate. Therefore writing can be easily performed without high-accuracy control of the pulse width. Furthermore, according to the present embodiments, a complicated and large-scale control circuit for controlling a short pulse width with high accuracy is not required.

In the present embodiments, when writing to the magnetoresistive element 3 in the low resistance state and maintaining the low resistance state are desired, the positive voltage is applied. In the present embodiments, when writing to the magnetoresistive element 3 in the high resistance state and maintaining the high resistance state are desired, the negative voltage is applied. Therefore, in the present embodiments, since the expected state is maintained even after reversing the state by applying the voltage corresponding to the expected state, initial reading for confirming the state of the magnetoresistive element 3 is unnecessary. As a result, according to the present embodiments, an increase in the write time can be avoided, and the characteristic of the VC-MRAM to write fast can be sufficiently utilized.

Furthermore, each step in the flow of each of the embodiments described above may not necessarily be processed in the described order. For example, each step may be implemented in an appropriately changed order. In addition, each step may be partially implemented in parallel or individually instead of being implemented sequentially.

In addition, the magnetoresistive elements 3 according to the embodiments and the modifications of the present disclosure can be manufactured by using a method, a device, and conditions used for manufacturing a general semiconductor device.

Examples of the above-described method include a physical vapor deposition (PVD) method, a chemical vapor deposition (CVD) method, and an atomic layer deposition (ALD) method. Examples of the PVD method include a vacuum vapor deposition method, an electron beam (EB) vapor deposition method, various sputtering methods (magnetron sputtering method, radio frequency (RF)-direct current (DC) coupled bias sputtering method, electron cyclotron resonance (ECR) sputtering method, counter target sputtering method, high-frequency sputtering method, and the like), an ion plating method, a laser ablation method, a molecular beam epitaxy (MBE) method, and a laser transfer method. Examples of the CVD method include a plasma CVD method, a thermal CVD method, an organic metal (MO) CVD method, and a photo CVD method. Further, other methods include an electrolytic plating method, an electroless plating method, a spin coating method, an immersion method; a cast method, a micro-contact printing method, a drop cast method; various printing methods such as a screen printing method, an inkjet printing method, an offset printing method, a gravure printing method, and a flexographic printing method; a stamping method, a spray method, and various coating methods such as an air doctor coater method, a blade coater method, a rod coater method, a knife coater method, a squeeze coater method, a reverse roll coater method, a transfer roll coater method, a gravure coater method, a kiss coater method, a cast coater method, a spray coater method, a slit orifice coater method, and a calendar coater method. Furthermore, examples of the patterning method include chemical etching such as shadow mask, laser transfer, and photolithography, and physical etching using ultraviolet rays, laser, or the like. In addition, examples of the planarization technique include a chemical mechanical polishing (CMP) method, a laser planarization method, and a reflow method.

### <<15. Configuration example of electronic apparatus>>

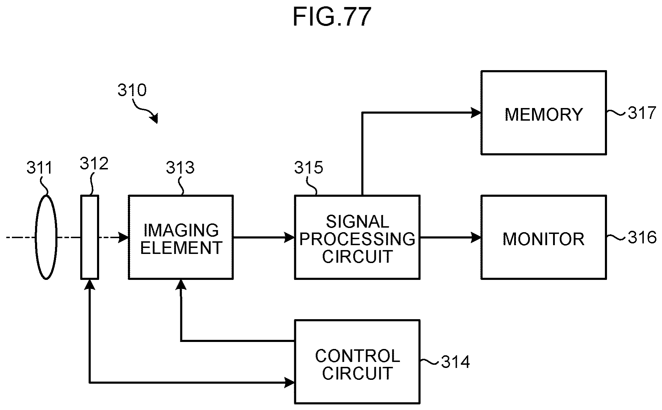

Hereinafter, with reference to FIGS. 77 to 80, an imaging device 310, a distance measuring device 410, and a game machine 900 will be described as electronic apparatuses to which the above-described embodiments (including modifications) of the present disclosure are applied.

### <15.1 Imaging device>

First, with reference to FIG. 77, the imaging device 310 will be described as an electronic apparatus to which the above-described embodiments (including modifications) of the present disclosure are applied. FIG. 77 is a diagram illustrating an example of a schematic configuration of the imaging device 310. Examples of the imaging device 310 include electronic apparatuses such as a digital still camera, a video camera, a smartphone having an imaging function, and a mobile phone.

As illustrated in FIG. 77, the imaging device 310 includes an optical system 311, a shutter device 312, an imaging element 313, a control circuit (drive circuit) 314, a signal processing circuit 315, a monitor 316, and a memory 317. The imaging device 310 can capture a still image and a moving image.

The optical system 311 includes one or a plurality of lenses. The optical system 311 guides light (incident light) from a subject to the imaging element 313 and forms an image on a light receiving surface of the imaging element 313.

The shutter device 312 is disposed between the optical system 311 and the imaging element 313. The shutter device 312 controls a light irradiation period and a light shielding period with respect to the imaging element 313 according to the control of the control circuit 314.

The imaging element 313 accumulates signal charges for a certain period according to light formed on the light receiving surface via the optical system 311 and the shutter device 312. The signal charges accumulated in the imaging element 313 are transferred in accordance with a drive signal (timing signal) supplied from the control circuit 314.

The control circuit 314 outputs the drive signal for controlling the transfer operation of the imaging element 313 and the shutter operation of the shutter device 312 to drive the imaging element 313 and the shutter device 312.

The signal processing circuit 315 performs various types of signal processing on the signal charges output from the imaging element 313. An image (image data) obtained by performing the signal processing by the signal processing circuit 315 is supplied to the monitor 316 and also supplied to the memory 317.

The monitor 316 displays a moving image or a still image captured by the imaging element 313 based on the image data supplied from the signal processing circuit 315. As the monitor 316, for example, a panel type display device such as a liquid crystal panel or an organic electro luminescence (EL) panel is used.

The memory 317 stores the image data supplied from the signal processing circuit 315, i.e., image data of the moving image or the still image captured by the imaging element 313. Embodiments of the present disclosure can be applied to the memory 317.

### <15.2 Distance measuring device>

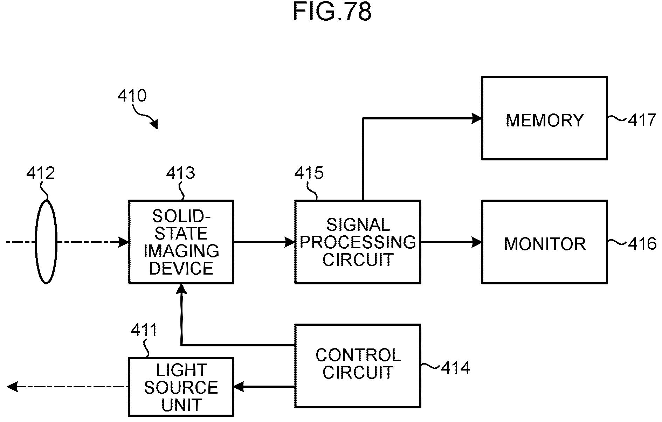

Next, with reference to FIG. 78, the distance measuring device 410 will be described as an electronic apparatus to which the above-described embodiments (including modifications) of the present disclosure are applied. FIG. 78 is a diagram illustrating an example of a schematic configuration of the distance measuring device 410.

As illustrated in FIG. 78, the distance measuring device (distance image sensor) 410 includes a light source unit 411, an optical system 412, a solid-state imaging device (imaging element) 413, a control circuit (drive circuit) 414, a signal processing circuit 415, a monitor 416, and a memory 417. The distance measuring device 410 can acquire a distance image according to a distance to a subject by projecting light from the light source unit 411 toward the subject and receiving light (modulated light or pulsed light) reflected on a surface of the subject.

The light source unit 411 projects light toward the subject. As the light source unit 411, for example, a vertical cavity surface emitting laser (VCSEL) array that emits laser light as a surface light source or a laser diode array in which laser diodes are arranged on a line is used. Note that the laser diode array is supported by a predetermined drive unit (not illustrated), and is scanned in a direction perpendicular to an arrangement direction of the laser diodes.

The optical system 412 includes one or a plurality of lenses. The optical system 412 guides light (incident light) from the subject to the solid-state imaging device 413 and forms an image on a light receiving surface (sensor unit) of the solid-state imaging device 413.

The solid-state imaging device 413 accumulates signal charges according to light formed on the light receiving surface via the optical system 412. A distance signal indicating a distance obtained from a light reception signal (APD OUT) output from the solid-state imaging device 413 is supplied to the signal processing circuit 415. As the solid-state imaging device 413, for example, a solid-state imaging element such as an image sensor is used.

The control circuit 414 outputs a drive signal (control signal) for controlling operations of the light source unit 411, the solid-state imaging device 413, and the like, and drives the light source unit 411, the solid-state imaging device 413, and the like.

The signal processing circuit 415 performs various types of signal processing on the distance signal supplied from the solid-state imaging device 413. For example, the signal processing circuit 415 performs image processing (e.g., histogram processing and peak detection processing) for configuring a distance image based on the distance signal. An image (image data) obtained by performing the signal processing by the signal processing circuit 415 is supplied to the monitor 416 and also supplied to the memory 417.

The monitor 416 displays the distance image captured by the solid-state imaging device 413 based on the image data supplied from the signal processing circuit 415. As the monitor 416, for example, a panel type display device such as a liquid crystal panel or an organic EL panel is used.

The memory 417 stores the image data supplied from the signal processing circuit 415, i.e., image data of the distance image captured by the solid-state imaging device 413. Embodiments of the present disclosure can be applied to the memory 417.

### <15.3 Game machine>

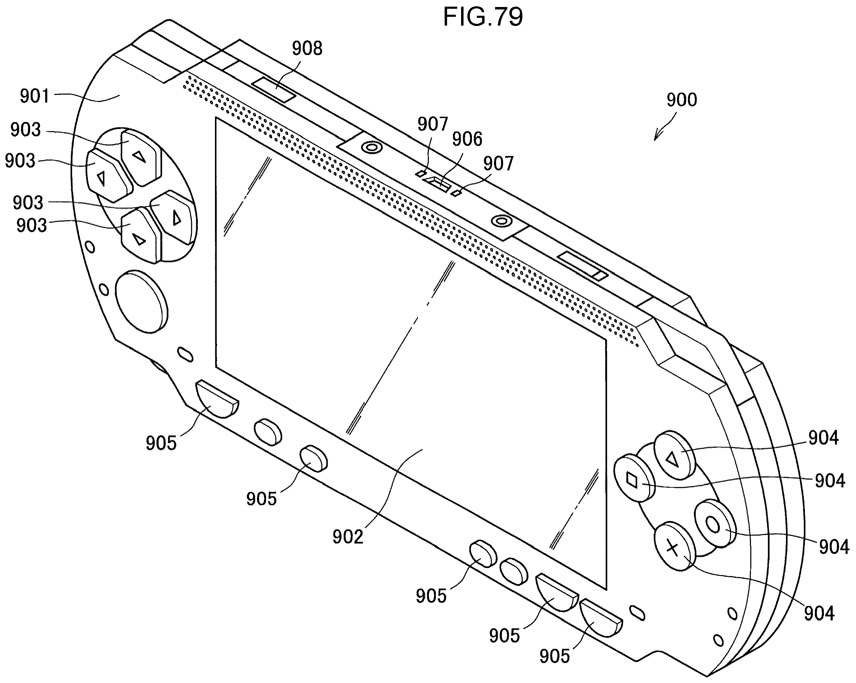

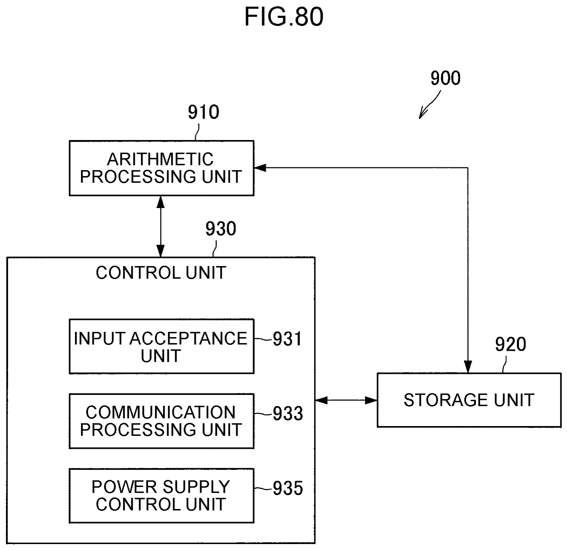

Next, the game machine 900 will be described as an electronic apparatus to which the above-described embodiments (including modifications) of the present disclosure are applied with reference to FIGS. 79 and 80. FIG. 79 is a perspective view (external perspective view) illustrating an example of a schematic configuration of the game machine 900. FIG. 80 is a block diagram illustrating the example of the schematic configuration of the game machine 900.

As illustrated in FIG. 79, the game machine 900 has an appearance, for example, in which each component is disposed inside and outside an outer casing 901 formed in a horizontally long flat shape.

On the front surface of the outer casing 901, a display panel 902 is provided at the center in a longitudinal direction. Further, operation keys 903 and operation keys 904 are provided on the left and right sides of the display panel 902, respectively, spaced apart in the circumferential direction. Operation keys 905 are provided at a lower end of the front surface of the outer casing 901. The operation keys 903, 904, and 905 function as direction keys, decision keys, and the like, and are used for selection of menu items displayed on the display panel 902, progress of a game, and the like.

On the upper surface of the outer casing 901, a connection terminal 906 for connecting an external device, a power supply terminal 907, a light receiving window 908 for performing infrared communication with the external device, and the like are provided.

As illustrated in FIG. 80, the game machine 900 includes an arithmetic processing unit 910 including a central processing unit (CPU), a storage unit 920 that stores various types of information, and a control unit 930 that controls each configuration of the game machine 900. Power is supplied to the arithmetic processing unit 910 and the control unit 930 from, for example, a battery (not illustrated) or the like.

The arithmetic processing unit 910 generates a menu screen for allowing the user to set various types of information or select an application. In addition, the arithmetic processing unit 910 executes the application selected by the user.

The storage unit 920 holds various types of information set by the user. Embodiments of the present disclosure can be applied to the storage unit 920.

The control unit 930 includes an input acceptance unit 931, a communication processing unit 933, and a power control unit 935. The input acceptance unit 931 detects, for example, states of the operation keys 903, 904, and 905. Furthermore, the communication processing unit 933 performs communication processing with the external device. The power control unit 935 controls power supplied to each unit of the game machine 900.

Furthermore, the embodiments of the present disclosure can be mounted on various electronic apparatuses on which a memory (storage unit) can be mounted as described above. For example, the embodiments of the present disclosure can be applied to various electronic apparatuses and the like such as a notebook personal computer (PC), a mobile device (e.g., a smartphone and a tablet PC), a personal digital assistant (PDA), a wearable device, and a music device, in addition to the imaging device 310 and the game machine 900.

### <<16. Supplement>>

Although the preferred embodiments of the present disclosure have been described in detail with reference to the accompanying drawings, the technical scope of the present disclosure is not limited to these examples. It is obvious that a person having ordinary knowledge in the technical field of the present disclosure can conceive various changes or modifications within the scope of the technical idea described in the claims, and it is naturally understood that these also belong to the technical scope of the present disclosure.

Furthermore, the effects described in the present specification are merely illustrative or exemplary, and are not restrictive. In other words, the technology according to the present disclosure can exhibit other effects obvious to those skilled in the art from the description of the present specification in addition to or instead of the above effects.

The present technology may also have the following configurations.
(1) A memory device comprising:
   a magnetoresistive element connected between a first control line and a second control line;
   a write circuit configured to control writing to the magnetoresistive element; and
   a read circuit configured to control reading from the magnetoresistive element, wherein
   the magnetoresistive element is a voltage-controlled magnetic anisotropy (VCMA) effect magnetoresistive element, and
   the write circuit controls the magnetoresistive element such that a first voltage for writing in a high resistance state and a second voltage for writing in a low resistance state have opposite directions.
(2) The memory device according to (1), wherein the magnetoresistive element includes at least one magnetic tunnel junction (MTJ) element having a laminated structure of a storage layer, a tunnel barrier layer, and a reference layer.
(3) The memory device according to (2), wherein the magnetoresistive element includes a plurality of the MTJ elements laminated to each other.
(4) The memory device according to (3), wherein the magnetoresistive element further includes a magnetic coupling layer or an antiferromagnetic coupling layer provided between the plurality of MTJ elements.
(5) The memory device according to (4), wherein the magnetic coupling layer or the antiferromagnetic coupling layer is provided so as to be sandwiched between the storage layer of one of the plurality of MTJ elements and the storage layer of another of the plurality of MTJ elements.
(6) The memory device according to (3), wherein the plurality of MTJ elements shares the storage layer.
(7) The memory device according to any one of (3) to (6), wherein each of the plurality of MTJ elements has a different tunnel magneto resistance (TMR) ratio from each other.
(8) The memory device according to (7), wherein each of the plurality of MTJ elements has the tunnel barrier layer having a different film thickness from each other.
(9) The memory device according to (7) or (8), wherein
   the magnetoresistive element includes a first MTJ element and a second MTJ element, and
   a resistance value of the second MTJ element in a high resistance state, a resistance value of the first MTJ element in a high resistance state, a resistance value of the first MTJ element in a low resistance state, and a resistance value of the second MTJ element in a low resistance state are smaller in this order.
(10) The memory device according to (2), wherein
   the magnetoresistive element includes:
   a magnetic coupling layer or an antiferromagnetic coupling layer in contact with the storage layer of the MTJ element; and
   a resistance element having another storage layer in contact with the magnetic coupling layer or the antiferromagnetic coupling layer, and another tunnel barrier layer in contact with the another storage layer.
(11) The memory device according to (2), wherein
   the magnetoresistive element further includes a resistance element having another tunnel barrier layer in contact with the storage layer of the MTJ element.
(12) The memory device according to (10) or (11), wherein
   the magnetoresistive element includes one piece of the MTJ element and one piece of the resistance element, and
   a resistance value of the MTJ element in a high resistance state, a resistance value of the resistance element, and a resistance value of the MTJ element in a low resistance state are smaller in this order.
(13) The memory device according to any one of (2) to (12), wherein the magnetoresistive element further includes a cap layer and a base layer that sandwich the MTJ element.
(14) The memory device according to any one of (1) to (13), further comprising a selection element having a terminal connected to the second control line.
(15) The memory device according to any one of (1) to (14), wherein
   the memory device includes a plurality of the magnetoresistive elements, and
   the plurality of magnetoresistive elements configures a cross-point memory array in which the plurality of magnetoresistive elements is arranged in a row direction and a column direction,
   one ends of the plurality of magnetoresistive elements in a same column are electrically connected to a common first control line, and
   other ends of the plurality of magnetoresistive elements in a same row are electrically connected to a common second control line.
(16) The memory device according to any one of (1) to (14), further comprising a latch circuit.
(17) The memory device according to any one of (1) to (14), further comprising a flip-flop circuit.
(18) The memory device according to (16) or (17), wherein the memory device configures a static random access memory (SRAM).
(19) A memory system comprising:
   a plurality of memory cells including a magnetoresistive element and a selection element that selects the magnetoresistive element;
   a write circuit configured to select the plurality of memory cells and performs writing to the magnetoresistive element via the selection element;
   a read circuit configured to select the plurality of memory cells and performs reading from the magnetoresistive element via the selection element; and
   a memory control unit configured to control data writing and reading in the plurality of the memory cells via the write circuit and the read circuit, wherein
   the magnetoresistive element is a voltage-controlled magnetic anisotropy (VCMA) effect magnetoresistive element, and
   the write circuit controls the magnetoresistive element such that a first voltage for writing in a high resistance state and a second voltage for writing in a low resistance state have opposite directions.

### Reference Signs List

1 GATE ELECTRODE
2 ELEMENT SEPARATION LAYER
3, 3a, 3b, 3c, 3d, 3e, 3f, 3g, 3h, 3i, 3j, 3k, 3m, 3n, 3p, 3q, 3r, 3s MAGNETORESISTIVE ELEMENT
5 SELECTION ELEMENT
5a TRANSISTOR
4 CONTACT LAYER
6 BIT LINE
7 SOURCE REGION
8 DRAIN REGION
9 WIRING
10 SEMICONDUCTOR SUBSTRATE
11, 550, 550a, 550b MEMORY CELL ARRAY
15, 16 VOLTAGE LINE
17 DATA LINE
19 SIGNAL LINE
30, 32 SWITCH
50 WRITE UNIT
51 WRITE VOLTAGE GENERATION UNIT
52 VOLTAGE APPLICATION UNIT
53 READ UNIT
54 COMPARISON UNIT
55 FEEDBACK UNIT
56 WRITE SELECTION UNIT
100, 200 MTJ ELEMENT
102, 202 MAGNETIZATION FIXED LAYER
104, 204 TUNNEL BARRIER LAYER
106, 206 STORAGE LAYER
300 MAGNETIC COUPLING LAYER
302 ANTIFERROMAGNETIC COUPLING LAYER
400 BASE LAYER
402 CAP LAYER
500, 500a, 500c, 500d, 500e, 500f, 500g, 500h, 500i, 500j MEMORY DEVICE
502, 570 INPUT/OUTPUT UNIT
503, 568 CONTROL CIRCUIT
504 VOLTAGE GENERATION CIRCUIT
506 SENSE AMPLIFIER
510, 564 READ CIRCUIT
512 WRITE CIRCUIT
520 BIT/SOURCE LINE ADDRESS DECODER
530 WORD LINE ADDRESS DECODER
540 BIT LINE CONTROL CIRCUIT
542 WORD LINE CONTROL CIRCUIT
544 SOURCE LINE CONTROL CIRCUIT
552 SWITCH
560 BL BIAS CIRCUIT
562 WL BIAS CIRCUIT
566 PULSE GENERATOR
572 ADDRESS DECODER
800 IMAGING DEVICE
810, 830 SUBSTRATE
812 IMAGE SENSOR
820 LOGIC LSI
822 MEMORY UNIT
824 LOGIC UNIT
840 ADC
842 FRAME MEMORY CONTROL UNIT
844 IMAGE/AI PROCESSING UNIT
846 OUTPUT UNIT
850 ECC PROCESSING UNIT
860 FRAME MEMORY

## Claims

1. A memory device comprising:
a magnetoresistive element connected between a first control line and a second control line;
a write circuit configured to control writing to the magnetoresistive element; and
a read circuit configured to control reading from the magnetoresistive element, wherein
the magnetoresistive element is a voltage-controlled magnetic anisotropy (VCMA) effect magnetoresistive element, and
the write circuit controls the magnetoresistive element such that a first voltage for writing in a high resistance state and a second voltage for writing in a low resistance state have opposite directions.

2. The memory device according to claim 1, wherein the magnetoresistive element includes at least one magnetic tunnel junction (MTJ) element having a laminated structure of a storage layer, a tunnel barrier layer, and a reference layer.

3. The memory device according to claim 2, wherein the magnetoresistive element includes a plurality of the MTJ elements laminated to each other.

4. The memory device according to claim 3, wherein the magnetoresistive element further includes a magnetic coupling layer or an antiferromagnetic coupling layer provided between the plurality of MTJ elements.

5. The memory device according to claim 4, wherein the magnetic coupling layer or the antiferromagnetic coupling layer is provided so as to be sandwiched between the storage layer of one of the plurality of MTJ elements and the storage layer of another of the plurality of MTJ elements.

6. The memory device according to claim 3, wherein the plurality of MTJ elements shares the storage layer.

7. The memory device according to claim 3, wherein each of the plurality of MTJ elements has a different tunnel magneto resistance (TMR) ratio from each other.

8. The memory device according to claim 7, wherein each of the plurality of MTJ elements has the tunnel barrier layer having a different film thickness from each other.

9. The memory device according to claim 7, wherein
the magnetoresistive element includes a first MTJ element and a second MTJ element, and
a resistance value of the second MTJ element in a high resistance state, a resistance value of the first MTJ element in a high resistance state, a resistance value of the first MTJ element in a low resistance state, and a resistance value of the second MTJ element in a low resistance state are smaller in this order.

10. The memory device according to claim 2, wherein
the magnetoresistive element includes:
a magnetic coupling layer or an antiferromagnetic coupling layer in contact with the storage layer of the MTJ element; and
a resistance element having another storage layer in contact with the magnetic coupling layer or the antiferromagnetic coupling layer, and another tunnel barrier layer in contact with the another storage layer.

11. The memory device according to claim 2, wherein
the magnetoresistive element further includes a resistance element having another tunnel barrier layer in contact with the storage layer of the MTJ element.

12. The memory device according to claim 10, wherein
the magnetoresistive element includes one piece of the MTJ element and one piece of the resistance element, and
a resistance value of the MTJ element in a high resistance state, a resistance value of the resistance element, and a resistance value of the MTJ element in a low resistance state are smaller in this order.

13. The memory device according to claim 2, wherein the magnetoresistive element further includes a cap layer and a base layer that sandwich the MTJ element.

14. The memory device according to claim 1, further comprising a selection element having a terminal connected to the second control line.

15. The memory device according to claim 1, wherein
the memory device includes a plurality of the magnetoresistive elements, and
the plurality of magnetoresistive elements configures a cross-point memory array in which the plurality of magnetoresistive elements is arranged in a row direction and a column direction,
one ends of the plurality of magnetoresistive elements in a same column are electrically connected to a common first control line, and
other ends of the plurality of magnetoresistive elements in a same row are electrically connected to a common second control line.

16. The memory device according to claim 1, further comprising a latch circuit.

17. The memory device according to claim 1, further comprising a flip-flop circuit.

18. The memory device according to claim 16, wherein the memory device configures a static random access memory (SRAM).

19. A memory system comprising:
a plurality of memory cells including a magnetoresistive element and a selection element that selects the magnetoresistive element;
a write circuit configured to select the plurality of memory cells and performs writing to the magnetoresistive element via the selection element;
a read circuit configured to select the plurality of memory cells and performs reading from the magnetoresistive element via the selection element; and
a memory control unit configured to control data writing and reading in the plurality of the memory cells via the write circuit and the read circuit, wherein
the magnetoresistive element is a voltage-controlled magnetic anisotropy (VCMA) effect magnetoresistive element, and
the write circuit controls the magnetoresistive element such that a first voltage for writing in a high resistance state and a second voltage for writing in a low resistance state have opposite directions.
